# EUROPÄISCHE PATENTSCHRIFT

(11) **EP 4 169 082 B1**
(45) Veröffentlichungstag und Bekanntmachung des Hinweises auf die Patenterteilung: **11.11.2026**
(21) Anmeldenummer: 21733994.4
(22) Anmeldetag: 21.06.2021
(51) Int. Cl.: H10K 71/10, B29C 48/00, B29C 48/03, H10K 50/11

(54) **VERFAHREN ZUR HERSTELLUNG EINER MISCHUNG**
METHOD FOR MANUFACTURING A MIXTURE
PROCÉDÉ DE FABRICATION D'UN MÉLANGE

(30) Priorität: 23.06.2020 EP 20181541
(43) Veröffentlichungstag der Anmeldung: 26.04.2023
(73) Patentinhaber: Merck Patent GmbH, 64293 Darmstadt (DE)
(72) Erfinder: STOESSEL, Philipp, 64293 Darmstadt (DE)
(74) Vertreter: Merck Patent Association
(86) Internationale Anmeldenummer: PCT/EP2021/066747
(87) Internationale Veröffentlichungsnummer: WO 2021/259824

(56) Entgegenhaltungen:
- EP-A1- 2 584 624
- EP-B1- 2 381 503
- WO-A2-03/003411

## Beschreibung

Die vorliegende Erfindung beschreibt ein Verfahren zur Herstellung einer Mischung gemäß den Ansprüchen, enthaltend mindestens zwei funktionale Materialien (FM1, FM2), die sublimierbar sind und welche zur Herstellung von Funktionsschichten elektronischer Vorrichtungen einsetzbar sind. Elektronische Vorrichtungen, welche organische, metallorganische und/oder polymere Halbleiter enthalten, gewinnen zunehmend an Bedeutung, wobei diese aus Kostengründen und aufgrund ihrer Leistungsfähigkeit in vielen kommerziellen Produkten eingesetzt werden. Als Beispiele seien hier Ladungstransportmaterialien auf organischer Basis (z.B. Lochtransporter auf Triarylamin-Basis) in Kopiergeräten, organischen oder polymeren Leuchtdioden (OLEDs oder PLEDs) und in Anzeige- und Displayvorrichtungen oder organische Photorezeptoren in Kopierern genannt. Organische Solarzellen (O-SC), organische FeldeffektTransistoren (O-FET), organische Dünnfilm-Transistoren (O-TFT), organische Schaltelemente (O-IC), organische optische Verstärker und organische Laserdioden (O-Laser) sind in einem fortgeschrittenen Entwicklungsstand und können in der Zukunft große Bedeutung erlangen. Zur Herstellung dieser Vorrichtungen werden vielfach funktionale Materialien auf organischer oder metallorganischer Basis eingesetzt, die sublimierbar sind. Allerdings sind die bisher eingesetzten Pulver und Presslinge mit vielen Nachteilen behaftet. So stauben Pulver beim Vermahlen und Umfüllen, laden sich elektrostatisch auf und demgemäß verbleibt immer ein unerwünschter Rest im Gebinde. Ferner weisen Pulver eine geringe Schüttdichte auf. Presslinge sind sehr aufwändig herzustellen, so dass diese teuer sind. Typischerweise werden Presslinge aus gemahlenem Pulver hergestellt, so dass die zuvor beschriebenen Nachteile grundsätzlich ebenfalls vorhanden sind und mehrere Prozessschritte benötigt werden. Ferner werden die Presslinge einzeln umgefüllt und können fragil sein. Darüber hinaus ist die Staubproblematik nicht vollständig behoben. Durch den Staubanteil sind verstärkt Arbeitsschutzmaßnahmen erforderlich.

Bei Sublimationsanlagen, bei denen eine Schmelze eingesetzt wird, bestehen Probleme hinsichtlich der Dosierung, wobei die Schmelze zunächst erhalten werden muss. Je nach Anlage kann dies ein Pulver oder ein Pressling sein, so dass die zuvor dargelegte Problematik ebenfalls vorhanden ist. Ferner kann eine Anlage eingesetzt werden, bei der die zu sublimierenden Stoffe hergestellt werden. Allerdings sind diese Anlagen relativ unflexibel und daher teuer. Ferner führt eine Kopplung von Herstellung und Verwendung zu erhöhten Kosten bei einem Ausfall eines Teils der Gesamtanlage. Falls beispielsweise bei der Sublimationsanlage Fehler auftreten, muss die Produktion ebenfalls eingestellt werden.

Für einige Schichten werden Mischungen dieser Materialien eingesetzt, die beispielsweise in Pulverform oder als Pressling geliefert werden. Im Allgemeinen sind die Betreiber der Produktionsanlagen bestrebt, diese Mischungen vorkonfektioniert von den Herstellern der OLED-Materialien zu erhalten, um Anlagenfehler möglichst auszuschließen. Daher müssen die Pulver sicher und möglichst homogen beim Hersteller erzeugt werden, wobei dies mit Aufwand verbunden ist und beim Betreiber der Produktionsanlagen zu einem hohen Aufwand hinsichtlich des Gesundheitsschutzes und der Betriebssicherheit führt. Ferner können die zuvor dargelegten Presslinge aus den Pulvermischungen erzeugt werden, so dass ein dreifacher Aufwand - Herstellung der Einzelpulver, Herstellung der Mischung aus den Einzelpulvern, Pressen der Pulvermischung - notwendig ist.

Ein Problem, welches bei der Verwendung von Mischungen auftritt, die zur Herstellung von OLED-Schichten verdampft oder sublimiert werden, besteht darin, dass die Ausschussrate von den erhaltenen elektronischen Vorrichtungen, beispielsweise Displays oder ähnlichem sehr hoch ist. So erfüllen diese elektronischen Vorrichtungen vielfach nicht die üblichen Normen oder vorgegebenen Leistungsdaten. Eine weitere Aufgabe kann daher darin gesehen werden, Mischungen oder Verfahren bereitzustellen, die zu höheren Ausbeuten an elektronischen Vorrichtungen führen. Ferner sollten die Mischungen oder Verfahren zu einer konstanteren und besser vorhersehbaren Qualität der elektronischen Vorrichtungen führen. WO03/003411 (A2) beschreibt eine Extrusion zur Herstellung von Mischungen, die organische Halbleiter umfassen.

Weiterhin beschreibt EP 2 381 503 B1 eine Extrusion zur Herstellung von Mischungen, die organische Halbleiter umfassen. Problematisch an der Lehre der Druckschrift EP 2 381 503 B1 ist insbesondere, dass hierfür Polymere eingesetzt werden, die als Trägermaterial dienen. Diese Zusatzstoffe stören die weitere Verarbeitung der erhaltenen Mischungen, so dass sich Extrusionsverfahren zum Erhalt von zweckmäßigen Mischungen bisher nicht durchsetzen konnten.

EP2584624 beschreibt in Beispiel 1 eine Mischung aus drei funktionalen Materialien im Extruder.

Bekannte Pulver und Presslinge, die zur Herstellung von elektronischen Vorrichtungen eingesetzt werden, weisen ein brauchbares Eigenschaftsprofil auf. Allerdings besteht die dauerhafte Notwendigkeit, die Eigenschaften dieser Materialien und Vorrichtungen zu verbessern.

Zu diesen Eigenschaften gehören insbesondere die Verarbeitbarkeit, Transportfähigkeit und Lagerbarkeit von Materialien zur Herstellung von elektronischen Vorrichtungen. Insbesondere sollten die Materialien einen sehr geringen Staubanteil aufweisen und kostengünstig herstellbar sein. Ferner sollten keine besonders hohen Anforderungen an die Arbeitsschutzmaßnahmen bei der Verarbeitung der Materialien erforderlich sein.

Ferner sollte hierbei die Lebensdauer der elektronischen Vorrichtungen und andere Eigenschaften derselben nicht nachteilig durch die Verbesserung der Materialien in zuvor genannter Hinsicht beeinflusst werden. Hierzu gehört unter anderem die Energieeffizienz, mit der eine elektronische Vorrichtung die vorgegebene Aufgabe löst. Bei organischen Leuchtdioden sollte insbesondere die Lichtausbeute hoch sein, so dass zum Erreichen eines bestimmten Lichtflusses möglichst wenig elektrische Leistung aufgebracht werden muss. Weiterhin sollte auch zum Erzielen einer vorgegebenen Leuchtdichte eine möglichst geringe Spannung notwendig sein.

Eine weitere Aufgabe kann darin gesehen werden, elektronische Vorrichtungen mit einer ausgezeichneten Leistungsfähigkeit möglichst kostengünstig und in konstanter Qualität bereitzustellen.

Überraschend wurde gefunden, dass bestimmte, nachfolgend näher beschriebene Verfahren diese Aufgaben lösen und den Nachteil aus dem Stand der Technik beseitigen. Die Bildung eines Feinanteils lässt sich umgehen, wenn das Material aus einer fließfähigen Form in eine dosierbare Form gebracht wird. Ferner kann die Staubproblematik beim Verarbeiten der funktionalen Materialien durch das Überführen derselben in Granulatform vermieden werden. Hierdurch können insbesondere Verbesserungen hinsichtlich der Verarbeitbarkeit, der Transportfähigkeit und der Lagerbarkeit von Materialien zur Herstellung von elektronischen Vorrichtungen erzielt werden. Hierbei führt die Verwendung von Granulat zu sehr guten Eigenschaften organischer elektronischer Vorrichtungen, insbesondere von organischen Elektrolumineszenzvorrichtungen, insbesondere hinsichtlich der Lebensdauer, der Effizienz und der Betriebsspannung.

Gegenstand der vorliegenden Erfindung ist daher ein Verfahren zur Herstellung einer Mischung aus verschiedenen Matrixmaterialien, enthaltend mindestens ein elektronenleitendes Matrixmaterial und mindestens ein lochleitendes Matrixmaterial als funktionale Materialien (FM1, FM2), welche zur Herstellung von Funktionsschichten elektronischer Vorrichtungen einsetzbar sind und welche ein Molekulargewicht von ≤ 2000 g/mol haben, umfassend die Schritte:
A) Bereitstellung von mindestens zwei funktionalen Materialien, welche zur Herstellung von Funktionsschichten elektronischer Vorrichtungen einsetzbar sind;
B) Überführen der unter A) bereitgestellten Materialien in einen Schneckenextruder, der mindestens eine Homogenisierungszone umfasst;
C) Extrudieren der in Schritt B) überführten Materialien unter Erhalt einer Mischung und nach Schritt C);
D) Verfestigen der gemäß Schritt C) erhaltenen Mischung, wobei die in Schritt A) bereitgestellten und in Schritt B) überführten Materialien sublimierbar sind und die in Schritt C) durchgeführte Extrusion unterhalb der Schmelztemperatur und/oder der Sublimationstemperatur und unterhalb der Zersetzungstemperatur der in Schritt B) überführten Materialien und oberhalb der niedrigsten Glasübergangstemperatur durchgeführt wird, die die in Schritt A) bereitgestellten und in Schritt B) überführten Materialien oder die Mischung der in Schritt A) bereitgestellten und in Schritt B) überführten Materialien aufweisen, wobei die in Schritt D) erhaltene, verfestigte Mischung ein Granulat darstellt oder in ein Granulat überführt wird.

Die Mischung, enthaltend mindestens zwei funktionale Materialien (FM1, FM2) gemäß den Ansprüchen, welche zur Herstellung von Funktionsschichten elektronischer Vorrichtungen einsetzbar sind, kann mindestens zwei, drei, vier oder fünf funktionale Materialien (FM1, FM2), welche zur Herstellung von Funktionsschichten elektronischer Vorrichtungen einsetzbar sind, enthalten. Bevorzugt kann die Mischung, enthaltend mindestens zwei funktionale Materialien (FM1, FM2), welche zur Herstellung von Funktionsschichten elektronischer Vorrichtungen einsetzbar sind, genau zwei, genau drei, genau vier oder genau fünf funktionale Materialien (FM1, FM2), welche zur Herstellung von Funktionsschichten elektronischer Vorrichtungen einsetzbar sind, enthalten. Ferner kann die Mischung auch mehr als fünf Materialien, welche zur Herstellung von Funktionsschichten elektronischer Vorrichtungen einsetzbar sind, enthalten. Demgemäß können in Schritt A) zwei, drei, vier, fünf oder mehr funktionale Materialien bereitgestellt werden.

Mindestens eines, vorzugsweise mindestens zwei, besonders bevorzugt alle der zur Herstellung einer Mischung gemäß den Ansprüchen verwendeten funktionalen Materialien (FM1, FM2), welche zur Herstellung von Funktionsschichten elektronischer Vorrichtungen einsetzbar sind, kann/können beispielsweise als Pulver/Granulat oder als organisches Glas bereitgestellt werden. Weiterhin kann das erfindungsgemäße Verfahren jedoch insbesondere als Schritt bei der Herstellung eines dieser funktionalen Materialien durchgeführt werden, wobei ein zweites, drittes oder weiteres Material in einem Extruder zugegeben wird. Vorzugsweise wird daher eine fließfähige Zusammensetzung durch ein Herstellungsverfahren eines der funktionalen Materialien (FM1, FM2) bereitgestellt. Die fließfähige Zusammensetzung kann durch entsprechendes Abkühlen einer Schmelze bereitgestellt werden, so dass eine extrudierbare Zusammensetzung erhalten wird, oder, je nach Ausgestaltung der Anlage, als Schmelze zu einem Pulver, einem organischen Glas oder einer extrudierbaren Masse in einen Extruder eingeleitet werden.

Vorzugsweise kann vorgesehen sein, dass mindestens eines, vorzugsweise mindestens zwei und besonders bevorzugt alle der mindestens zwei funktionalen Materialien (FM1, FM2), welche zur Herstellung von Funktionsschichten elektronischer Vorrichtungen einsetzbar sind, zersetzungsfrei oberhalb einer Temperatur von 50°C, vorzugsweise oberhalb einer Temperatur von 100°C schmelzbar sind. Vorzugsweise kann vorgesehen sein, dass mindestens eines, vorzugsweise mindestens zwei und besonders bevorzugt alle der mindestens zwei funktionalen Materialien (FM1, FM2), welche zur Herstellung von Funktionsschichten elektronischer Vorrichtungen einsetzbar sind, zersetzungsfrei oberhalb einer Temperatur von 150°C, oberhalb einer Temperatur von 200°C, oberhalb einer Temperatur von 250°C oder oberhalb einer Temperatur von 300°C schmelzbar sind.

Weiterhin kann bevorzugt vorgesehen sein, dass mindestens eines, vorzugsweise mindestens zwei und besonders bevorzugt alle der mindestens zwei funktionalen Materialien (FM1, FM2), welche zur Herstellung von Funktionsschichten elektronischer Vorrichtungen einsetzbar sind, oberhalb einer Temperatur von 30°C, vorzugsweise oberhalb einer Temperatur von 50°C, besonders bevorzugt oberhalb einer Temperatur von 100°C eine Viskosität im Bereich von 1 bis 10²⁰ [mPa s], bevorzugt 10³ bis 10¹⁸ [mPa s], besonders bevorzugt 10⁶ bis 10¹⁴ [mPa s] bei einer Scherung von 1 bis 10⁴ [1/s], bevorzugt 10 bis 10³ [1/s], besonders bevorzugt 100 [1/s] aufweisen. Ein bevorzugtes Verfahren zur Messung der Viskosität wird später dargelegt.

Ferner kann vorgesehen sein, dass mindestens eines, vorzugsweise mindestens zwei und besonders bevorzugt alle der mindestens zwei funktionalen Materialien (FM1, FM2), welche zur Herstellung von Funktionsschichten elektronischer Vorrichtungen einsetzbar sind, im geschmolzenen Zustand bei Verarbeitungstemperatur einen Abbau von höchstens 0,1 Gew.-% über eine Lagerdauer von 10 Stunden zeigt/zeigen. Hierbei kann die Verarbeitungstemperatur im Bereich von 50°C bis 500°C liegen. Die Verarbeitungstemperatur ist die Temperatur, bei der die Extrusion erfolgt. Vorzugsweise zeigt/zeigen mindestens eines, vorzugsweise mindestens zwei und besonders bevorzugt alle der mindestens zwei funktionalen Materialien (FM1, FM2), welche zur Herstellung von Funktionsschichten elektronischer Vorrichtungen einsetzbar sind, bei der jeweiligen Schmelztemperatur einen Abbau von höchstens 0,1 Gew.-% über eine Lagerdauer von 10 Stunden.

In einer bevorzugten Ausgestaltung des erfindungsgemäßen Verfahrens werden Materialien eingesetzt, die sublimierbar sind. Materialien die sublimierbar sind, weisen bevorzugt ein geringes Molekulargewicht aus, wie dieses später dargelegt wird.

In Schritt C) des erfindungsgemäßen Verfahrens werden die in Schritt B) überführten Materialien unter Erhalt einer Mischung extrudiert. Der Begriff "Extrudieren" ist in der Fachwelt weithin bekannt und bezeichnet ein Herauspressen einer verfestigbaren Masse durch eine Öffnung. Hierzu wird gemäß der vorliegenden Erfindung ein Extruder verwendet. Extruder sind in der Fachwelt ebenfalls bekannt und kommerziell erhältlich. Der Begriff Extruder bezeichnet ein Fördergerät zur Durchführung einer Extrusion.

Beispielsweise können Einschnecken- oder Doppelschneckenextruder eingesetzt werden. Die Auswahl und Anpassung geeigneter Extruderschnecken, insbesondere deren Geometrien aufgrund der entsprechenden verfahrenstechnischen Aufgaben, wie z. B. Einziehen, Fördern, Homogenisieren, Erweichen und Komprimieren, gehört dabei zum allgemeinen Wissen des Fachmannes.

Im Einzugsbereich des Extruders, vorzugsweise des Schneckenextruders, werden vorzugsweise Zylindertemperaturen im Bereich von 50° bis 450°C, vorzugsweise 80° bis 350°C eingestellt, je nach Art der funktionalen Materialien (FM1, FM2). In den Einzugsbereich können beispielsweise die zuvor und nachfolgend dargelegten funktionalen Materialien (FM1, FM2) in Form von Pulver, fließfähiger Masse und/oder Granulat zugeführt werden.

Ferner kann vorgesehen sein, dass die mindestens zwei funktionalen Materialien (FM1, FM2), welche zur Herstellung von Funktionsschichten elektronischer Vorrichtungen einsetzbar sind, in einen einzigen Einzug des Extruders zugegeben werden.

Weiterhin kann vorgesehen sein, dass die mindestens zwei funktionalen Materialien (FM1, FM2), welche zur Herstellung von Funktionsschichten elektronischer Vorrichtungen einsetzbar sind, in zwei verschiedene Einzüge des Extruders zugegeben werden.

Dem Einzugsbereich können Zonen, in denen das Material erweicht und homogenisiert wird, nachgeschaltet sein, gefolgt vom Austragsbereich (Düse).

Der Extruder ist einen Schneckenextruder der mindestens eine Homogenisierungszone umfasst. Eine Homogenisierung der erweichten funktionalen Materialien (FM1, FM2) kann vorzugsweise durch die Verwendung von Knetblöcken erfolgen.

Das verwendete Temperaturprofil variiert dabei in Abhängigkeit von den eingesetzten funktionalen Materialien (FM1, FM2). Im Erweichungs- und Homogenisierungsbereich werden vorzugsweise Temperaturprofile im Bereich von 80 bis 450°C, vorzugsweise 90 bis 350°C, besonders bevorzugt 100 bis 300°C, insbesondere bevorzugt 120 bis 250°C und speziell bevorzugt 130 bis 230°C eingestellt. Im Austragsbereich liegen die Temperaturen vorzugsweise im Bereich von 80 bis 450°C, vorzugsweise 90 bis 350°C, besonders bevorzugt 100 bis 300°C, insbesondere bevorzugt 120 bis 250°C und speziell bevorzugt 130 bis 230°C. Die angegebenen Temperaturen beziehen sich hierbei auf Zylindertemperaturen und können mittels eines Thermoelements, z. Bsp. FeCuNi Typ L oder Typ J, eines PT 100 Thermometer oder eines IR-Thermometers gemessen werden.

Ferner kann vorgesehen sein, dass das Extrudieren gemäß Schritt C) mindestens 5°C, vorzugsweise mindestens 10°C oberhalb der Glasübergangstemperatur des funktionalen Materials mit der geringsten Glasübergangstemperatur durchgeführt wird. Weiterhin kann vorgesehen sein, dass das Extrudieren gemäß Schritt C) mindestens 5°C, vorzugsweise mindestens 10°C oberhalb der Glasübergangstemperatur der Mischung der in Schritt A) bereitgestellten und in Schritt B) überführten Materialien durchgeführt wird.

In einer bevorzugten Ausgestaltung wird das Extrudieren gemäß Schritt C) vorzugsweise mit einer Mischung durchgeführt, die eine Viskosität im Bereich von 1 bis 50000 [mPa s], vorzugsweise 10 bis 10000 [mPa s] und besonders bevorzugt 20 bis 1000 [mPa s] aufweist, gemessen mittels Platte-Platte unter Rotation bei einer Schergeschwindigkeit von 100 s⁻¹ und einer Temperatur im Bereich von 150° bis 450°C.

Die Viskositätswerte, wie diese zuvor und nachfolgend dargelegt sind, werden mittels Platte-Platte unter Rotation bestimmt. Hierbei können die rheologischen Messungen mit einem Discovery Hybrid Rheometer HR-3, versehen mit der Heiz-Einheit ETC, der Fa. Waters GmbH - UM TA Instruments, D-65760 Eschborn, Germany, durchgeführt werden. Die Kalibrierung kann mit Referenzen durchgeführt werden. Beispielsweise können hierzu folgende Öle eingesetzt werden:

| Referenz-Öl | Temperatur [°C] | Viskosität [mPa*s] | Abweichung |
|---|---|---|---|
| Fungilab RT10 | 20,00 | 11,14 | ±3,0% |
| Fungilab RT10 | 25,00 | 10,14 | ±3,0% |
| Paragon 2162/21 | 20,00 | 17,53 | ±3,0% |
| Paragon 2162/21 | 25,00 | 14,26 | ±3,0% |
| Brookfield Fluid | 25,00 | 497,00 | ±3,0% |
| Brookfield 5000 | 25,00 | 4795,00 | ±3,0%. |

Vielfach werden die Viskositäten bei drei unterschiedlichen Scherraten (10/s, 100/s und 500/s) in Abhängigkeit der Temperatur gemessen, wobei die jeweiligen Bedingungen zuvor und nachfolgend ausführlicher dargelegt sind. Vorzugsweise beträgt die Schergeschwindigkeit (Scherrate) 100 s⁻¹. Die Viskositätswerte werden vorzugsweise in Anlehnung an DIN 53019; insbesondere DIN 53019-1:2008-09, DIN 53019-2:2001-02, DIN 53019-3:2008-09 gemessen.

Weiterhin kann vorgesehen sein, dass die in Schritt C) erhaltene Mischung eine Viskosität im Bereich von 1 bis 50000 [mPa s], vorzugsweise 10 bis 10000 [mPa s] und besonders bevorzugt 20 bis 1000 [mPa s] aufweist, gemessen mittels Platte-Platte unter Rotation bei einer Schergeschwindigkeit von 100 s⁻¹ und einer Temperatur, die dem arithmetischen Mittelwert aus Glasübergangstemperatur des funktionalen Materials mit der geringsten Schmelztemperatur und Schmelztemperatur des funktionalen Materials mit der geringsten Schmelztemperatur entspricht. Falls keines der funktionalen Materialien eine Schmelztemperatur zeigt, so ist stattdessen die Temperatur heranzuziehen, die dem arithmetischen Mittelwert aus Glasübergangstemperatur des funktionalen Materials mit der geringsten Sublimationstemperatur und Sublimationstemperatur des funktionalen Materials mit der geringsten Sublimationstemperatur entspricht. Falls keines der funktionalen Materialien eine Sublimationstemperatur zeigt, so ist stattdessen die Temperatur heranzuziehen, die dem arithmetischen Mittelwert aus Glasübergangstemperatur des funktionalen Materials mit der geringsten Zersetzungstemperatur und Zersetzungstemperatur des funktionalen Materials mit der geringsten Zersetzungstemperatur entspricht.

Vorzugsweise weist mindestens eines, besonders bevorzugt weisen mindestens zwei der mindestens zwei funktionalen Materialien (FM1, FM2), welche zur Herstellung von Funktionsschichten elektronischer Vorrichtungen einsetzbar sind, eine Schmelztemperatur im Bereich von 150° bis 500°C, vorzugsweise 180° bis 400°C, besonders bevorzugt 220° bis 380°C und speziell bevorzugt 250° bis 350°C gemessen gemäß **DIN EN** ISO 11357-1 und **DIN EN** ISO 11357-2 auf. Die Schmelztemperatur ergibt sich hierbei aus der Messung der Glasübergangstemperatur in Form eines DSC-Signals, wobei weitere Einzelheiten zur Messung der Schmelztemperatur im Zusammenhang mit der Bestimmung der Glasübergangstemperatur dargelegt sind.

Für das vorliegende Verfahren ist es nicht wesentlich, dass sämtliche Materialien einen Schmelzpunkt aufweisen. Im Allgemeinen ist es ausreichend, dass mindestens eines der Materialien bei einer ausreichend hohen Viskosität erweicht. Für eine sehr gute Homogenisierung ist es bevorzugt, dass mindestens zwei, besonders bevorzugt alle der mindestens zwei funktionalen Materialien (FM1, FM2), welche zur Herstellung von Funktionsschichten elektronischer Vorrichtungen einsetzbar sind, bei einer ausreichend hohen Viskosität erweichen.

Demgemäß weisen einige der funktionalen Materialien keinen Schmelzpunkt auf, sondern zersetzen sich oder sublimieren. Die nachfolgend angegebenen Sublimations- oder Zersetzungstemperaturen sind nur einschlägig, falls eines oder mehrere der eingesetzten funktionalen Materialien keinen Schmelzpunkt aufweist/aufweisen. Dementsprechend kann vorgesehen sein, dass mindestens eines der mindestens zwei funktionalen Materialien (FM1, FM2), welche zur Herstellung von Funktionsschichten elektronischer Vorrichtungen einsetzbar sind, eine Sublimationstemperatur im Bereich von 150° bis 500°C, vorzugsweise 180° bis 400°C, besonders bevorzugt 220° bis 380°C und speziell bevorzugt 250° bis 350°C gemessen gemäß DIN 51006 aufweist. Die Sublimationstemperatur ergibt sich hierbei aus der Vakuum-TGA Messung, bei der gezielt ein Material sublimiert oder verdampft wird. Die Messung kann mit einem TG 209 F1 Libra Gerät der Firma Netzsch mit folgenden Messbedingungen durchgeführt werden:
Probeneinwaage: 1 mg;
Tiegel: offener Aluminiumtiegel;
Heizrate: 5 K/min;
Temperaturbereich: 105°-550°C;
Atmosphäre: Vakuum 10⁻² mbar (geregelt);

Evakuierungszeit vor Beginn der Messung: ca. 30 Minuten. Als Sublimationstemperatur wird die Temperatur verwendet bei der 5% Gewichtsverlust eintritt.

Ferner kann vorgesehen sein, dass mindestens eines der zwei funktionalen Materialien (FM1, FM2), welche zur Herstellung von Funktionsschichten elektronischer Vorrichtungen einsetzbar sind, eine Zersetzungstemperatur oberhalb von 340°C, vorzugsweise oberhalb von 350°C oder 400°C, besonders bevorzugt oberhalb von 500°C aufweist. Die Zersetzungstemperatur ergibt sich hierbei aus einer DSC oder TGA-Messung, wobei die Zerstörung des Materials festgestellt wird. Als Zersetzungstemperatur gilt die Temperatur bei der 50% Zerstörung der Substanz innerhalb der Aufheizung, die mit 5 K pro Minute erfolgt, festgestellt wird (Probengröße ca. 1mg).

Gemäß einer bevorzugten Ausführungsform kann vorgesehen sein, dass mindestens eines, vorzugsweise mindestens zwei und besonders bevorzugt alle der mindestens zwei funktionale Materialien (FM1, FM2), welche zur Herstellung von Funktionsschichten elektronischer Vorrichtungen einsetzbar sind, jeweils eine Glasübergangstemperatur im Bereich von 80° bis 400°C, vorzugsweise 90° bis 300°C, besonders bevorzugt 100° bis 250°C, insbesondere bevorzugt 120° bis 220°C und speziell bevorzugt 130° bis 200°C gemessen gemäß DIN EN ISO 11357-1 und DIN EN ISO 11357-2 aufweist/aufweisen. Die Einzelheiten zur Bestimmung der Glasübergangstemperatur sind dem Fachmann aus den Normen bekannt, wobei vorzugsweise die Glasübergangstemperatur nach einem ersten Heiz- und Abkühlvorgang bestimmt wird. Für viele Substanzen kann bei einer Heizrate von 20 K/min für das erste und zweite Heizen und einer Kühlrate von 20 K/min für das erste und zweite Kühlen eine zweckmäßige Glasübergangstemperatur erhalten werden, die beim zweiten oder dritten Heizvorgang, vorzugsweise beim zweiten Heizvorgang, als Signal ermittelt wird. In einer speziell bevorzugten Ausführungsform wird die Glasübergangstemperatur anhand einer Probe ermittelt, die durch einen ersten Heizvorgang mit einer Heizrate von 20 K/min und einem Quenchvorgang, der durch unmittelbares Kühlen der erhitzten Probe in flüssigem Stickstoff vorbereitet wird und die Glasübergangstemperatur durch ein zweites Heizen der so vorbehandelten Probe mit einer Heizrate von 50 K/min bestimmt wird. Durch diese Maßnahmen kann die Glasübergangstemperatur zuverlässig auch auf für Substanzen bestimmt werden, deren Glasübergang bei anderen Verfahren durch eine Rekristallisationstemperatur überlagert wird. Diese Meßmethode, bei der das erste Abkühlen durch einen Quenchvorgang bewirkt wird und das 2. Aufheizen mit einer Heizrate von 50 K/min durchgeführt wird, ist gegenüber anderen, die beispielsweise mit geringeren Abkühlraten oder geringeren Aufheizrate arbeiten, besonders bevorzugt. Der Heizbereich liegt vorzugsweise im Bereich von 0°C bis 350°C, falls die Schmelztemperatur unterhalb von 300°C liegt. Bei höher schmelzenden Substanzen wird der Heizbereich entsprechend nach oben vergrößert, wobei dieser jedoch unterhalb der Zersetzungstemperatur gehalten werden muss. Vorzugsweise liegt die obere Temperatur des Heizbereichs mindestens 5°C unterhalb der Zersetzungstemperatur.

Die Probenmenge liegt vorzugsweise im Bereich von 10 bis 15 mg. Weitere Informationen bezüglich der Bestimmung der Glasübergangstemperatur finden sich in den Beispielen. In den Beispielen sind insbesondere bevorzugte Messgeräte dargelegt.

Vorzugsweise beträgt die Differenz zwischen der Schmelztemperatur des Materials mit der höchsten Schmelztemperatur der eingesetzten mindestens zwei funktionalen Materialien (FM1, FM2), welche zur Herstellung von Funktionsschichten elektronischer Vorrichtungen einsetzbar sind, und der Schmelztemperatur des Materials mit der geringsten Schmelztemperatur der eingesetzten mindestens zwei funktionalen Materialien (FM1, FM2), welche zur Herstellung von Funktionsschichten elektronischer Vorrichtungen einsetzbar sind, vorzugsweise höchstens 200°C, insbesondere bevorzugt höchstens 150°C, speziell bevorzugt höchstens 100°C, besonders speziell bevorzugt höchstens 70°C. Diese Ausführungen gelten für sämtliche Materialien der eingesetzten mindestens zwei funktionalen Materialien (FM1, FM2), welche zur Herstellung von Funktionsschichten elektronischer Vorrichtungen einsetzbar sind und eine Schmelztemperatur zeigen.

Bevorzugt kann weiterhin vorgesehen sein, dass die Differenz zwischen Glasübergangstemperatur des Materials mit der höchsten Glasübergangstemperatur der eingesetzten mindestens zwei funktionalen Materialien (FM1, FM2), welche zur Herstellung von Funktionsschichten elektronischer Vorrichtungen einsetzbar sind, und die Glasübergangstemperatur des Materials mit der geringsten Glasübergangstemperatur der eingesetzten mindestens zwei funktionalen Materialien (FM1, FM2), welche zur Herstellung von Funktionsschichten elektronischer Vorrichtungen einsetzbar sind, höchstens 150°C, insbesondere bevorzugt höchstens 100°C, speziell bevorzugt höchstens 70°C beträgt. Diese Ausführungen gelten für sämtliche Materialien der eingesetzten mindestens zwei funktionalen Materialien (FM1, FM2), welche zur Herstellung von Funktionsschichten elektronischer Vorrichtungen einsetzbar sind und eine Glasübergangstemperatur zeigen. Es ist jedoch festzuhalten, dass mindestens eines, vorzugsweise mindestens zwei und besonders bevorzugt alle der mindestens zwei funktionale Materialien (FM1, FM2), welche zur Herstellung von Funktionsschichten elektronischer Vorrichtungen einsetzbar sind, jeweils eine Glasübergangstemperatur zeigt/zeigen.

In einer weiteren Ausgestaltung des vorliegenden Verfahrens kann vorgesehen sein, dass das Extrudieren bei einem Druck im Bereich von 0,2 bis 50 bar, vorzugsweise 0,5 bis 10 bar erfolgt, gemessen als absoluter Druck im Einzugsbereich des Extruders.

Vorzugsweise wird Schritt C) unter Schutzgasatmosphäre oder unter Vakuum durchgeführt, ohne dass hierdurch eine Beschränkung erfolgen soll. Durch das Verwenden von Schutzgas oder Vakuum kann überraschend die Qualität des extrudierten Materials verbessert werden.

Schutzgase sind Gase, die mit dem oder den funktionalen Material(ien) (FM1, FM2) keine Reaktion bei den Verfahrensbedingungen eingehen. Vorzugsweise ist das Schutzgas, auch Inertgas genannt, Stickstoff, Kohlendioxid, ein Edelgas, insbesondere Helium, Argon, Neon, Xenon, Krypton oder eine Mischung umfassend, besonders bevorzugt bestehend, aus diesen Gasen. Hierbei sind Argon, Stickstoff oder Mischungen umfassend diese Gase bevorzugt, wobei besonders bevorzugt Argon, Stickstoff oder Mischungen bestehend aus diesen Gasen eingesetzt wird/werden.

Nach Schritt C) wird die erhaltene Mischung verfestigt. Vorzugsweise erfolgt Verfestigen der gemäß Schritt C) erhaltenen Mischung durch Abkühlen auf eine Temperatur unterhalb von 60°C.

Der Austrag der in Schritt C) erhaltenen und in Schritt D) verfestigten Mischung aus dem Extruder erfolgt im Allgemeinen durch eine Düse. Vorzugsweise weist die Düse einen Durchmesser von bevorzugt höchstens 10 cm, besonders bevorzugt einen Durchmesser im Bereich von 0,1 bis 10 cm, ganz besonders bevorzugt einen Durchmesser im Bereich von 1 bis 8 cm auf.

In einer bevorzugten Ausgestaltung besteht die in Schritt D) erhaltene Mischung im Wesentlichen bevorzugt aus funktionalen Materialien (FM1, FM2), welche zur Herstellung von Funktionsschichten elektronischer Vorrichtungen einsetzbar sind. Vorzugsweise kann vorgesehen sein, dass die in Schritt D) erhaltene Mischung mindestens 90 Gew.-%, vorzugsweise mindestens 95 Gew.-% und speziell bevorzugt mindestens 99 Gew.-% an funktionalen Materialien (FM1, FM2), welche zur Herstellung von Funktionsschichten elektronischer Vorrichtungen einsetzbar sind, aufweist.

In einer bevorzugten Ausführungsform kann vorgesehen sein, dass die in Schritt D) erhaltene, verfestigte Mischung ein Granulat darstellt oder in ein Granulat überführt wird.

Ein gemäß einer bevorzugten Ausführungsform erhaltenes Granulat weist vorzugsweise einen Durchmesser im Bereich von 0,1 mm bis 10 cm, vorzugsweise 1 mm bis 8 cm und besonders bevorzugt 1 cm bis 5 cm auf, gemessen mit optischen Methoden als numerischer Mittelwert. In einer weiteren Ausführungsform weist ein bevorzugt erhaltenes Granulat vorzugsweise einen Durchmesser im Bereich von 0,1 mm bis 10 cm, vorzugsweise 1 mm bis 8 cm und besonders bevorzugt 1 cm bis 5 cm auf, gemessen gemäß der Siebmethode, wobei mindestens 90 % der Granulatteilchen, besonders bevorzugt mindestens 99 % der Granulatteilchen einen Durchmesser im Bereich von 0,1 mm bis 10 cm, vorzugsweise 1 mm bis 8 cm und besonders bevorzugt 1 cm bis 5 cm zeigen, wobei sich die Prozentangabe auf die Partikelzahl bezieht.

Bei nicht-sphärischem Granulat beziehen sich die zuvor genannten Durchmesser auf die geringste Ausdehnung der Granulatpartikel.

Ferner kann vorgesehen sein, dass ein gemäß der vorliegenden Erfindung bevorzugt erhaltenes Granulat einen Feinanteil kleiner 0,1 Gew.-% aufweist. Vorzugsweise wird der Feinanteil durch Partikel mit einem Durchmesser kleiner als 0,1 mm gebildet.

Weiterhin kann vorgesehen sein, dass ein gemäß der vorliegenden Erfindung bevorzugt erhaltenes Granulat eine Schüttdichte von mindestens 0,3 g/cm³, bevorzugt mindestens 0,6 g/cm³ aufweist. Vorzugsweise beträgt das Verhältnis von Schüttdichte des Granulats zur Dichte des zur Herstellung des Granulats verwendeten Materials (FM1, FM2) mindestens 1:2, bevorzugt mindestens 2:3, besonders bevorzugt mindestens 3:4 und speziell bevorzugt mindestens 5:6.

In einer weiteren Ausgestaltung ist mindestens eines, vorzugsweise sind mindestens zwei, besonders bevorzugt sind alle der funktionalen Materialien (FM1, FM2), welche zur Herstellung von Funktionsschichten elektronischer Vorrichtungen einsetzbar sind, ausgewählt aus der Gruppe bestehend aus der Gruppe der Benzene, Fluorene, Indenofluorene, Spirobifluorene, Carbazole, Indenocarbazole, Indolocarbazole, Spirocarbazole, Pyrimidine, Triazine, Chinazoline, Chinoxaline, Pyridine, Chinoline, iso-Chinoline, Lactame, Triarylamine, Dibenzofurane, Dibenzothiophene, Imidazole, Benzimidazole, Benzoxazole, Benzthiazole, 5-Aryl-phenanthridin-6-one, 9,10-Dihydrophenanthrene, Fluoranthene, Naphthaline, Phenanthrene, Anthracene, Benzanthracene, Fluoradene, Pyrene, Perylene, Chrysene, Borazine, Boroxine, Borole, Borazole, Azaborole, Ketone, Phosphinoxide, Arylsilane, Siloxane, Biphenyle, Triphenyle, Terphenyle, Triphenylene, Arylgermane, Arylbismutodide, Metallkomplexe, Chelatkomplexe, Übergangsmetallkomplexe, Metallcluster und deren Kombinationen, wobei Metallkomplexe, Chelatkomplexe, Übergangsmetallkomplexe, Metallcluster bevorzugt die Elemente Li, Na, K, Cs, Be, Mg, Bor, Al, Ga In, Ge, Sn, Bi, Se, Te, Sc, Ti, Zr, Mo, W, Re, Ru, Os, Rh, Ir, Pd, Pt, Cu, Ag, Au, Zn enthalten.

Die zur Herstellung der vorliegenden Mischungen, vorzugsweise Granulate, eingesetzten funktionalen Materialien (FM1, FM2) stellen vielfach organische Verbindungen dar, welche die zuvor und nachfolgend genannten Funktionen bereitstellen. Daher sind die Begriffe funktionelle Verbindung beziehungsweise funktionales Material vielfach synonym zu verstehen.

Organisch funktionale Materialien (FM1, FM2) werden vielfach über die Eigenschaften der Grenzorbitale beschrieben, die nachfolgend näher dargelegt werden. Molekülorbitale, insbesondere auch das highest occupied molecular orbital (HOMO) und das lowest unoccupied molecular orbital (LUMO), deren Energieniveaus sowie die Energie des niedrigsten Triplettzustands T₁ bzw. des niedrigsten angeregten Singulettzustands S₁ der Materialien werden über quantenchemische Rechnungen bestimmt. Zur Berechnung organischer Substanzen ohne Metalle wird zuerst eine Geometrieoptimierung mit der Methode "Ground State/Semiempirical/Default Spin/AM1/Charge 0/Spin Singlet" durchgeführt. Im Anschluss erfolgt auf Grundlage der optimierten Geometrie eine Energierechnung. Hierbei wird die Methode "TD-SCF/DFT/Default Spin/B3PW91" mit dem Basissatz "6-31G(d)" verwendet (Charge 0, Spin Singlet). Für metallhaltige Verbindungen wird die Geometrie über die Methode "Ground State/Hartree-Fock/Default Spin/LanL2MB/Charge 0/Spin Singlet" optimiert. Die Energierechnung erfolgt analog zu der oben beschriebenen Methode für die organischen Substanzen mit dem Unterschied, dass für das Metallatom der Basissatz "LanL2DZ" und für die Liganden der Basissatz "6-31G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt: $HOMO \left(eV\right) = \left(\left(HEh*27.212\right)-0.9899\right) / 1.1206$ $LUMO \left(eV\right) = \left(\left(LEh*27.212\right)-2.0041\right) / 1.385$

Diese Werte sind im Sinne dieser Anmeldung als HOMO- bzw. LUMO-Energieniveaus der Materialien anzusehen.

Der niedrigste Triplettzustand T₁ ist definiert als die Energie des Triplettzustands mit der niedrigsten Energie, der sich aus der beschriebenen quantenchemischen Rechnung ergibt.

Der niedrigste angeregte Singulettzustand S₁ ist definiert als die Energie des angeregten Singulettzustands mit der niedrigsten Energie, der sich aus der beschriebenen quantenchemischen Rechnung ergibt.

Die hierin beschriebene Methode ist unabhängig von dem verwendeten Softwarepaket und liefert immer dieselben Ergebnisse. Beispiele oft benutzter Programme für diesen Zweck sind "Gaussian09W" (Gaussian Inc.) und Q-Chem 4.1 (Q-Chem, Inc.).

Verbindungen mit Lochinjektionseigenschaften, hierin auch Lochinjektionsmaterialien genannt, erleichtern oder ermöglichen die Übertragung von Löchern, d. h. positive Ladungen, aus der Anode in eine organische Schicht. Im Allgemeinen weist ein Lochinjektionsmaterial ein HOMO-Niveau auf, das im Bereich des Niveaus der Anode ist oder darüber liegt, d. h. im Allgemeinen mindestens -5,3 eV.

Verbindungen mit Lochtransporteigenschaften, hierin auch Lochtransportmaterialien genannt, sind in der Lage Löcher, d. h. positive Ladungen, zu transportieren, die im Allgemeinen aus der Anode oder einer angrenzenden Schicht, beispielsweise einer Lochinjektionsschicht injiziert werden. Ein Lochtransportmaterial weist im Allgemeinen ein hohes HOMO-Niveau von vorzugsweise mindestens -5.4 eV auf. Je nach Aufbau einer elektronischen Vorrichtung kann ein Lochtransportmaterial auch als Lochinjektionsmaterial eingesetzt werden.

Zu den bevorzugten organischen funktionalen Materialien (FM1, FM2), die Lochinjektions- und/oder Lochtransporteigenschaften aufweisen, gehören beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weitere O-, S- oder N-haltige Heterocyclen mit hoch liegendem HOMO (HOMO = höchstes besetztes Molekülorbital).

Insbesondere zu nennen sind als organische funktionale Materialien (FM1, FM2), die Lochinjektions- und/oder Lochtransporteigenschaften aufweisen, Phenylendiamin-Derivate (US 3615404), Arylamin-Derivate (US 3567450), Amino-substituierte Chalcon-Derivate (US 3526501), Styrylanthracen-Derivate (JP-A-56-46234), Polyzyklische aromatische Verbindungen (EP 1009041), Polyarylalkan-Derivate (US 3615402), Fluorenon-Derivate (JP-A-54-110837), Hydrazon-Derivate (US 3717462), Acylhydrazone, Stilben-Derivate (JP-A-61-210363), Silazan-Derivate (US 4950950), Polysilane (JP-A-2-204996), Anilin-Copolymere (JP-A-2-282263), Thiophen-Oligomere (JP Heisei 1 (1989) 211399), Polythiophene, Poly(N-vinylcarbazol) (PVK), Polypyrrole, Polyaniline und andere elektrisch leitende Makromoleküle, Porphyrin-Verbindungen (JP-A-63-2956965, US 4720432), aromatische Dimethyliden-Typ-Verbindungen, Carbazol-Verbindungen wie z.B. CDBP, CBP, mCP, aromatische tertiäre Amin- und Styrylamin-Verbindungen (US 4127412) wie z.B. Triphenylamine vom Benzidin-Typ, Triphenylamine vom Styrylamin-Typ und Triphenylamine vom Diamin-Typ. Auch Arylamin-Dendrimere können verwendet werden (JP Heisei 8 (1996) 193191), monomere Triarylamine (US 3180730), Triarylamine mit einem oder mehreren Vinylradikalen und/oder mindestens einer funktionellen Gruppe mit aktivem Wasserstoff (US 3567450 und US 3658520) oder Tetraaryldiamine (die zwei Tertiäramineinheiten sind über eine Arylgruppe verbunden). Es können auch noch mehr Triarylaminogruppen im Molekül vorhanden sein. Auch Phthalocyanin-Derivate, Naphthalocyanin-Derivate, Butadien-Derivate und Chinolinderivate wie z.B. Dipyrazino[2,3-f:2',3'-h]quinoxalinhexacarbonitril sind geeignet.

Bevorzugte organische funktionale Materialien (FM1, FM2) sind aromatische tertiäre Amine mit mindestens zwei Tertiäramin-Einheiten (US 2008/0102311 A1, US 4720432 und US 5061569), wie z.B. NPD (α-NPD = 4,4'-bis[N-(1-naphthyl)-N-phenylamino]biphenyl) (US 5061569), TPD 232 (= N,N'-Bis-(N,N'-diphenyl-4-aminophenyl)-N,N-diphenyl-4,4'-diamino-1,1'-biphenyl) oder MTDATA (MTDATA oder m-MTDATA= 4, 4', 4"-Tris[3-methylphenyl)phenyl-amino]triphenylamin) (JP-A-4-308688), TBDB (= N,N,N',N'-Tetra(4-biphenyl)diaminobiphenylen), TAPC (= 1,1-Bis(4-di-p-tolylaminophenyl)-cyclohexan), TAPPP (= 1,1-Bis(4-di-*p*-tolylaminophenyl)-3-phenylpropan), BDTAPVB (= 1,4-Bis[2-[4-[N,N-di(p-tolyl)amino]phenyl]vinyl]benzol), TTB (= N,N,N',N'-Tetra-*p*-tolyl-4,4'-diaminobiphenyl), TPD (= 4,4'-Bis[N-3-methylphenyl]-N-phenylamino)biphenyl), N,N,N',N'-Tetraphenyl-4,4‴-diamino-1,1',4',1",4",1"'-quaterphenyl, ebenso tertiäre Amine mit Carbazol-Einheiten wie z.B. TCTA (= 4-(9H-Carbazol-9-yl)-N,N-bis[4-(9H-carbazol-9-yl)phenyl]benzolamin). Ebenfalls bevorzugt sind Hexaaza-Triphenylen-Verbindungen gemäß US 2007/0092755 A1 sowie Phthalocyanin-Derivate (z.B. H₂Pc, CuPc (= Kupfer-Phthalocyanin), CoPc, NiPc, ZnPc, PdPc, FePc, MnPc, ClAlPc, ClGaPc, ClInPc, ClSnPc, Cl₂SiPc, (HO)AlPc, (HO)GaPc, VOPc, TiOPc, MoOPc, GaPc-O-GaPc).

Besonders bevorzugte organische funktionale Materialien (FM1, FM2) sind folgende Triarylamin-Verbindungen gemäß den Formeln (TA-1) bis (TA-6), die in den Dokumenten EP 1162193 B1, EP 650 955 B1, Synth. Metals 1997, 91(1-3), 209, DE 19646119 A1, WO 2006/122630 A1, EP 1 860 097 A1, EP 1834945 A1, JP 08053397 A, US 6251531 B1, US 2005/0221124, JP 08292586 A, US 7399537 B2, US 2006/0061265 A1, EP 1 661 888 und WO 2009/041635. Die genannten Verbindungen gemäß den Formeln (TA-1) bis (TA-6) können auch substituiert sein:

| | |
|---|---|
| 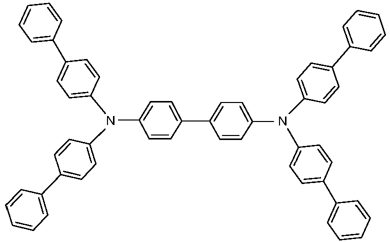 | 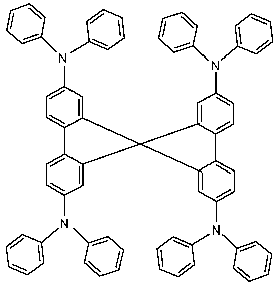 |
| Formel TA-1 | Formel TA-2 |
| 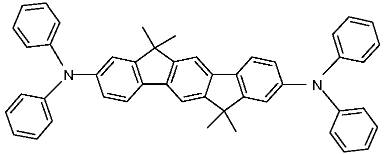 | 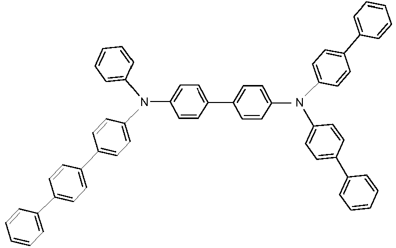 |
| Formel TA-3 | Formel TA-4 |
| 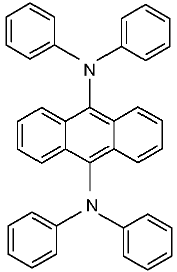 | 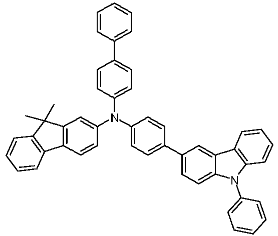 |
| Formel TA-5 | Formel TA-6 |
| 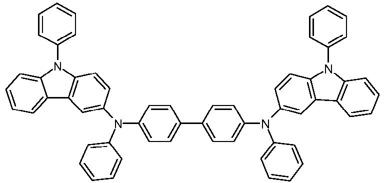 | 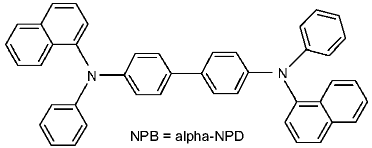 |
| Formel TA-7 | Formel TA-8 |
| 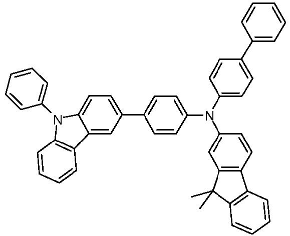 | 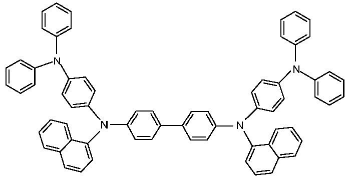 |
| Formel TA-9 | Formel TA-10 |
| 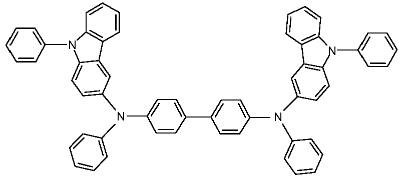 | 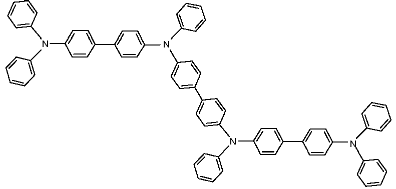 |
| Formel TA-11 | Formel TA-12 |

Weitere Verbindungen, die als Lochinjektionsmaterialien als organische funktionale Materialien (FM1, FM2) eingesetzt werden können, sind beschrieben in der EP 0891121 A1 und der EP 1029909 A1, Injektionsschichten allgemein in der US 2004/0174116 A1.

Vorzugsweise führen diese Arylamine und Heterocyclen, die im allgemeinen als Lochinjektions- und/oder Lochtransportmaterialien eingesetzt werden, zu einem HOMO von mehr als -5,8 eV (gegen Vakuumlevel), besonders bevorzugt von mehr als -5,5 eV.

Organische funktionale Materialien (FM1, FM2), die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen mit niedrig liegendem LUMO (LUMO = niedrigstes unbesetztes Molekülorbital).

Besonders geeignete Verbindungen als organische funktionale Materialien (FM1, FM2) für elektronentransportierende und elektroneninjizierende Schichten sind Metallchelate von 8-Hydroxychinolin (z.B. LiQ, AlQ₃, GaQ₃, MgQ₂, ZnQ₂, InQ₃, ZrQ₄), BAlQ, Ga-Oxinoid-Komplexe, 4-Azaphenanthren-5-ol-Be-Komplexe (US 5529853 A, vgl. Formel ET-1), Butadienderivate (US 4356429), heterozyklische optische Aufheller (US 4539507), Benzimidazol-Derivate (US 2007/0273272 A1), wie z.B. TPBI (US 5766779, vgl. Formel ET-2), 1,3,5-Triazine, z.B. Spirobifluoren-Triazin-Derivate (z.B. gemäß der DE 102008064200), Pyrene, Anthracene, Tetracene, Fluorene, Spirofluorene, Dendrimere, Tetracene (z.B. Rubren-Derivate), 1,10-Phenanthrolin-Derivate (JP 2003-115387, JP 2004-311184, JP-2001-267080, WO 2002/043449), Sila-Cyclopentadien-Derivate (EP 1480280, EP 1478032, EP 1469533), Boran-Derivate wie z.B. Triarylboranderivate mit Si (US 2007/0087219 A1, vgl. Formel ET-3), Pyridin-Derivate (JP 2004-200162), Phenanthroline, vor allem 1,10-Phenanthrolinderivate, wie z.B. BCP und Bphen, auch mehrere über Biphenyl oder andere aromatische Gruppen verbundene Phenanthroline (US-2007-0252517 A1) oder mit Anthracen verbundene Phenanthroline (US 2007-0122656 A1, vgl. Formeln ET-4 und ET-5).

| | |
|---|---|
| 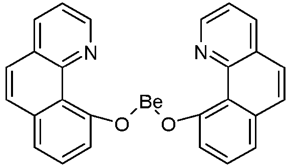 | 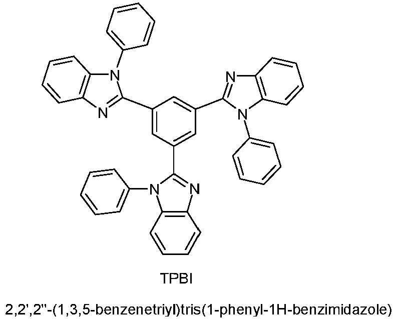 |
| Formel ET-1 | Formel ET-2 |
| 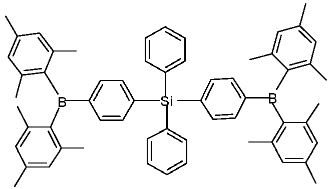 | 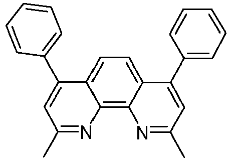 |
| Formel ET-3 | Formel ET-4 |
| 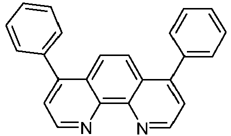 | |
| Formel ET-5 | |

Ebenfalls als organische funktionale Materialien (FM1, FM2) geeignet sind heterozyklische organische Verbindungen wie z.B. Thiopyrandioxide, Oxazole, Triazole, Imidazole oder Oxadiazole. Beispiele für die Verwendung von Fünfringen mit N wie z.B. Oxazole, vorzugsweise 1,3,4-Oxadiazole, beispielsweise Verbindungen gemäß Formeln ET-6, ET-7, ET-8 und ET-9, die unter anderem in US 2007/0273272 A1 dargelegt sind; Thiazole, Oxadiazole, Thiadiazole, Triazole, u.a. siehe US 2008/0102311 A1 und Y.A. Levin, M.S. Skorobogatova, Khimiya Geterotsiklicheskikh Soedinenii 1967 (2), 339-341, vorzugsweise Verbindungen gemäß Formel ET-10, Silacyclopentadien-Derivate. Bevorzugte Verbindungen sind folgende gemäß den Formeln (ET-6) bis (ET-10):

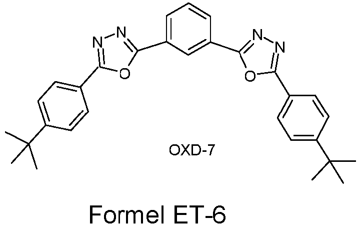

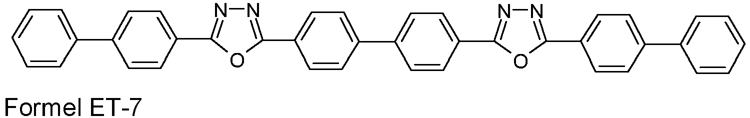

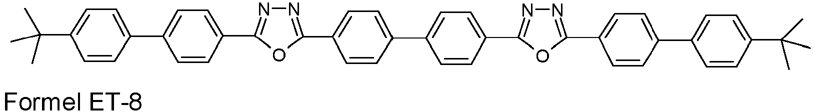

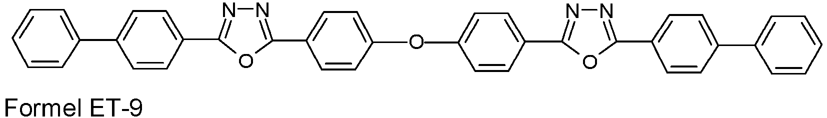

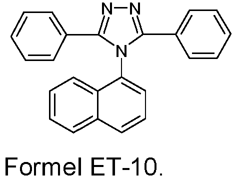

Auch organische Verbindungen wie Derivate von Fluorenon, Fluorenylidenmethan, Perylentetrakohlensäure, Anthrachinondimethan, Diphenochinon, Anthron und Anthrachinondiethylendiamin können als organische funktionale Materialien (FM1, FM2) eingesetzt werden.

Bevorzugt als organische funktionale Materialien (FM1, FM2) sind 2,9,10-substituierte Anthracene (mit 1- oder 2-Naphthyl und 4- oder 3-Biphenyl) oder Moleküle, die zwei Anthraceneinheiten enthalten (US2008/0193796 A1, vgl. Formel ET-11). Sehr vorteilhaft ist auch die Verbindung von 9,10-substituierten Anthracen-Einheiten mit Benzimidazol-Derivaten (US 2006 147747 A und EP 1551206 A1, vgl. Formeln ET-12 und ET-13).

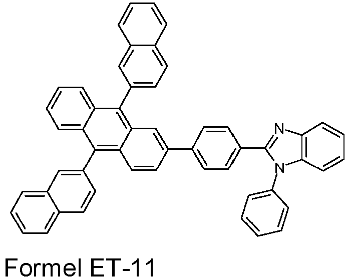

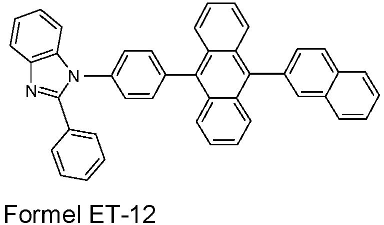

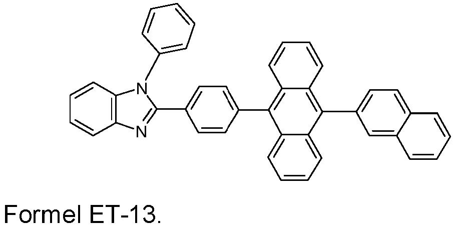

Vorzugsweise führen die Verbindungen, die die Elektroneninjektions- und/oder Elektronentransporteigenschaften erzeugen können, zu einem LUMO von weniger als -2,3 eV, bevorzugt von weniger als -2,5 eV (gegen Vakuumlevel), besonders bevorzugt von weniger als -2,7 eV.

Die zur Herstellung der vorliegenden Mischungen eingesetzten funktionalen Materialien (FM1, FM2) können Emitter umfassen. Der Begriff Emitter bezeichnet ein Material, welches, nach einer Anregung, die durch Übertragung jeder Art von Energie erfolgen kann, einen strahlungsbehafteten Übergang unter Emission von Licht in einen Grundzustand erlaubt. Im Allgemeinen sind zwei Klassen von Emittern bekannt, fluoreszierende und phosphoreszierende Emitter. Der Begriff fluoreszierender Emitter bezeichnet Materialien oder Verbindungen, bei welchen ein strahlungsbehafteter Übergang von einem angeregten Singulettzustand in den Grundzustand erfolgt. Der Begriff phosphoreszierender Emitter bezeichnet vorzugsweise lumineszierende Materialien oder Verbindungen, die Übergangsmetalle umfassen.

Emitter werden häufig auch als Dotanden bezeichnet, falls die Dotanden die zuvor dargelegten Eigenschaften in einem System hervorrufen. Unter einem Dotanden wird in einem System enthaltend ein Matrixmaterial und einen Dotanden diejenige Komponente verstanden, deren Anteil in der Mischung der kleinere ist. Entsprechend wird unter einem Matrixmaterial in einem System enthaltend ein Matrixmaterial und einen Dotanden diejenige Komponente verstanden, deren Anteil in der Mischung der größere ist. Unter dem Begriff phosphoreszierende Emitter können demgemäß beispielsweise auch phosphoreszierende Dotanden verstanden werden.

Verbindungen als organische funktionale Materialien (FM1, FM2), welche Licht emittieren können, umfassen unter anderem fluoreszierende Emitter und phosphoreszierende Emitter. Hierzu gehören unter anderem Verbindungen mit Stilben-, Stilbenamin-, Styrylamin-, Coumarin-, Rubren-, Rhodamin-, Thiazol-, Thiadiazol-, Cyanin-, Thiophen-, Paraphenylen-, Perylen-, Phatolocyanin-, Porphyrin-, Keton-, Chinolin-, Imin-, Anthracen- und/oder Pyren-Strukturen. Besonders bevorzugt sind Verbindungen als organische funktionale Materialien (FM1, FM2), die auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen als organische funktionale Materialien (FM1, FM2), welche Schweratome mit einer Ordnungszahl von mehr als 36 enthalten. Bevorzugt sind Verbindungen, welche d- oder f-Übergangsmetalle enthalten, die die o.g. Bedingung erfüllen. Besonders bevorzugt sind hier entsprechende Verbindungen als organische funktionale Materialien (FM1, FM2), welche Elemente der Gruppe 6 bis 10, bevorzugt 8 bis 10 (Mo, W, Re, Cu, Ag, Au, Zn, Ru, Os, Rh, Ir, Pd, Pt, bevorzugt Ru, Os, Rh, Ir, Pd, Pt) enthalten. Als funktionale Materialien (FM1, FM2) kommen hier z.B. verschiedene Komplexe in Frage, wie sie z.B. in der WO 02/068435 A1, der WO 02/081488 A1, der EP 1239526 A2 und der WO 04/026886 A2 beschrieben werden.

Nachfolgend werden beispielhaft bevorzugte Verbindungen als organische funktionale Materialien (FM1, FM2) dargelegt, die als fluoreszierende Emitter dienen können. Bevorzugte fluoreszierende Emitter als organische funktionale Materialien (FM1, FM2) sind ausgewählt aus der Klasse der Monostyrylamine, der Distyrylamine, der Tristyrylamine, der Tetrastyrylamine, der Styrylphosphine, der Styrylether und der Arylamine.

Unter einem Monostyrylamin wird eine Verbindung verstanden, die eine substituierte oder unsubstituierte Styrylgruppe und mindestens ein, bevorzugt aromatisches, Amin enthält. Unter einem Distyrylamin wird eine Verbindung verstanden, die zwei substituierte oder unsubstituierte Styrylgruppen und mindestens ein, bevorzugt aromatisches, Amin enthält. Unter einem Tristyrylamin wird eine Verbindung verstanden, die drei substituierte oder unsubstituierte Styrylgruppen und mindestens ein, bevorzugt aromatisches, Amin enthält. Unter einem Tetrastyrylamin wird eine Verbindung verstanden, die vier substituierte oder unsubstituierte Styrylgruppen und mindestens ein, bevorzugt aromatisches, Amin enthält. Die Styrylgruppen sind besonders bevorzugt Stilbene, die auch noch weiter substituiert sein können. Entsprechende Phosphine und Ether sind in Analogie zu den Aminen definiert. Unter einem Arylamin bzw. einem aromatischen Amin im Sinne der vorliegenden Anmeldung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, vorzugsweise mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden sind, vorzugsweise in 2,6- oder 9,10-Position. Aromatische Pyrenamine, Pyrendiamine, Chrysenamine und Chrysendiamine sind analog dazu definiert, wobei die Diarylaminogruppen am Pyren vorzugsweise in 1-Position bzw. in 1,6-Position gebunden sind.

Weitere bevorzugte fluoreszierende Emitter als organische funktionale Materialien (FM1, FM2) sind ausgewählt aus Indenofluorenaminen bzw. - diaminen, die unter anderem im Dokument WO 06/122630 dargelegt sind; Benzoindenofluorenaminen bzw. -diaminen, die unter anderem im Dokument WO 2008/006449 dargelegt sind; und Dibenzoindenofluorenaminen bzw. -diaminen, die unter anderem im Dokument WO 2007/140847 dargelegt sind.

Beispiele für Verbindungen, die als fluoreszierende Emitter und die als organische funktionale Materialien (FM1, FM2) eingesetzt werden können, aus der Klasse der Styrylamine sind substituierte oder unsubstituierte Tristilbenamine oder die Dotanden, die in der WO 06/000388, der WO 06/058737, der WO 06/000389, der WO 07/065549 und der WO 07/115610 beschrieben sind. Distyrylbenzol- und Distyrylbiphenyl-Derivate sind beschrieben in der US 5121029. Weitere Styrylamine sind in der US 2007/0122656 A1 zu finden.

Besonders bevorzugte Styrylamin-Verbindungen als organische funktionale Materialien (FM1, FM2) sind die in US 7250532 B2 beschriebene Verbindung der Formel EM-1 und die in DE 10 2005 058557 A1 dargelegten Verbindung der Formel EM-2:

| | |
|---|---|
| 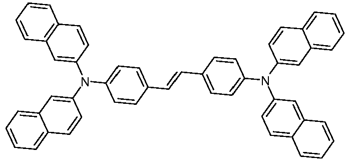 | 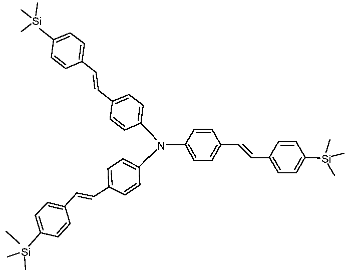 |
| Formel EM-1 | Formel EM-2 |

Besonders bevorzugte Triarylamin-Verbindungen beziehungsweise -Gruppen oder -Strukturelemente als organische funktionale Materialien (FM1, FM2) sind die in den Druckschriften CN 1583691 A, JP 08/053397 A und US 6251531 B1, EP 1957606 A1, US 2008/0113101 A1, US 2006/210830 A, WO 08/006449 und DE 102008035413 dargelegten Verbindungen der Formeln EM-3 bis EM-15 und deren Derivate:

| | |
|---|---|
| 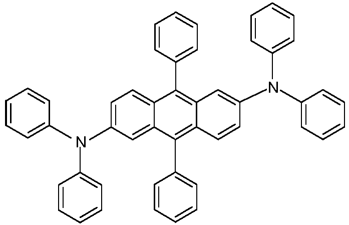 | 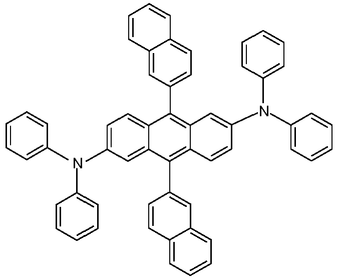 |
| Formel EM-3 | Formel EM-4 |
| 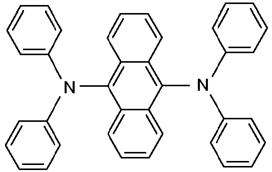 | 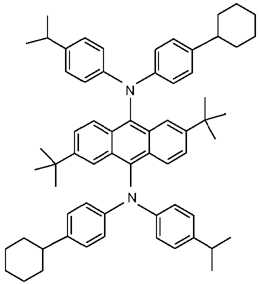 |
| Formel EM-5 | Formel EM-6 |
| 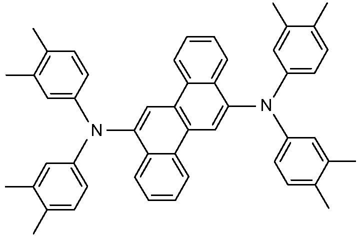 | 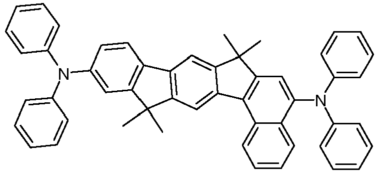 |
| Formel EM-7 | Formel EM-8 |
| 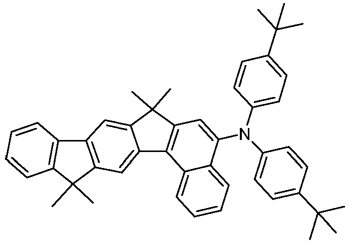 | 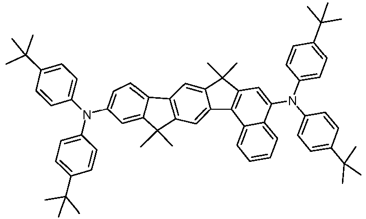 |
| Formel EM-9 | Formel EM-10 |
| 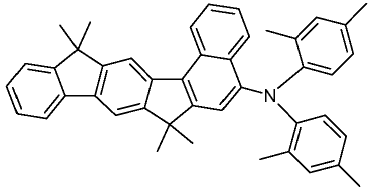 | 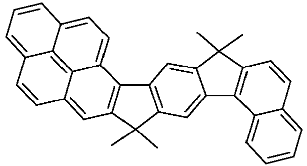 |
| Formel EM-11 | Formel EM-12 |
| 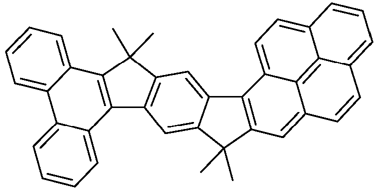 | 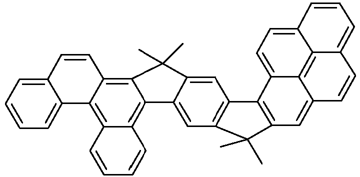 |
| Formel EM-13 | Formel EM-14 |
| 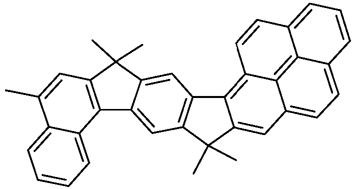 | |
| Formel EM-15 | |

Weitere bevorzugte Verbindungen, die als fluoreszierenden Emitter und die als organische funktionale Materialien (FM1, FM2) eingesetzt werden können, sind ausgewählt aus Derivaten von Naphthalin, Anthracen, Tetracen, Benzanthracen, Benzphenanthren (DE 10 2009 005746), Fluoren, Fluoranthen, Periflanthen, Indenoperylen, Phenanthren, Perylen (US 2007/0252517 A1), Pyren, Chrysen, Decacyclen, Coronen, Tetraphenylcyclopentadien, Pentaphenylcyclopentadien, Fluoren, Spirofluoren, Rubren, Cumarin (US 4769292, US 6020078, US 2007/0252517 A1), Pyran, Oxazol, Benzoxazol, Benzothiazol, Benzimidazol, Pyrazin, Zimtsäureestern, Diketopyrrolopyrrol, Acridon und Chinacridon (US 2007/0252517 A1).

Von den Anthracenverbindungen sind besonders bevorzugt in 9,10-Position substituierte Anthracene wie z.B. 9,10-Diphenylanthracen und 9,10-Bis(phenylethynyl)anthracen. Auch 1,4-Bis(9'-ethynylanthracenyl)-benzol ist ein bevorzugter Dotand, der als organisches funktionales Material (FM1, FM2) eingesetzt werden kann.

Ebenfalls bevorzugt sind Derivate von Rubren, Cumarin, Rhodamin, Chinacridon als organische funktionale Materialien (FM1, FM2) wie z.B. DMQA (= N,N'-dimethylchinacridon), Dicyano-methylenpyran wie z.B. DCM (= 4-(dicyanoethylen)-6-(4-dimethylamino-styryl-2-methyl)-4H-pyran), Thiopyran, Polymethin, Pyrylium- und Thiapyryliumsalzen, Periflanthen und Indenoperylen.

Blaue Fluoreszenzemitter als organische funktionale Materialien (FM1, FM2) sind vorzugsweise Polyaromaten wie z.B. 9,10-Di(2-naphthylanthracen) und andere Anthracen-Derivate, Derivate von Tetracen, Xanthen, Perylen wie z.B. 2,5,8,11-Tetra-t-butyl-perylen, Phenylen, z.B. 4,4'-(Bis(9-ethyl-3-carbazovinylen)-1,1'-biphenyl, Fluoren, Fluoranthen, Arylpyrene (US 2006/0222886 A1), Arylenvinylene (US 5121029, US 5130603), Bis(azinyl)imin-Bor-Verbindungen (US 2007/0092753 A1), Bis(azinyl)methenverbindungen und Carbostyryl-Verbindungen.

Weitere bevorzugte blaue Fluoreszenzemitter als organische funktionale Materialien (FM1, FM2) sind in C.H. Chen et al.: "Recent developments in organic electroluminescent materials" Macromol. Symp. 125, (1997) 1-48 und "Recent progress of molecular organic electroluminescent materials and devices" Mat. Sci. and Eng. R, 39 (2002), 143-222 beschrieben. Weitere bevorzugte blau fluoreszierende Emitter als organische funktionale Materialien (FM1, FM2) sind die in der DE 102008035413 offenbarten Kohlenwasserstoffe. Besonders bevorzugt als organische funktionale Materialien (FM1, FM2) sind ferner, die in WO 2014/111269 dargelegten Verbindungen, insbesondere Verbindungen mit einem Bis-Indenofluoren-Grundgerüst.

Nachfolgend werden beispielhaft bevorzugte Verbindungen als organische funktionale Materialien (FM1, FM2) dargelegt, die als phosphoreszierende Emitter dienen können.

Unter Phosphoreszenz im Sinne dieser Erfindung wird die Lumineszenz aus einem angeregten Zustand mit höherer Spinmultiplizität verstanden, also einem Spinzustand > 1, insbesondere aus einem angeregten Triplettzustand. Im Sinne dieser Anmeldung sollen alle lumineszierenden Komplexe mit Übergangsmetallen oder Lanthaniden, insbesondere alle Iridium-, Platin- und Kupferkomplexe als phosphoreszierende Verbindungen angesehen werden.

Als phosphoreszierende Verbindungen (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten, insbesondere ein Metall mit dieser Ordnungszahl. Bevorzugt werden als Phosphoreszenzemitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium oder Platin enthalten.

Beispiele der oben beschriebenen Emitter als organische funktionale Materialien (FM1, FM2) können den Anmeldungen WO 00/70655, WO 2001/41512, WO 2002/02714, WO 2002/15645, EP 1191613, EP 1191612, EP 1191614, WO 05/033244, WO 05/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/032626, WO 2011/066898, WO 2011/157339, WO 2012/007086, WO 2014/008982, WO 2014/023377, WO 2014/094961, WO 2014/094960, WO 2015/036074, WO 2015/104045, WO 2015/117718, WO 2016/015815, WO 2016/124304, WO 2017/032439, WO 2018/011186, WO 2018/001990, WO 2018/019687, WO 2018/019688, WO 2018/041769, WO 2018/054798, WO 2018/069196, WO 2018/069197, WO 2018/069273, WO 2018/178001, WO 2018/177981, WO 2019/020538, WO 2019/115423, WO 2019/158453 und WO 2019/179909 entnommen werden. Generell eignen sich alle phosphoreszierenden Komplexe, wie sie gemäß dem Stand der Technik für phosphoreszierende Elektrolumineszenzvorrichtungen verwendet werden und wie sie dem Fachmann auf dem Gebiet der organischen Elektrolumineszenz bekannt sind, als organische funktionale Materialien (FM1, FM2).

Bevorzugte Liganden für phosphoreszierende Komplexe als organische funktionale Materialien (FM1, FM2) sind 2-Phenylpyridin-Derivate, 7,8-Benzochinolin-Derivate, 2-(2-Thienyl)pyridin-Derivate, 2-(1-Naphthyl)pyridin-Derivate, 1-Phenylisochinolin-Derivate, 3-Phenylisochinolin-Derivate oder 2-Phenyl-chinolin-Derivate. Alle diese Verbindungen können substituiert sein, z.B. für Blau mit Fluor-, Cyano- und/oder Trifluormethylsubstituenten. Auxiliäre Liganden sind vorzugsweise Acetylacetonat oder Picolinsäure.

Insbesondere sind Komplexe von Pt oder Pd mit tetradentaten Liganden gemäß Formel EM-16 als Emitter und als organische funktionale Materialien (FM1, FM2) geeignet.

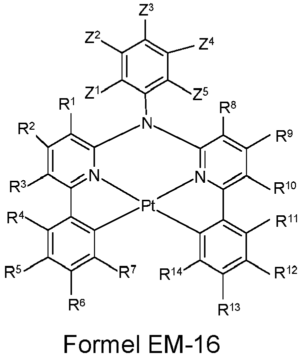

Die Verbindungen gemäß Formel EM-16 sind detaillierter in US 2007/0087219 A1 dargelegt, wobei zur Erläuterung der Substituenten und Indices in obiger Formel auf diese Druckschrift zu Offenbarungszwecken verwiesen wird.

Weiterhin als organische funktionale Materialien (FM1, FM2) geeignet sind Pt-Porphyrinkomplexe mit vergrößertem Ringsystem (US 2009/0061681 A1) und Ir-Komplexe, z.B. 2,3,7,8,12,13,17,18-Octaethyl-21H, 23H-porphyrin-Pt(II), Tetraphenyl-Pt(II)-tetrabenzoporphyrin (US 2009/0061681 A1), *cis*-Bis(2-phenylpyridinato-N, C²')Pt(II), cis-Bis(2-(2'-thienyl)pyridinato-N,C³')Pt(II), *cis*-Bis-(2-(2'-thienyl)chinolinato-N, C⁵')Pt(II), (2-(4,6-Difluorophenyl)pyridinato-N, C²')Pt(II)(acetylacetonat), oder Tris(2-phenylpyridinato-N,C²')Ir(III) (= Ir(ppy)₃, grün), Bis(2-phenyl-pyridinato-N,C²)Ir(III)(acetylacetonat) (= Ir(ppy)₂acetylacetonat, grün, US 2001/0053462 A1, Baldo, Thompson et al. Nature 403, (2000), 750-753), Bis(1-phenylisochinolinato-N, C²')(2-phenylpyridinato-N, C²')Iridium(III), Bis(2-phenylpyridinato-N, C²')(1-phenylisochinolinato-N, C²')Iridium(III), Bis(2-(2'-benzothienyl)pyridinato-N, C³')Iridium(III)(acetylacetonat), Bis(2-(4',6'-difluorophenyl)pyridinato-N, C²')Iridium(III)(piccolinat) (Flrpic, blau), Bis(2-(4',6'-difluorophenyl)pyridinato-N,C²')Ir(III)(tetrakis(1-pyrazolyl)borat), Tris(2-(biphenyl-3-yl)-4-tertbutylpyridin)iridium(III), (ppz)₂Ir(5phdpym) (US 2009/0061681 A1), (45ooppz)₂Ir(5phdpym) (US 2009/0061681 A1), Derivate von 2-Phenylpyridin-Ir-Komplexen, wie z.B. PQIr (= Iridium(III)-bis(2-phenyl-quinolyl-N, C²')acetylacetonat), Tris(2-phenylisochinolinato-N,C)Ir(III) (rot), Bis(2-(2'-benzo[4,5-a]thienyl)pyridinato-N,C³)Ir(acetylacetonat) ( [Btp₂Ir(acac)], rot, Adachi et al. Appl. Phys. Lett. 78 (2001), 1622-1624). Besonders geeignet als organische funktionale Materialien (FM1, FM2) sind weiterhin, die in WO 2016/124304 dargelegten Komplexe.

Ebenfalls als organische funktionale Materialien (FM1, FM2) geeignet sind Komplexe von trivalenten Lanthaniden wie z.B. Tb³⁺ und Eu³⁺ (J. Kido et al. Appl. Phys. Lett. 65 (1994), 2124, Kido et al. Chem. Lett. 657, 1990, US 2007/0252517 A1) oder phosphoreszente Komplexe von Pt(II), Ir(I), Rh(I) mit Maleonitrildithiolat (Johnson et al., JACS 105, 1983, 1795), Re(I)-Tricarbonyl-diimin-Komplexe (Wrighton, JACS 96, 1974, 998 u.a.), Os(II)-Komplexe mit Cyanoliganden und Bipyridyl- oder Phenanthrolin-Liganden (Ma et al., Synth. Metals 94, 1998, 245).

Weitere als organische funktionale Materialien (FM1, FM2) geeignete phosphoreszierende Emitter mit tridentaten Liganden werden beschrieben in der US 6824895 und der US 10/729238. Rot emittierende phosphoreszente Komplexe findet man in der US 6835469 und der US 6830828.

Besonders bevorzugte Verbindungen, die als phosphoreszierende Dotanden Verwendung finden und die als organische funktionale Materialien (FM1, FM2) geeignet sind, sind unter anderem die in US 2001/0053462 A1 und Inorg. Chem. 2001, 40(7), 1704-1711, JACS 2001, 123(18), 4304-4312 beschrieben Verbindungen gemäß Formel EM-17 sowie Derivate hiervon.

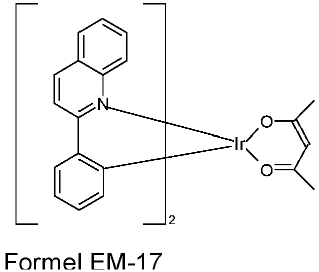

Derivate sind beschrieben in der US 7378162 B2, der US 6835469 B2 und der JP 2003/253145 A.

Ferner können die in US 7238437 B2, US 2009/008607 A1 und EP 1348711 beschriebenen Verbindungen gemäß Formel EM-18 bis EM-21 sowie deren Derivate als Emitter und als organisches funktionales Material (FM1, FM2) eingesetzt werden.

| | |
|---|---|
| 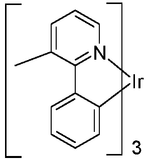 | 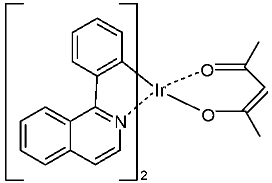 |
| Formel EM-18 | Formel EM-19 |
| 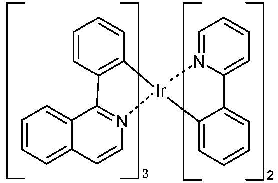 | 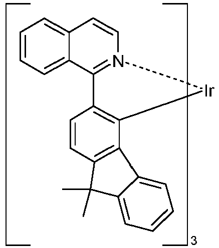 |
| Formel EM-20 | Formel EM-21 |

Ferner können die in der folgenden Tabelle beschriebenen Verbindungen 1 bis 54 sowie deren Derivate als Emitter und als organisches funktionales Material (FM1, FM2) eingesetzt werden:

| | |
|---|---|
| 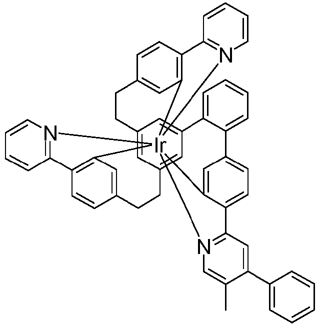 | 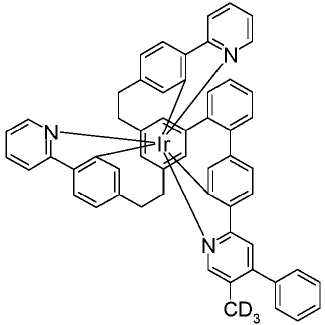 |
| 1 | 2 |
| 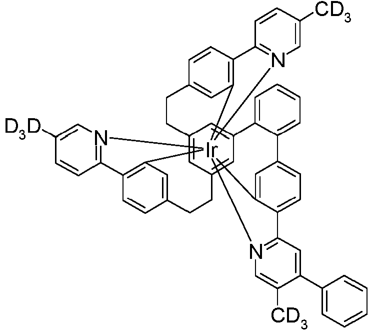 | 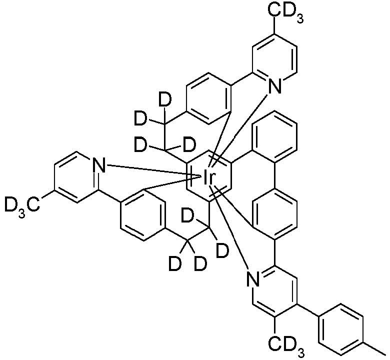 |
| 3 | 4 |
| 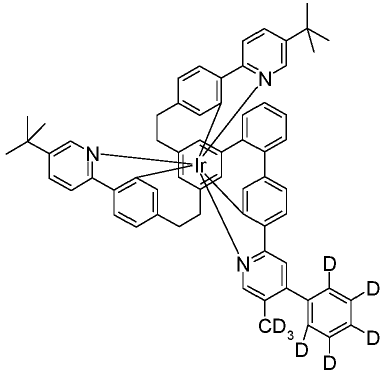 | 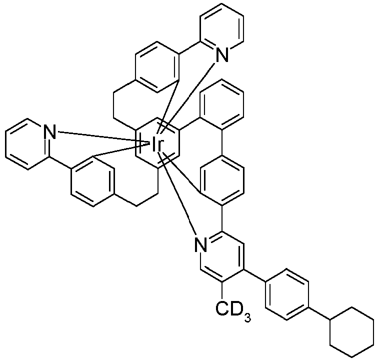 |
| 5 | 6 |
| 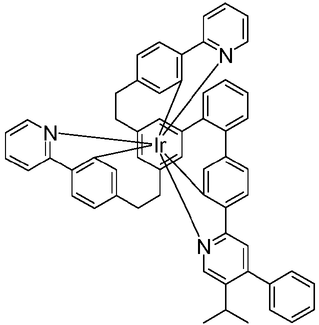 | 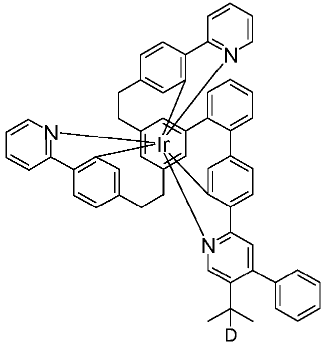 |
| 7 | 8 |
| 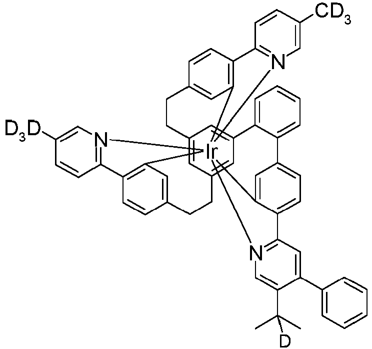 | 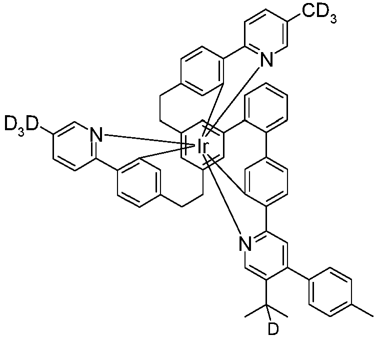 |
| 9 | 10 |
| 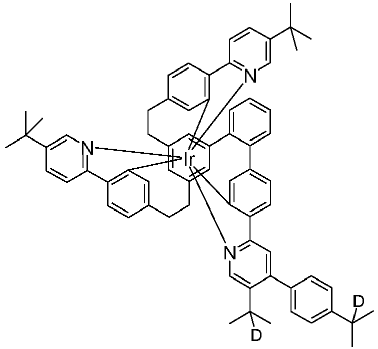 | 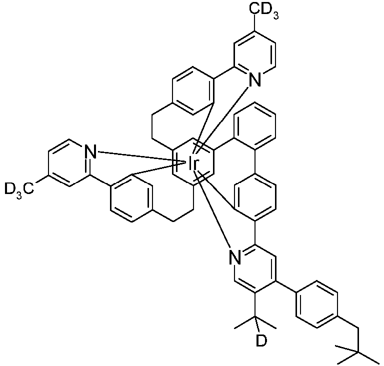 |
| 11 | 12 |
| 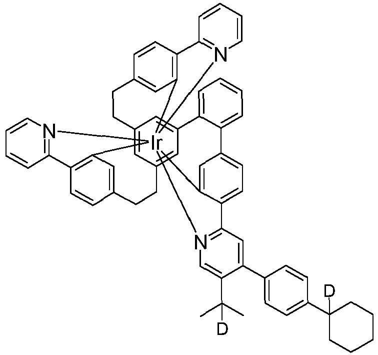 | 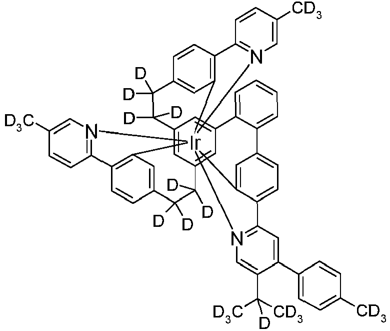 |
| 13 | 14 |
| 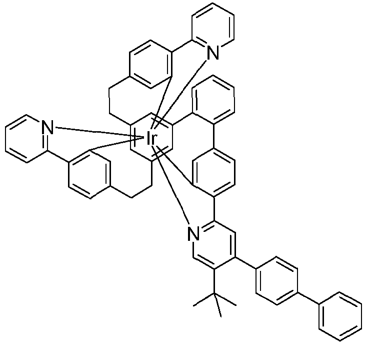 | 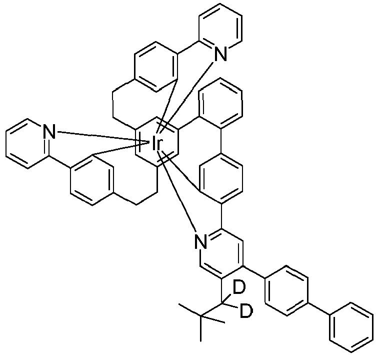 |
| 15 | 16 |
| 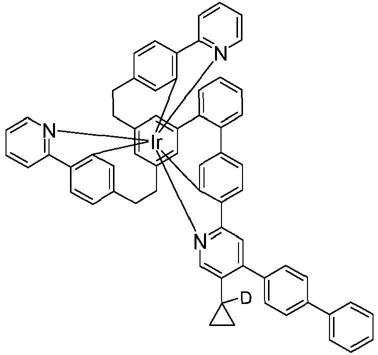 | 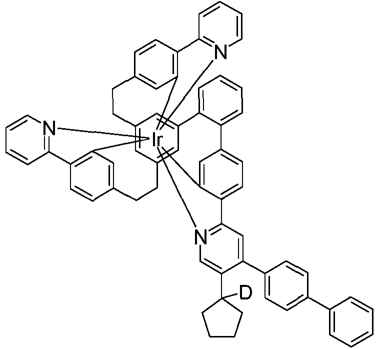 |
| 17 | 18 |
| 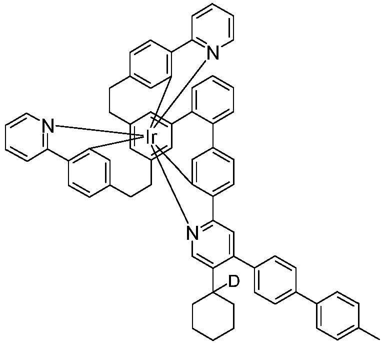 | 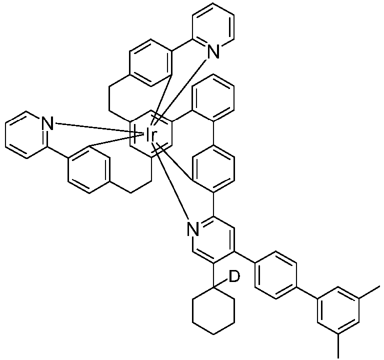 |
| 19 | 20 |
| 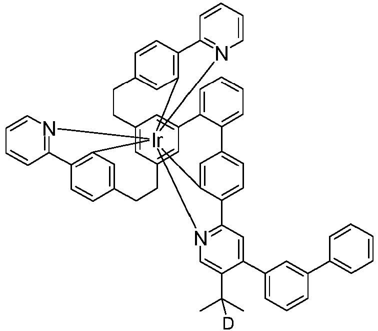 | 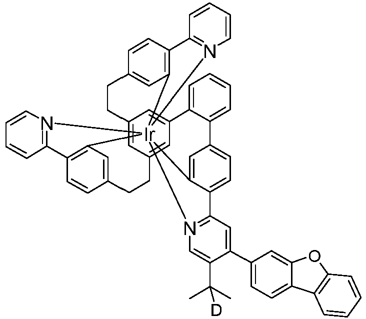 |
| 21 | 22 |
| 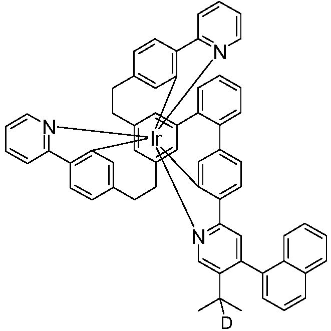 | 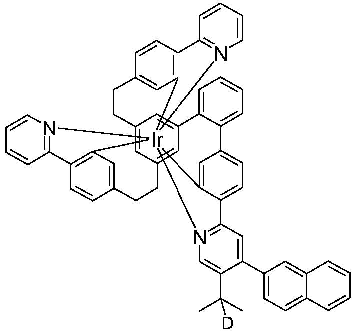 |
| 23 | 24 |
| 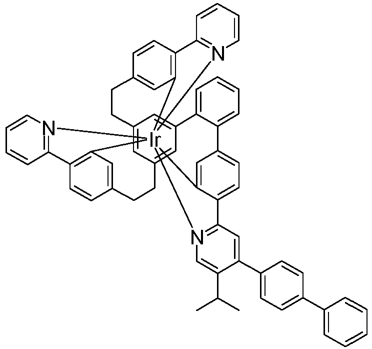 | 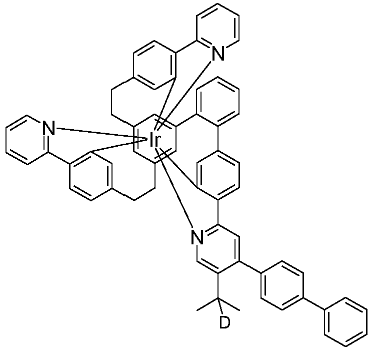 |
| 25 | 26 |
| 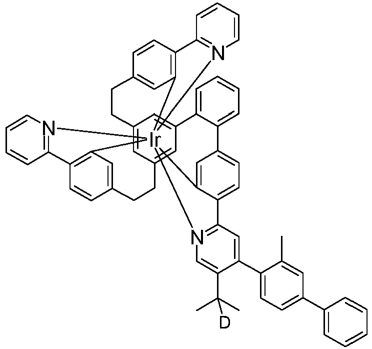 | 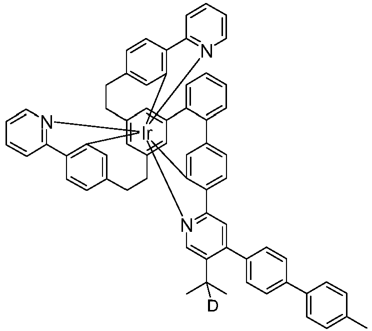 |
| 27 | 28 |
| 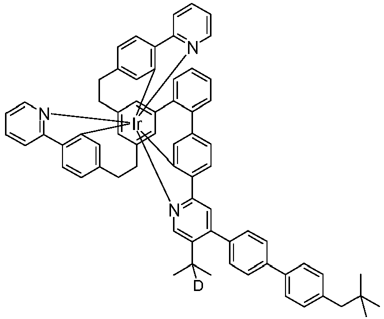 | 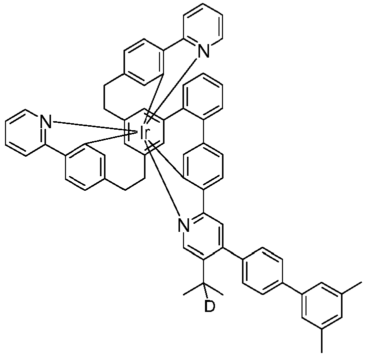 |
| 29 | 30 |
| 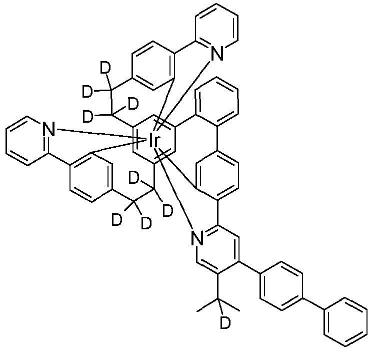 | 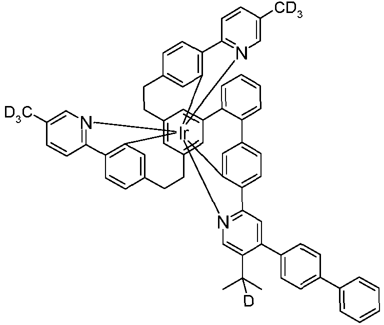 |
| 31 | 32 |
| 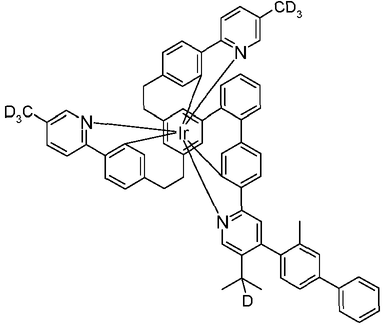 | 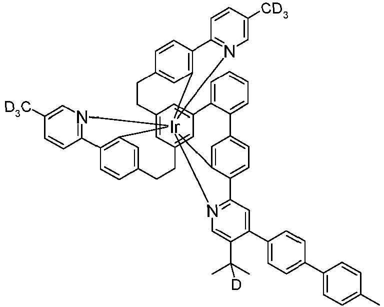 |
| 33 | 34 |
| 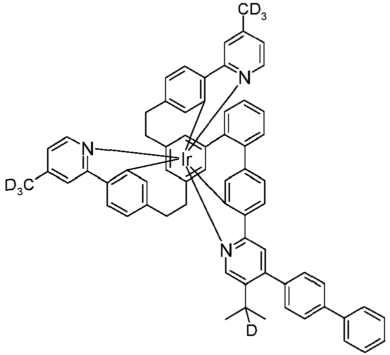 | 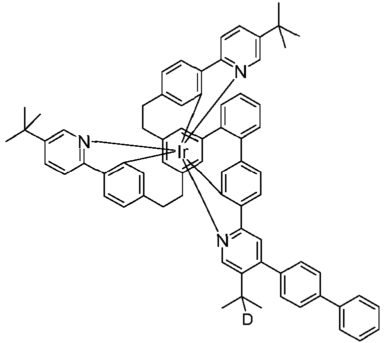 |
| 35 | 36 |
| 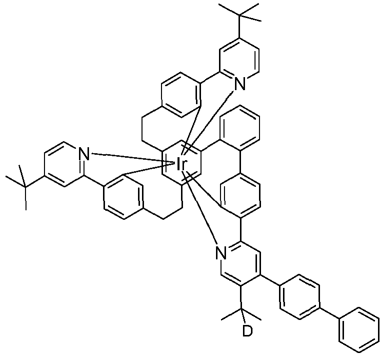 | 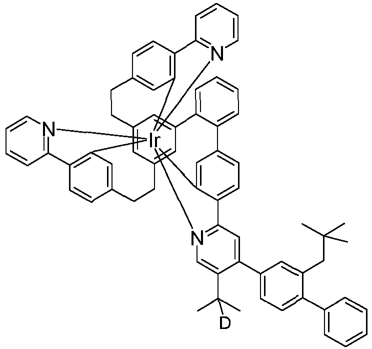 |
| 37 | 38 |
| 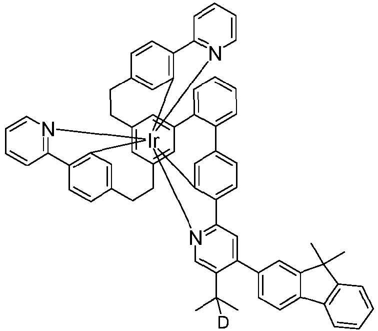 | 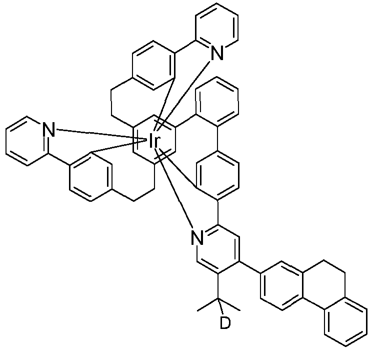 |
| 39 | 40 |
| 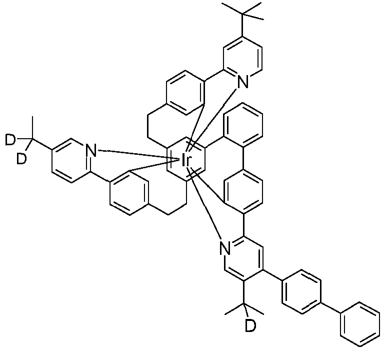 | 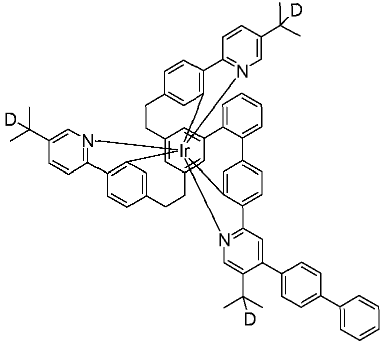 |
| 41 | 42 |
| 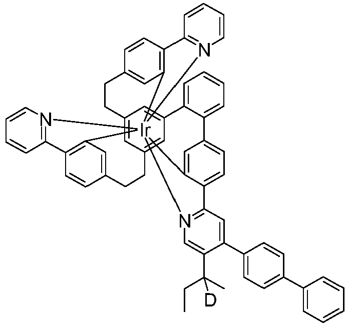 | 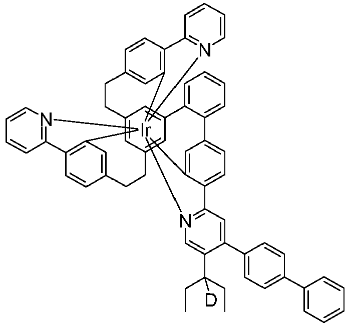 |
| 43 | 44 |
| 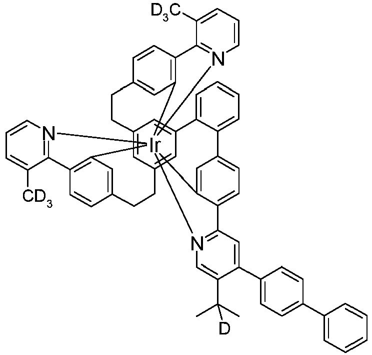 | 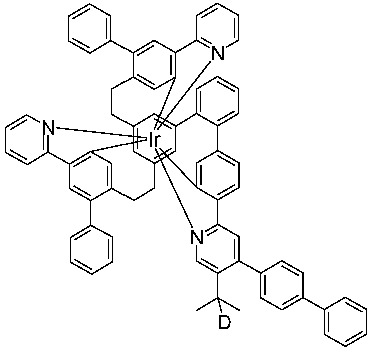 |
| 45 | 46 |
| 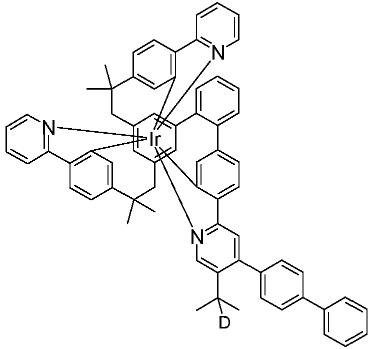 | 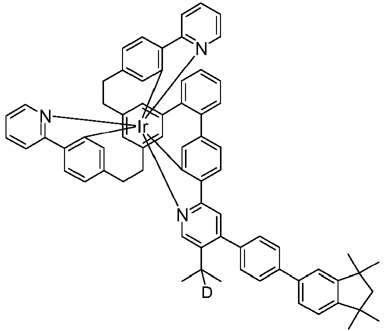 |
| 47 | 48 |
| 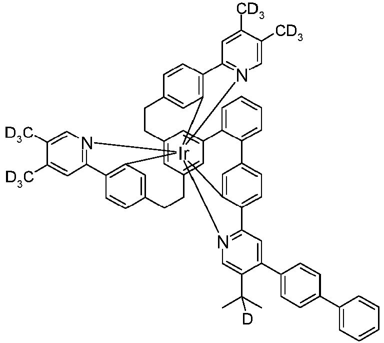 | 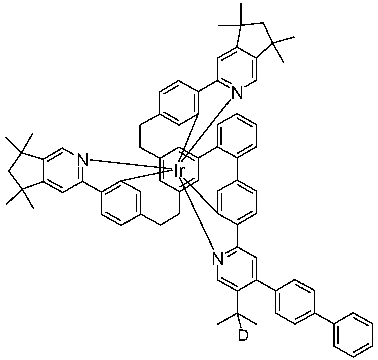 |
| 49 | 50 |
| 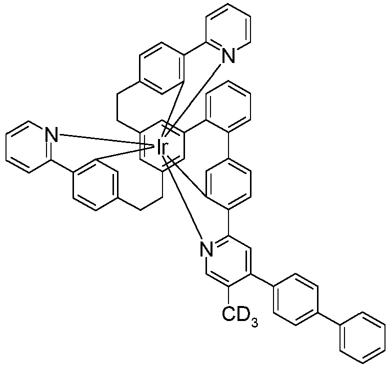 | 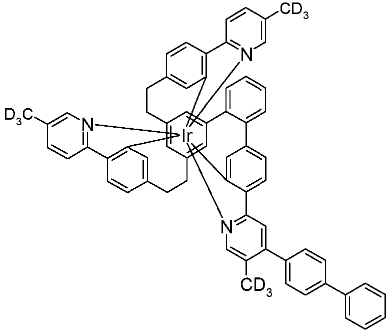 |
| 51 | 52 |
| 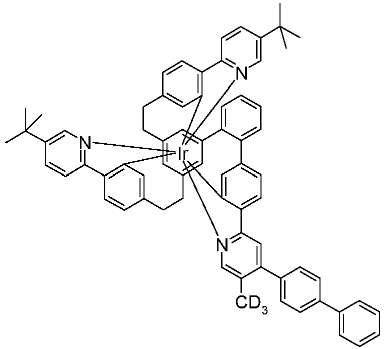 | 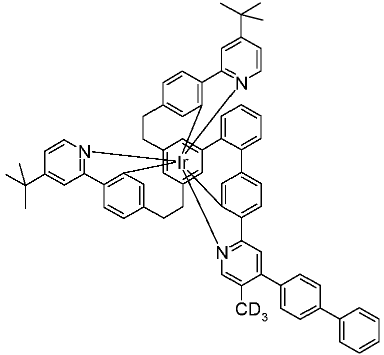 |
| 53 | 54 |

Quantum Dots können ebenfalls als Emitter und als organische funktionale Materialien (FM1, FM2) eingesetzt werden, wobei diese Materialien ausführlich in WO 2011/076314 A1 offenbart werden.

In einer bevorzugten Ausgestaltung wird durch eine geeignete Kombination von Verbindungen vorzugsweise ein Hyperfluoreszenz- und/oder Hyperphosphoreszenz-System gebildet. Derartige Hyperfluoreszenz- und/oder Hyperphosphoreszenz-Systeme bilden eine bevorzugte Ausführungsform erfindungsgemäß einzusetzender funktionaler Materialien (FM1, FM2).

Vorzugsweise wird hierzu ein fluoreszierender Emitter in Kombination mit einem oder mehreren phosphoreszierenden Materialien (Triplettemitter) und/oder einer Verbindung eingesetzt, die ein TADF-Hostmaterial (thermally activated delayed fluorescence) darstellt.

In WO 2015/091716 A1 und in WO 2016/193243 A1 werden OLEDs offenbart, die in der Emissionsschicht sowohl eine phosphoreszierende Verbindung als auch einen fluoreszierenden Emitter enthalten, wobei die Energie von der phosphoreszierenden Verbindung auf den fluoreszierenden Emitter übertragen wird (Hyperphosphoreszenz). Die phosphoreszierende Verbindung verhält sich in diesem Zusammenhang demnach wie ein Host-Material. Wie der Fachmann weiß, haben Hostmaterialien höhere Singulett und Triplett-Energien im Vergleich zu dem Emittern, damit die Energie des Host-Materials auch möglichst optimal auf den Emitter übertragen werden. Die im Stand der Technik offenbarten Systeme weisen genau solch eine Energierelation auf.

Ein fluoreszierender Emitter kann vorzugsweise in Kombination mit einem TADF-Hostmaterial und/oder einem TADF-Emitter eingesetzt werden, wie dies zuvor dargelegt ist.

Der als thermisch aktivierte verzögerte Fluoreszenz (TADF = "thermally activated delayed fluorescence") bezeichnete Vorgang wird beispielsweise von B. H. Uoyama et al., Nature 2012, Vol. 492, 234 beschrieben. Um diesen Prozess zu ermöglichen, ist im Emitter ein vergleichsweise kleiner Singulett-Triplett-Abstand ΔE(S₁ - T₁) von zum Beispiel weniger als etwa 2000 cm⁻¹ nötig. Um den an sich spin-verbotenen Übergang T₁ → S₁ zu öffnen, kann neben dem Emitter eine weitere Verbindung in der Matrix vorgesehen werden, die eine starke Spin-Bahn-Kopplung aufweist, sodass über die räumliche Nähe und die damit mögliche Wechselwirkung zwischen den Molekülen ein Inter-System-Crossing ermöglicht wird, oder die Spin-Bahn-Kopplung wird über ein im Emitter enthaltenes Metallatom erzeugt.

Verbindungen, die als Hostmaterialien, insbesondere zusammen mit emittierenden Verbindungen eingesetzt werden, umfassen Materialien verschiedener Stoffklassen.

Hostmaterialien weisen im Allgemeinen größere Bandlücken zwischen HOMO und LUMO auf als die eingesetzten Emittermaterialien. Zusätzlich zeigen bevorzugte Hostmaterialien entweder Eigenschaften eines Loch- oder Elektronentransportmaterials. Weiterhin können Hostmaterialien sowohl Elektronen- als auch Lochtransporteigenschaften aufweisen.

Hostmaterialien werden zum Teil auch als Matrixmaterial bezeichnet, insbesondere falls das Hostmaterial in Kombination mit einem phosphoreszierenden Emitter in einer OLED eingesetzt wird.

In einer bevorzugten Ausgestaltung wird eine geeignete Kombination von Matrixmaterialien oder Matrixmaterialien und Emittermaterialien im erfindungsgemäßen Verfahren eingesetzt. Derartige Materialkombinationen sind eine bevorzugte Ausführungsform erfindungsgemäß einzusetzender funktionaler Materialien (FM1, FM2).

Bevorzugte Host-Materialien oder Co-Host-Materialien als organische funktionale Materialien (FM1, FM2), die insbesondere zusammen mit fluoreszierenden Dotanden eingesetzt werden, sind ausgewählt aus den Klassen der Oligoarylene (z.B. 2,2',7,7'-Tetraphenyl-spirobifluoren gemäß EP 676461 oder Dinaphthylanthracen), insbesondere der Oligoarylene enthaltend kondensierte aromatische Gruppen wie z.B. Anthracen, Benzanthracen, Benzphenanthren (DE 10 2009 005746, WO 09/069566), Phenanthren, Tetracen, Coronen, Chrysen, Fluoren, Spirofluoren, Perylen, Phthaloperylen, Naphthaloperylen, Decacyclen, Rubren, der Oligoarylenvinylene (z.B. DPVBi = 4,4'-Bis(2,2-diphenyl-ethenyl)-1,1'-biphenyl ) oder Spiro-DPVBi gemäß EP 676461), der polypodalen Metallkomplexe (z.B. gemäß WO 04/081017), insbesondere Metallkomplexe von 8-Hydroxychinolin, z.B. AlQ₃ (= Aluminium(III)tris(8-hydroxychinolin)) oder Bis(2-methyl-8-chinolinolato)-4-(phenylphenolino-lato)aluminium, auch mit Imidazol-Chelat (US 2007/0092753 A1) sowie der Chinolin-Metallkomplexe, Aminochinolin-Metallkomplexe, Benzochinolin-Metallkomplexe, der lochleitenden Verbindungen (z.B. gemäß WO 04/058911), der elektronenleitenden Verbindungen, insbesondere Ketone, Phosphinoxide, Sulfoxide, Carbazole, Spiro-Carbazole, Indenocarbazole, etc. (z.B. gemäß der WO 05/084081 und der WO 05/084082), der Atropisomere (z.B. gemäß der WO 06/048268), der Boronsäurederivate (z.B. gemäß der WO 06/117052) oder der Benzanthracene (z.B. gemäß der WO 08/145239).

Besonders bevorzugte Verbindungen, die als Host-Materialien oder Co-Host-Materialien dienen können und die als organische funktionale Materialien (FM1, FM2) geeignet sind, sind ausgewählt aus den Klassen der Oligoarylene, enthaltend Anthracen, Benzanthracen und/oder Pyren oder Atropisomere dieser Verbindungen. Unter einem Oligoarylen im Sinne der vorliegenden Erfindung soll eine Verbindung verstanden werden, in der mindestens drei Aryl- bzw. Arylengruppen aneinander gebunden sind.

Bevorzugte Hostmaterialien als organische funktionale Materialien (FM1, FM2) sind insbesondere ausgewählt aus Verbindungen der Formel (H-100),

Ar⁵-(Ar⁶)ₚ-Ar⁷ (H-100)

wobei Ar⁵, Ar⁶, Ar⁷ bei jedem Auftreten gleich oder verschieden eine Aryl- oder Heteroarylgruppe mit 5 bis 30 aromatischen Ringatomen ist, die gegebenenfalls substituiert sein kann, und p eine ganze Zahl im Bereich von 1 bis 5 darstellt; dabei gilt, dass die Summe der π-Elektronen in Ar⁵, Ar⁶ und Ar⁷ mindestens 30 beträgt, wenn p = 1 ist, und mindestens 36 beträgt, wenn p = 2 ist, und mindestens 42 beträgt, wenn p = 3 ist.

Besonders bevorzugt steht in den Verbindungen der Formel (H-100) die Gruppe Ar⁶ für Anthracen und die Gruppen Ar⁵ und Ar⁷ sind in 9- und 10-Position gebunden, wobei diese Gruppen gegebenenfalls substituiert sein können. Ganz besonders bevorzugt ist mindestens eine der Gruppen Ar⁵ und/oder Ar⁷ eine kondensierte Arylgruppe, ausgewählt aus 1- oder 2-Naphthyl, 2-, 3- oder 9-Phenanthrenyl oder 2-, 3-, 4-, 5-, 6- oder 7-Benzanthracenyl. Anthracen-basierte Verbindungen sind beschrieben in der US 2007/0092753 A1 und der US 2007/0252517 A1, z.B. 2-(4-Methylphenyl)-9,10-di-(2-naphthyl)anthracen, 9-(2-Naphthyl)-10-(1,1'-biphenyl)anthracen und 9,10-Bis[4-(2,2-diphenylethenyl)phenyl]anthracen, 9,10-Diphenylanthracen, 9,10-Bis(phenylethynyl)anthracen und 1,4-Bis(9'-ethynylanthracenyl)benzol. Bevorzugt sind auch Verbindungen mit zwei Anthraceneinheiten (US 2008/0193796 A1), z.B. 10,10'-Bis[1,1',4', 1"]terphenyl-2-yl-9,9'-bisanthracenyl.

Weitere bevorzugte Verbindungen als organische funktionale Materialien (FM1, FM2) sind Derivate von Arylamin, Styrylamin, Fluorescein, Diphenylbutadien, Tetraphenylbutadien, Cyclopentadiene, Tetraphenylcyclopentadien, Pentaphenylcyclopentadien, Cumarin, Oxadiazol, Bisbenzoxazolin, Oxazol, Pyridin, Pyrazin, Imin, Benzothiazol, Benzoxazol, Benzimidazol (US 2007/0092753 A1), z.B. 2,2',2"-(1,3,5-Phenylen)tris[1-phenyl-1H-benzimidazol], Aldazin, Stilben, Styrylarylenderivate, z.B. 9,10-Bis[4-(2,2-diphenylethenyl)phenyl]anthracen und Distyrylarylen-Derivate (US 5121029), Diphenylethylen, Vinylanthracen, Diaminocarbazol, Pyran, Thiopyran, Diketopyrrolopyrrol, Polymethin, Zimtsäureestern und Fluoreszenzfarbstoffen.

Besonders bevorzugt als organische funktionale Materialien (FM1, FM2) sind Derivate von Arylamin und Styrylamin, z.B. TNB (= 4,4'-Bis[N-(1-naphthyl)-N-(2-naphthyl)amino]biphenyl). Metall-Oxinoid-Komplexe wie LiQ oder AlQ₃ können als Co-Hosts verwendet werden und bilden bevorzugt das zweite funktionale Material für die Mischung der organischen funktionalen Materialien (FM1, FM2).

Bevorzugte Verbindungen mit Oligoarylen als Matrixmaterial als organisches funktionales Material (FM1, FM2) sind in US 2003/0027016 A1, US 7326371 B2, US 2006/043858 A, WO 2007/114358, WO 08/145239, JP 3148176 B2, EP 1009044, US 2004/018383, WO 2005/061656 A1, EP 0681019B1, WO 2004/013073A1, US 5077142, WO 2007/065678 und DE 102009005746 dargelegt, wobei besonders bevorzugte Verbindungen durch die Formeln H-102 bis H-108 beschrieben sind.

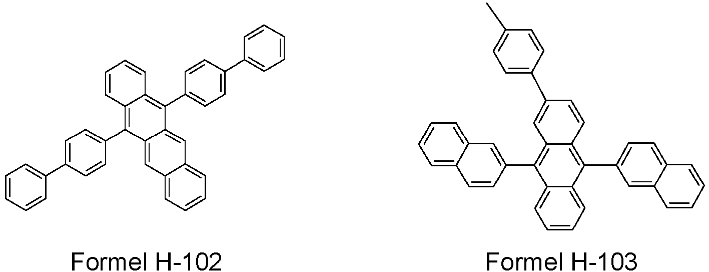

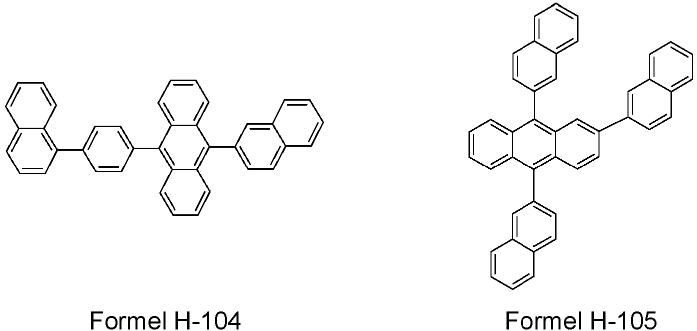

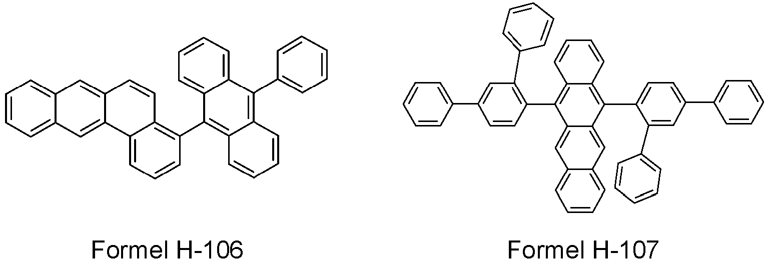

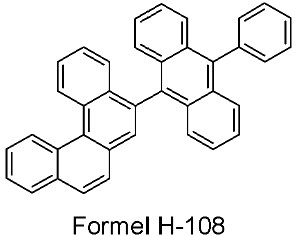

Weiterhin umfassen Verbindungen, die als Host oder Matrix eingesetzt werden können, Materialien, die zusammen mit phosphoreszierenden Emittern eingesetzt werden und in dem erfindungsgemäßen Verfahren eingesetzt werden. Zu diesen Verbindungen als organische funktionale Materialien (FM1, FM2) gehören CBP (N,N-Biscarbazolylbiphenyl), Carbazolderivate (z.B. gemäß WO 05/039246, US 2005/0069729, JP 2004/288381, EP 1205527 oder WO 08/086851), Azacarbazole (z.B. gemäß EP 1617710, EP 1617711, EP 1731584, JP 2005/347160), Ketone (z.B. gemäß WO 04/093207 oder gemäß der DE 102008033943), Phosphinoxide, Sulfoxide und Sulfone (z.B. gemäß WO 05/003253), Oligophenylene, aromatische Amine (z.B. gemäß US 2005/0069729), bipolare Matrixmaterialien (z.B. gemäß WO 07/137725), Silane (z.B. gemäß WO 05/111172), 9,9-Diarylfluorenderivate (z.B. gemäß der DE 102008017591), Azaborole oder Boronester (z.B. gemäß WO 06/117052), Triazin-Derivate (z.B. gemäß der DE 102008036982), Indolocarbazolderivate (z.B. gemäß WO 07/063754 oder WO 08/056746), Indenocarbazolderivate (z.B. gemäß der DE 102009023155 und der DE 102009031021), Diazaphospholderivate (z.B. gemäß der DE 102009022858), Triazol-Derivate, Oxazole und Oxazol-Derivate, ImidazolDerivate, Polyarylalkan-Derivate, Pyrazolin-Derivate, Pyrazolon-Derivate, Distyrylpyrazin-Derivate, Thiopyrandioxid-Derivate, Phenylendiamin-Derivate, tertiäre aromatische Amine, Styrylamine, Amino-substituierte Chalcon-Derivate, Indole, Hydrazon-Derivate, Stilben-Derivate, Silazan-Derivate, aromatische Dimethyliden-Verbindungen, Carbodiimid-Derivate, Metallkomplexe von 8-Hydroxychinolin-Derivaten wie z.B. AlQ₃, die 8-Hydroxychinolin-Komplexe können auch Triarylaminophenol-Liganden enthalten (US 2007/0134514 A1), Metallkomplex-Polysilan-Verbindungen sowie Thiophen-, Benzothiophen- und Dibenzothiophen-Derivate.

Beispiele für bevorzugte Carbazol-Derivate als mindestens ein organisches funktionales Material (FM1, FM2) sind mCP (= 1,3-N,N-dicarbazol-benzol (= 9,9'-(1,3-Phenylen)bis-9H-carbazol)) (Formel H-9), CDBP (= 9,9'-(2,2'-Dimethyl[1,1'-biphenyl]-4,4'-diyl)bis-9H-carbazol), 1,3-Bis(N,N'-dicarbazol)benzol (= 1,3-Bis(carbazol-9-yl)benzol), PVK (Polyvinylcarbazol), 3,5-Di(9H-carbazol-9-yl)biphenyl sowie CMTTP (Formel H10). Besonders bevorzugte Verbindungen als mindestens ein organisches funktionales Material (FM1, FM2) sind in US 2007/0128467 A1 und US 2005/0249976 A1 dargelegt (Formeln H-111 bis H-113).

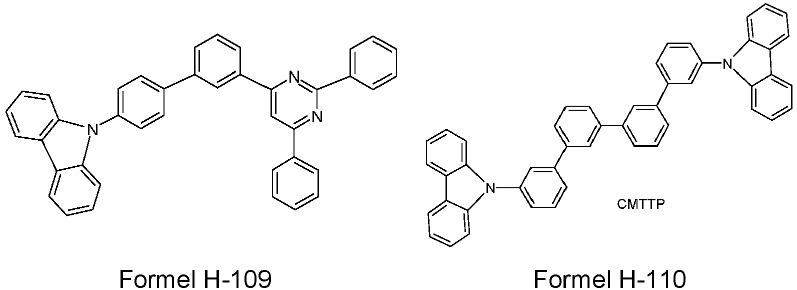

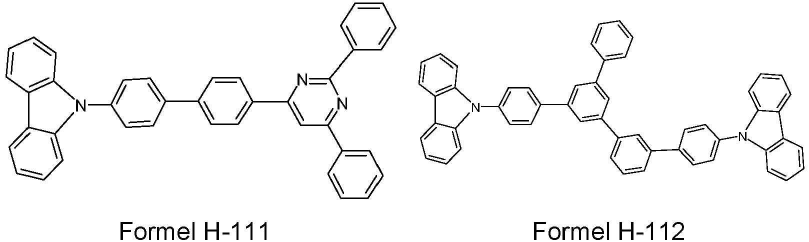

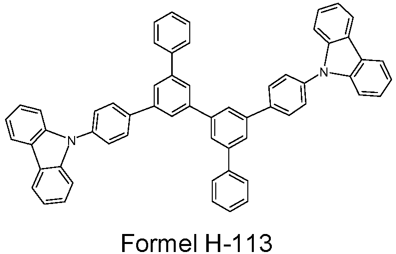

Bevorzugte Si-Tetraaryle als mindestens ein organisches funktionales Material (FM1, FM2) werden z.B. in den Dokumenten US 2004/0209115, US 2004/0209116, US 2007/0087219 A1 und H. Gilman, E.A. Zuech, Chemistry & Industry (London, United Kingdom), 1960, 120 dargelegt. Besonders bevorzugte Si-Tetraaryle werden durch die Formeln H-114 bis H-120 beschrieben.

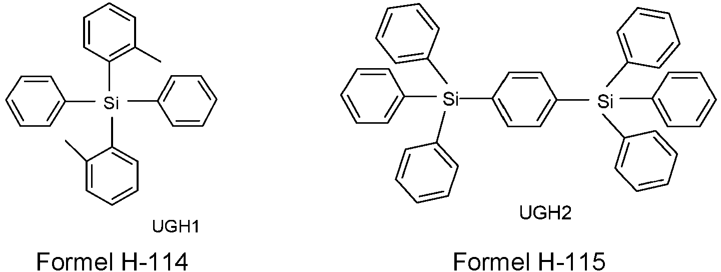

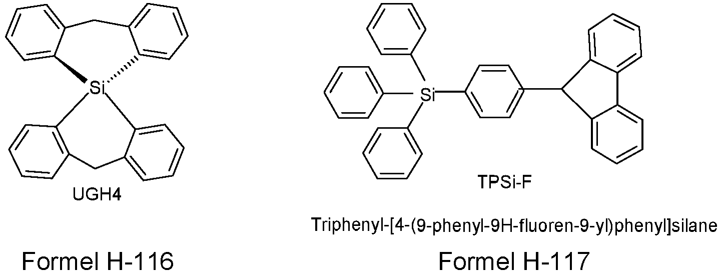

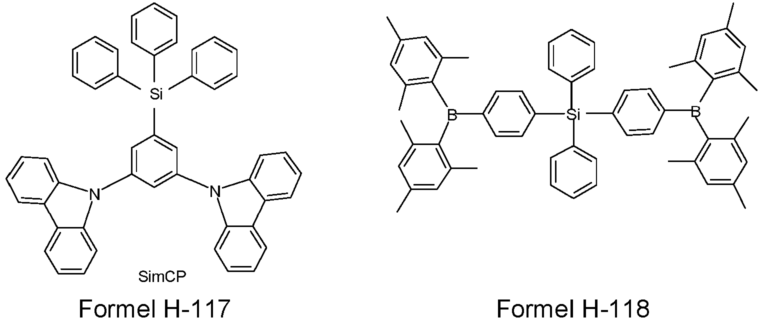

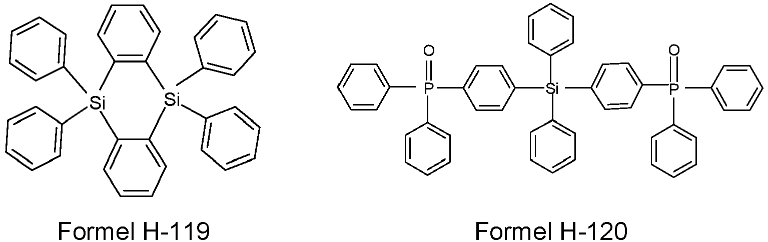

Besonders bevorzugte Verbindungen als Matrixmaterial für phosphoreszierende Dotanden, die zusammen das organische funktionale Material (FM1, FM2) bedeuten, sind unter anderem in DE 102009022858, DE 102009023155, EP 652273 B1, WO 07/063754 und WO 08/056746 dargelegt, wobei besonders bevorzugte Verbindungen durch die Formeln H-121 bis H-124 beschrieben werden.

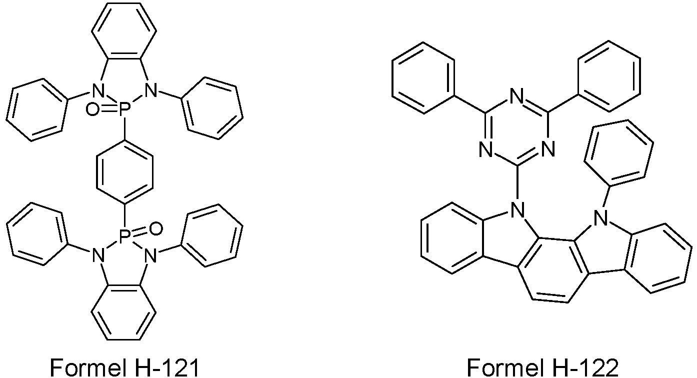

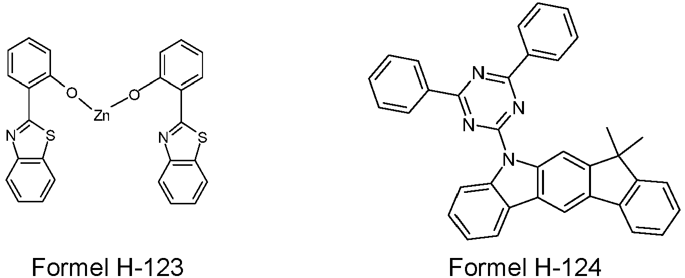

Im Hinblick auf die erfindungsgemäß einsetzbaren funktionalen Verbindungen, die als Hostmaterial dienen können, sind insbesondere Stoffe bevorzugt, die mindestens ein Stickstoffatom aufweist. Hierzu gehören vorzugsweise aromatische Amine, Triazin- und Carbazol-Derivate. So zeigen insbesondere Carbazol-Derivate eine überraschend hohe Effizienz. Triazin-Derivate führen unerwartet zu hohen Lebensdauern der elektronischen Vorrichtungen mit den genannten Verbindungen.

Die Mischung gemäß Ansspruch 1 enthält mindestens ein elektronenleitendes Matrixmaterial und mindestens ein lochleitendes Matrixmaterial als funktionale Materialien. Eine derartige Mischung wird bevorzugt mit dem erfindungsgemäßen Verfahren hergestellt.

Ebenso bevorzugt ist die erfindungsgemäße Herstellung einer Mischung aus einem elektronenleitenden Matrixmaterial und einem lochleitenden Matrixmaterial, wobei derartige Mischungen an Materialien z. B. in WO 2019/007866, WO 2019/007867 und WO 2019/229011 beschrieben sind.

Ebenso bevorzugt ist die erfindungsgemäße Herstellung einer Mischung aus einem elektronenleitenden Matrixmaterial der nachfolgenden Tabelle 1 und einem lochleitenden Matrixmaterial der nachfolgenden Tabelle 2, wobei gegebenenfalls noch ein weiteres Matrixmaterial und/oder ein Emitter, wie zuvor beschrieben, enthalten sein kann.

Elektronenleitende Verbindungen der Tabelle 1:

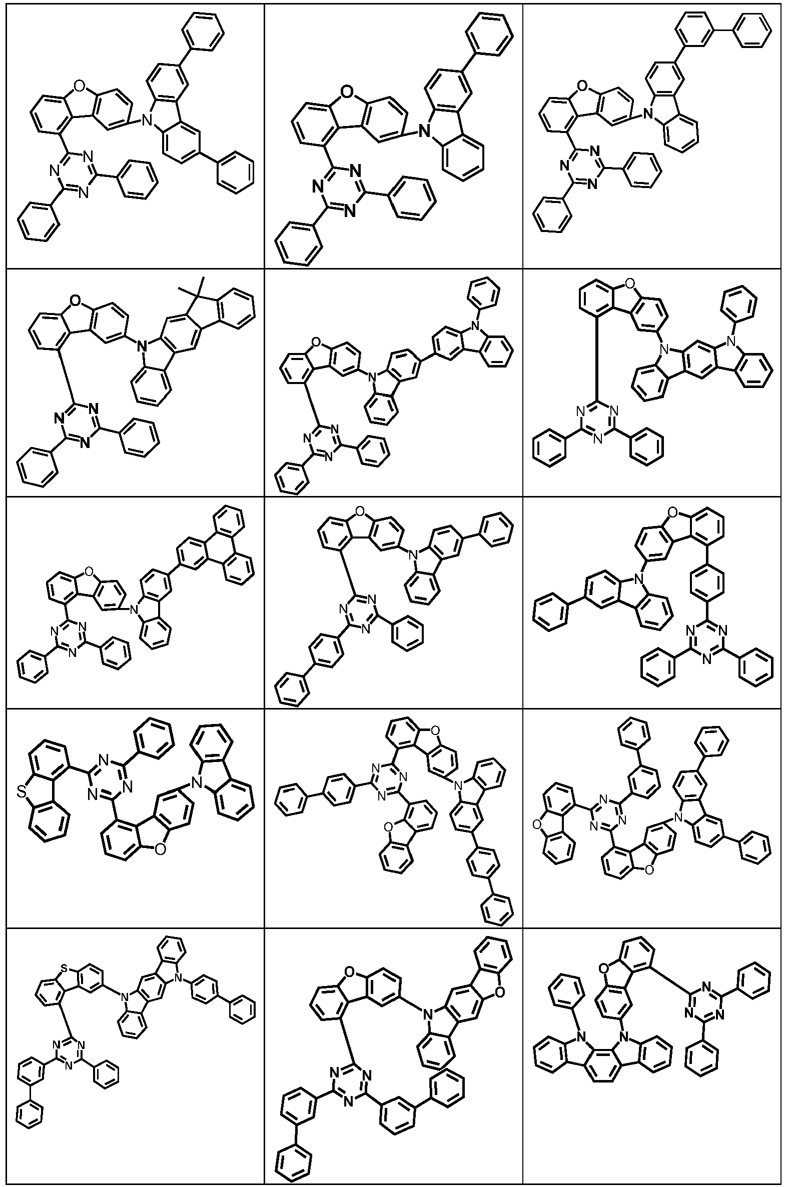

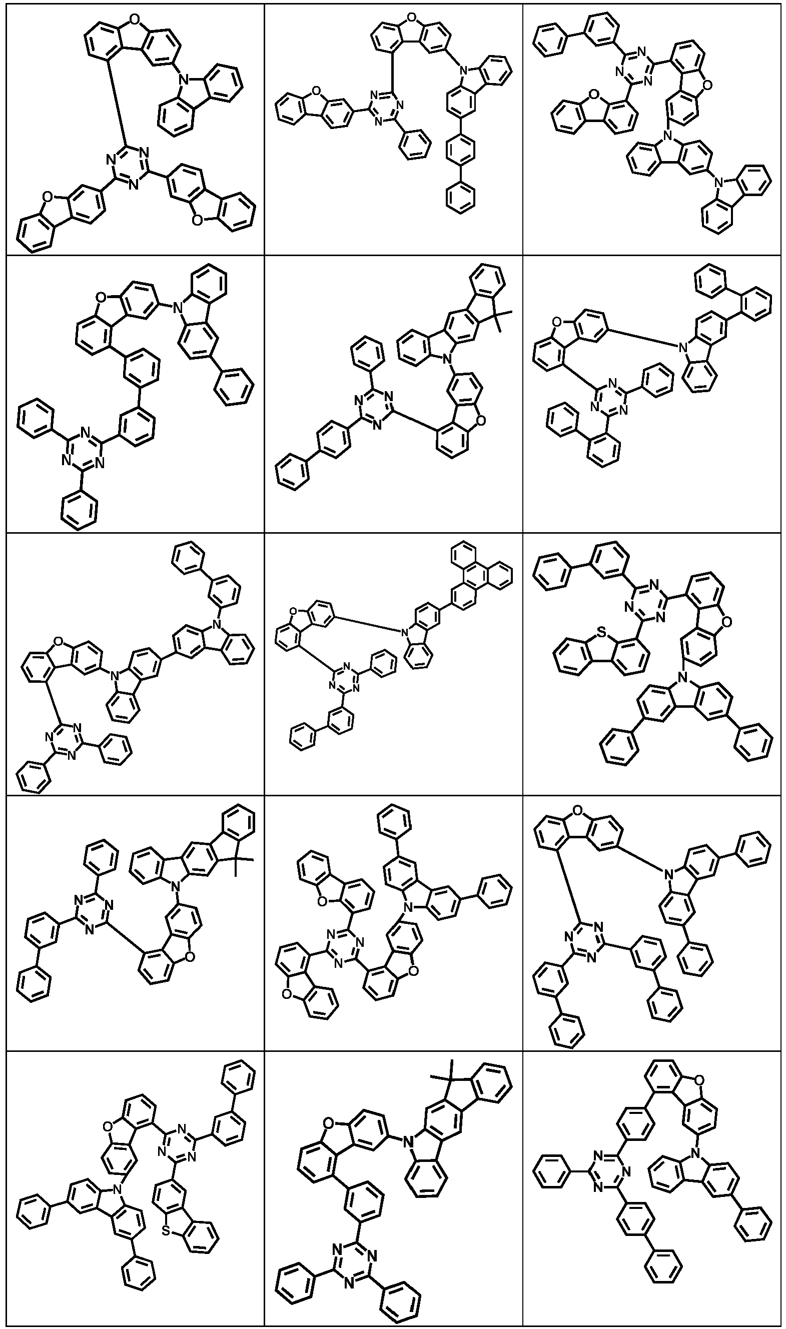

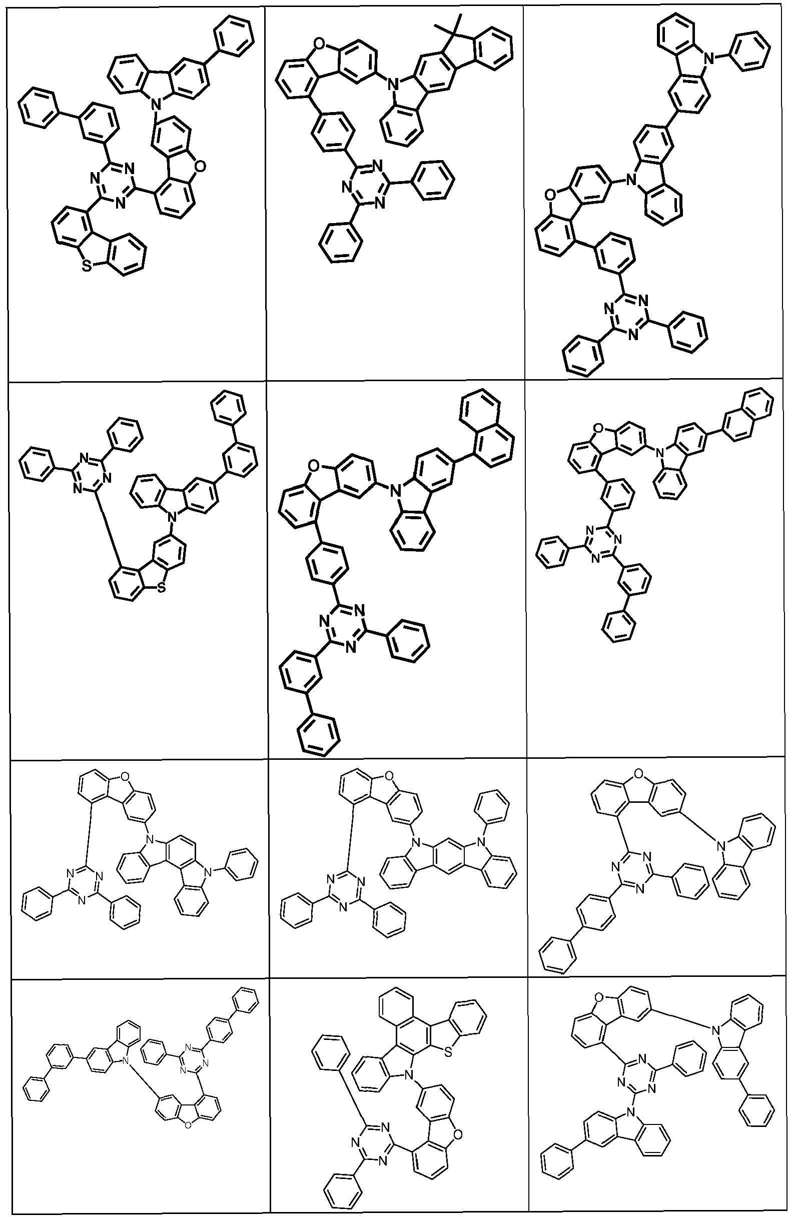

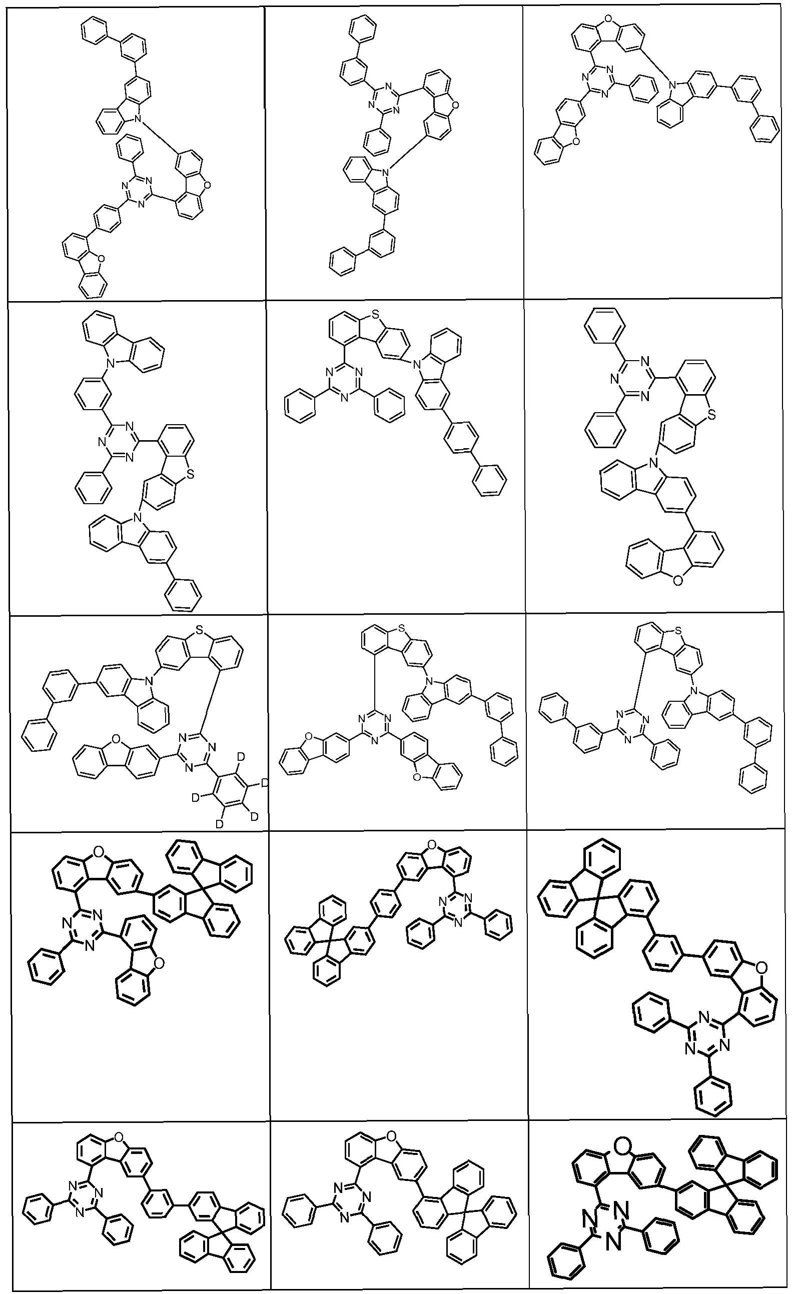

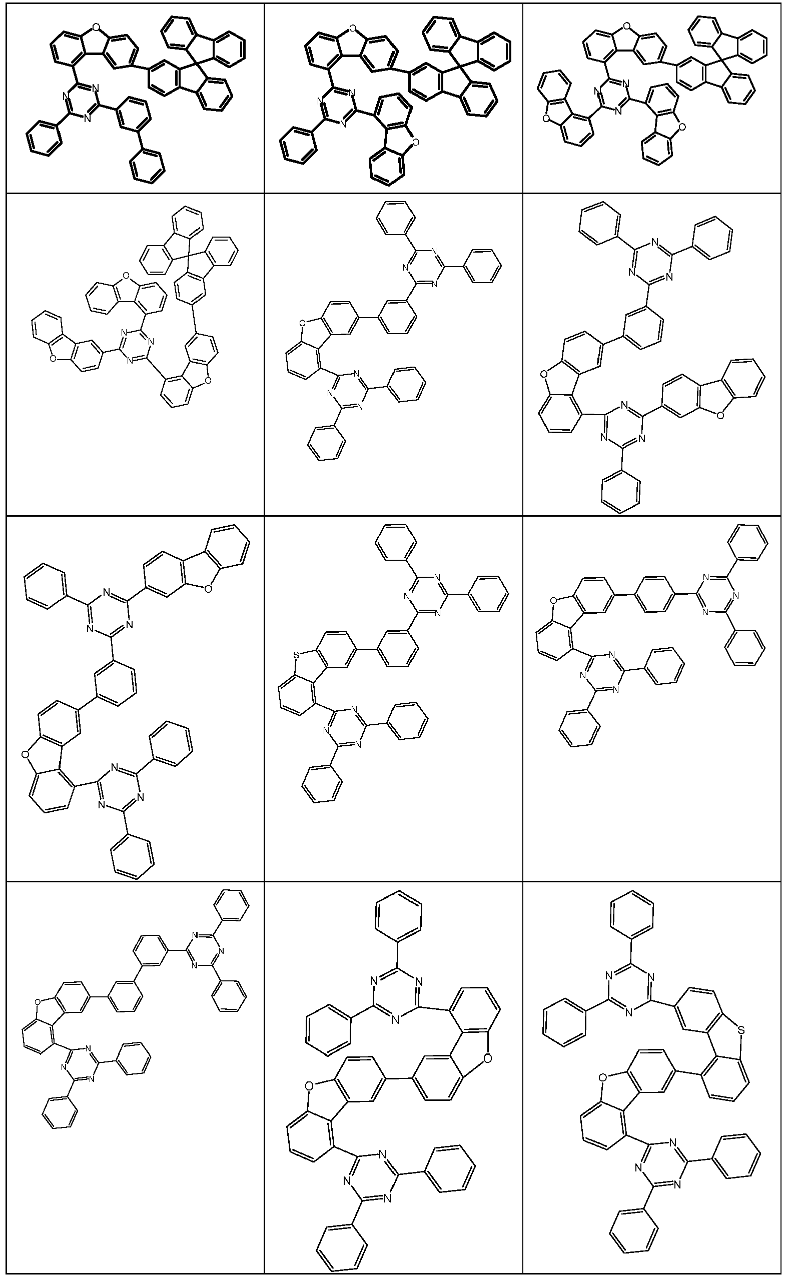

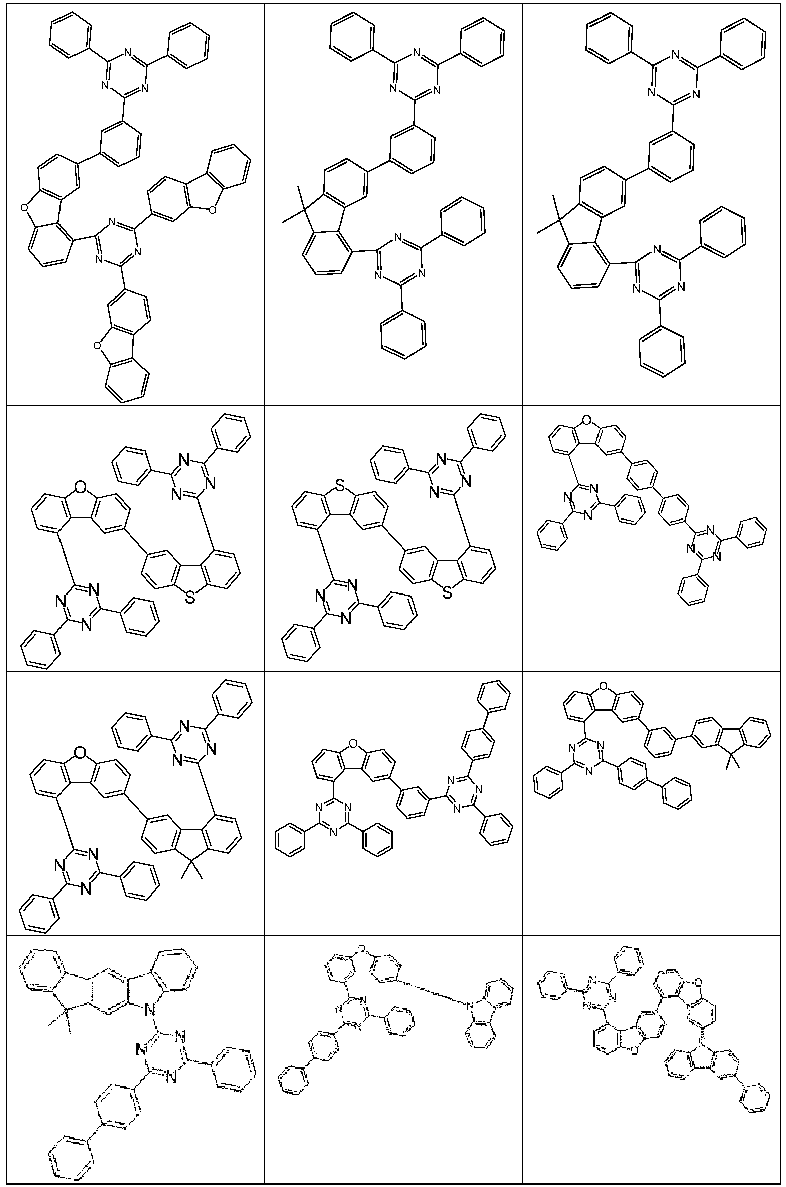

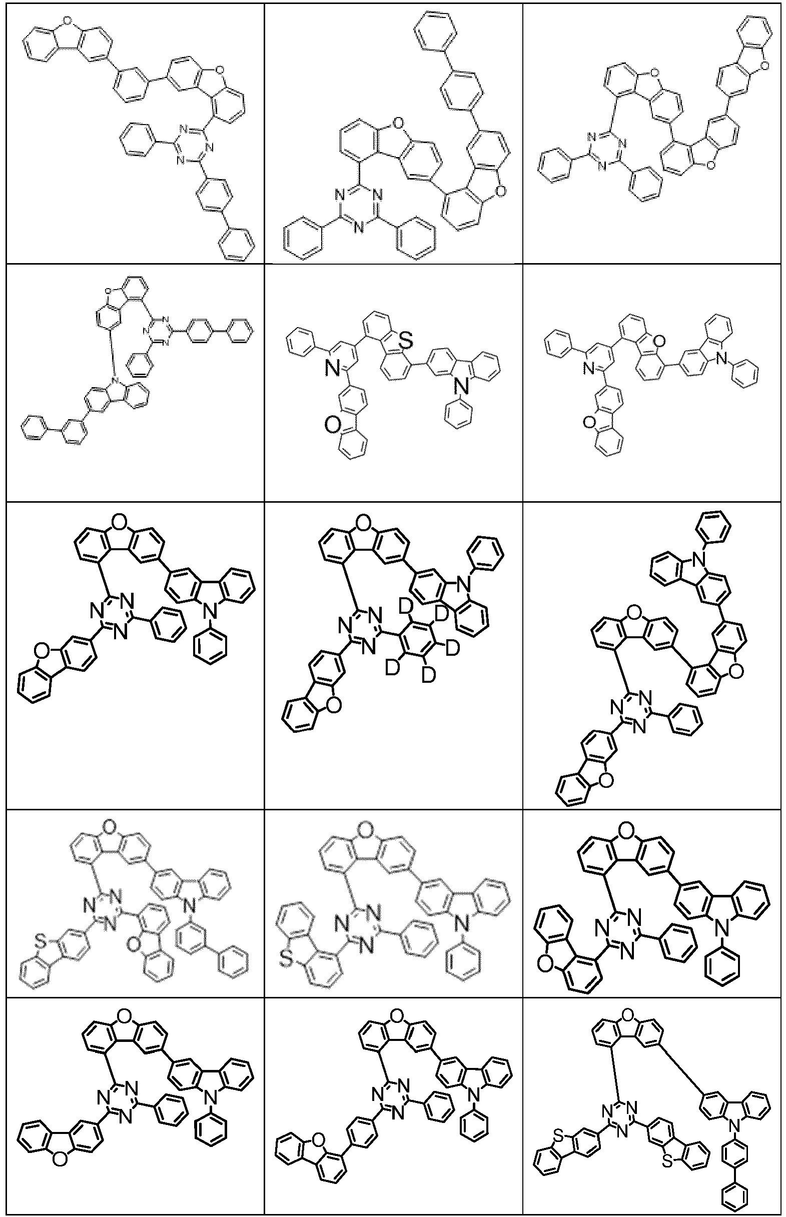

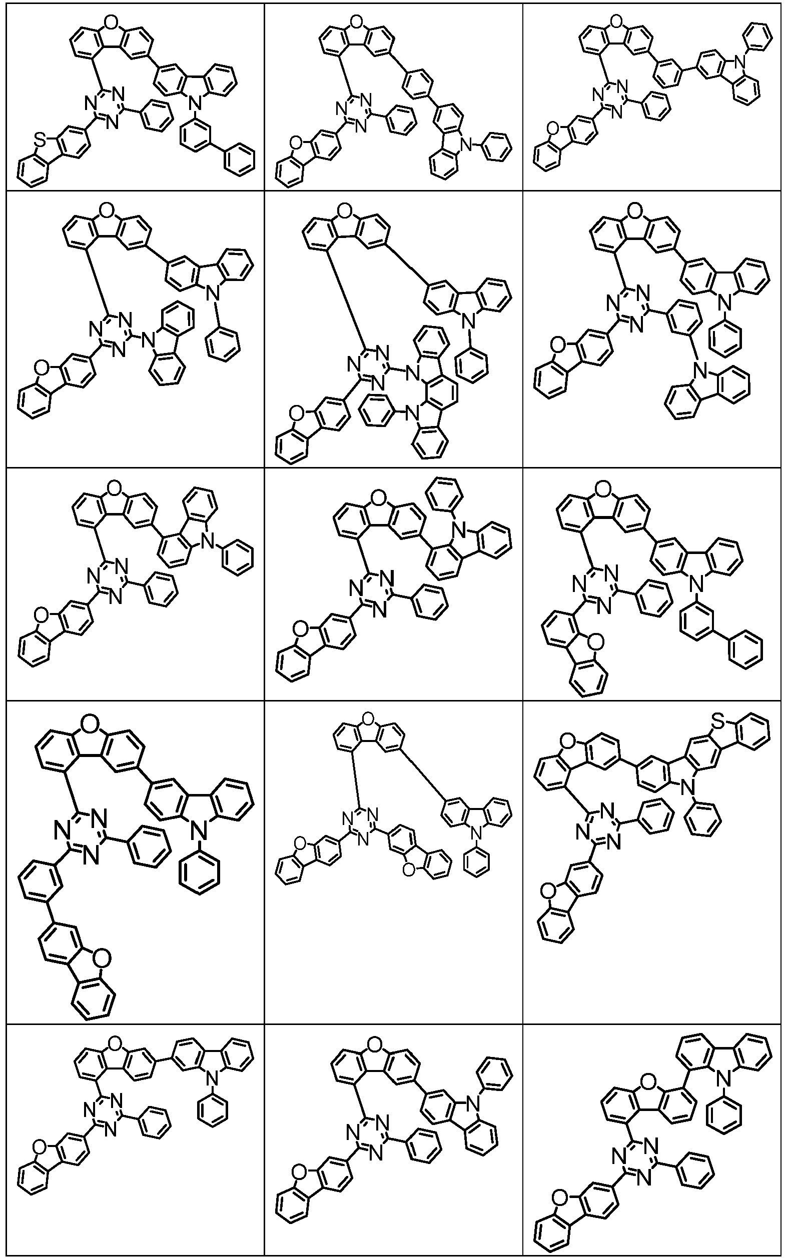

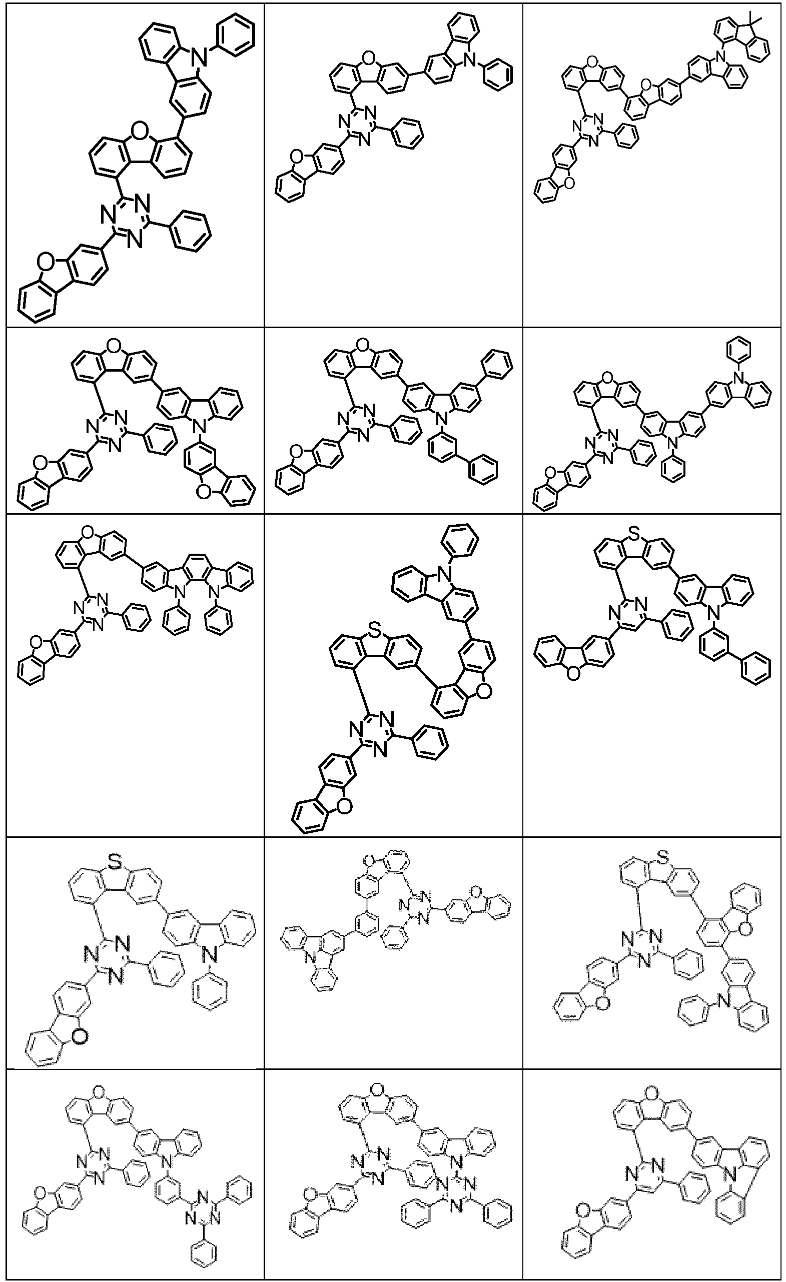

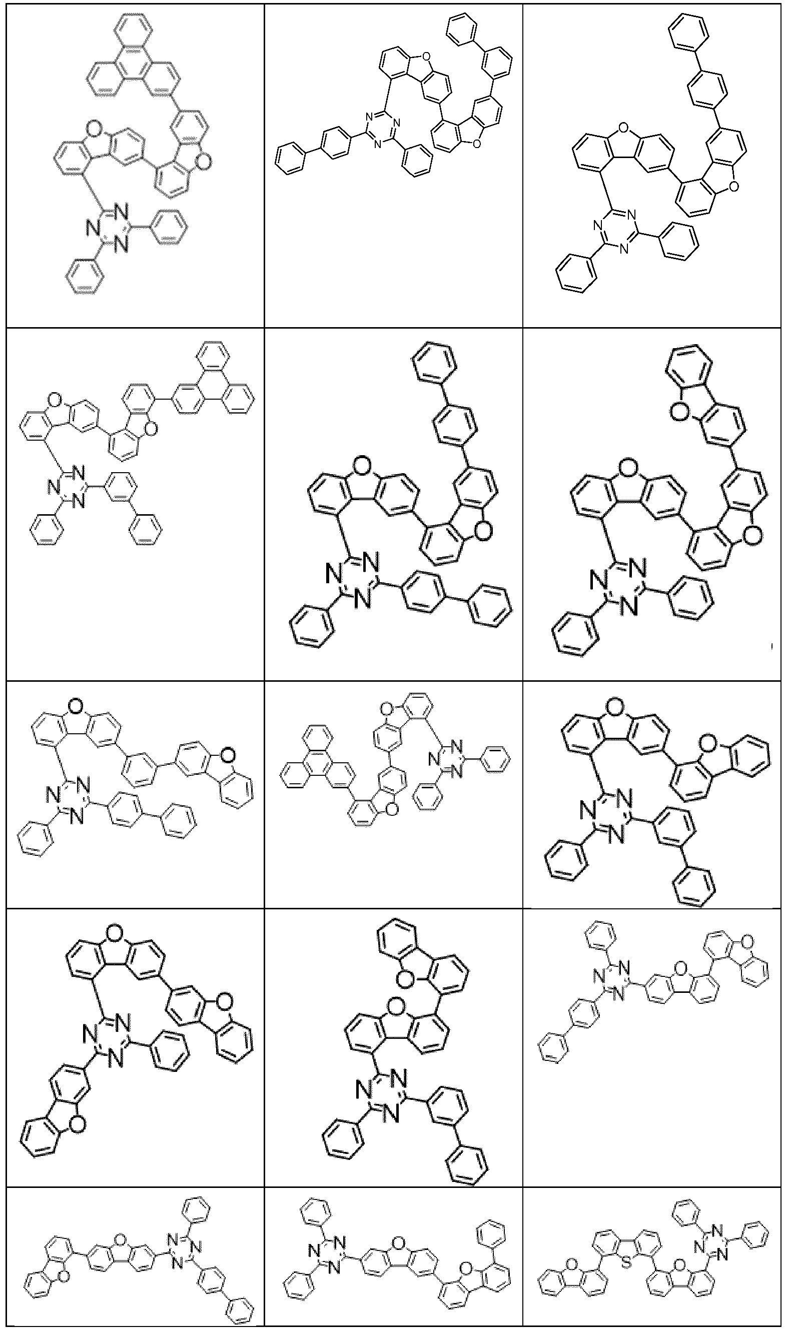

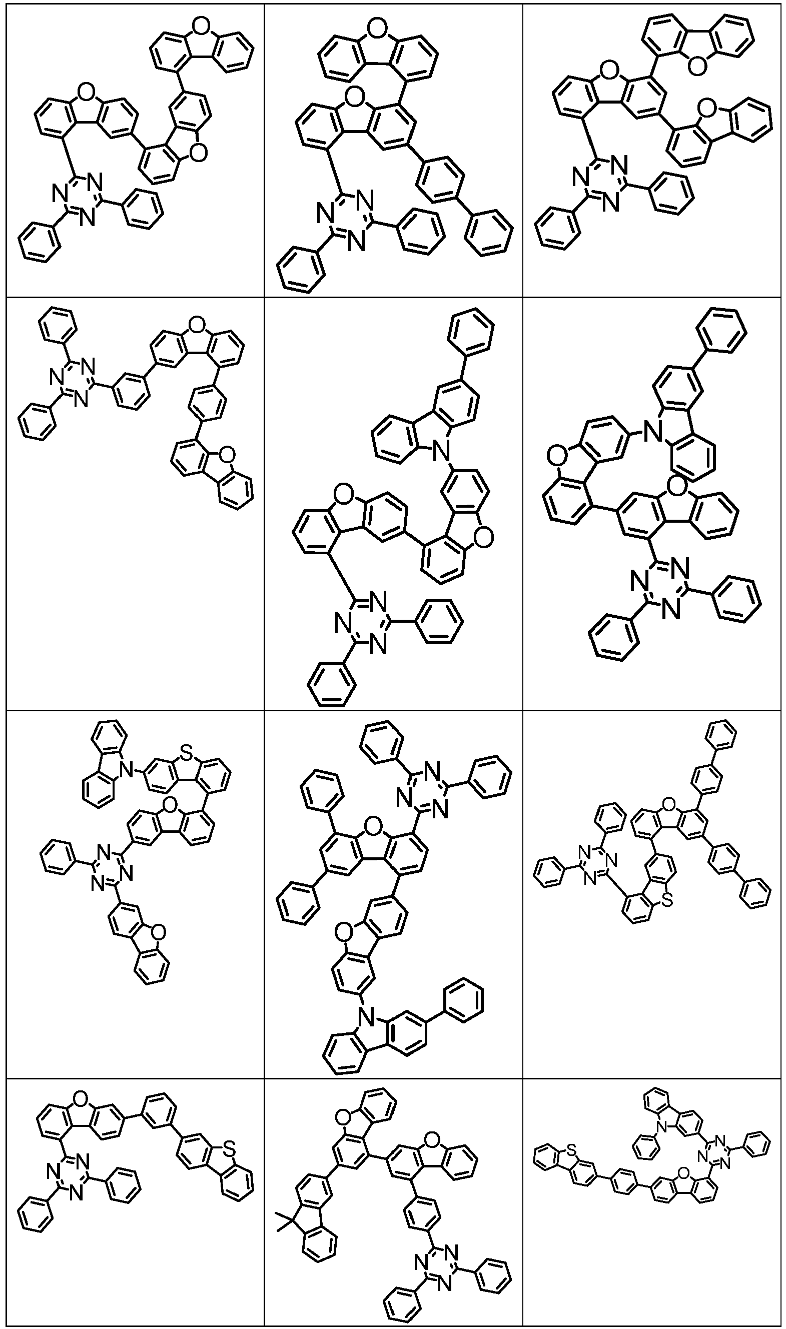

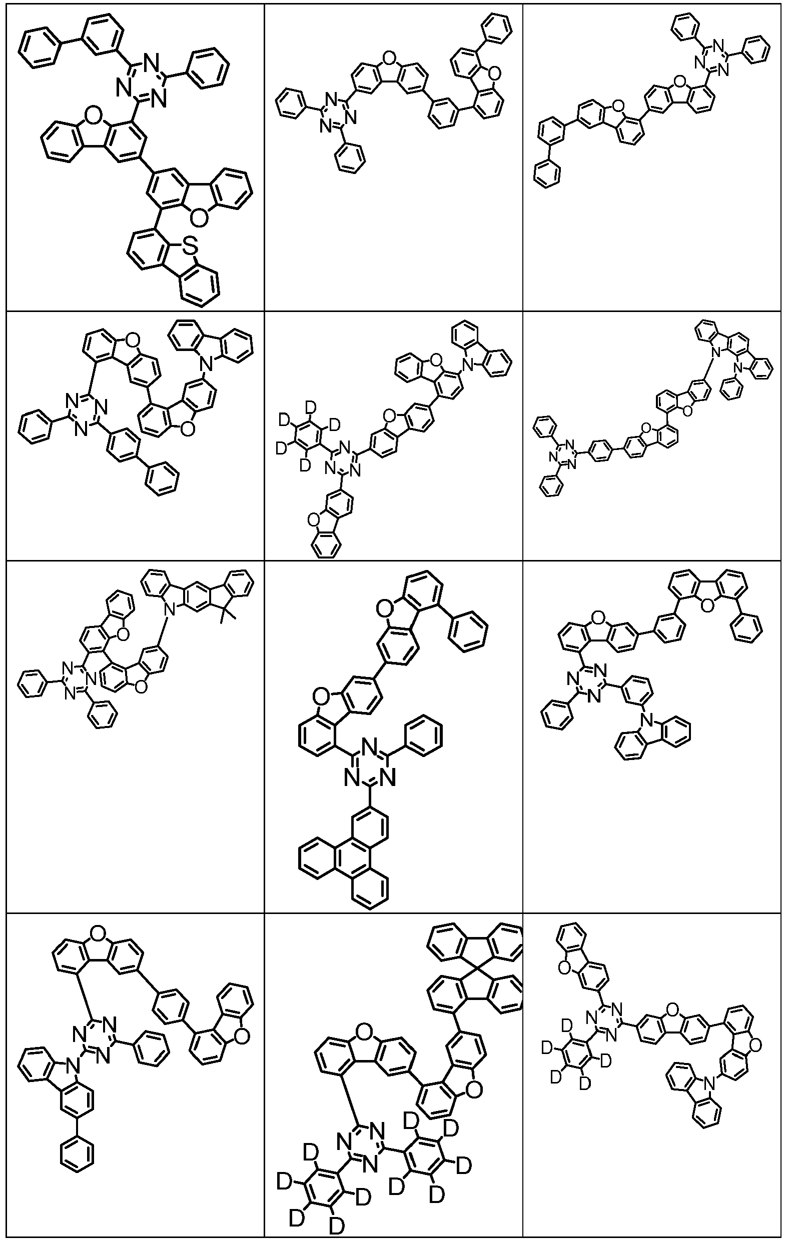

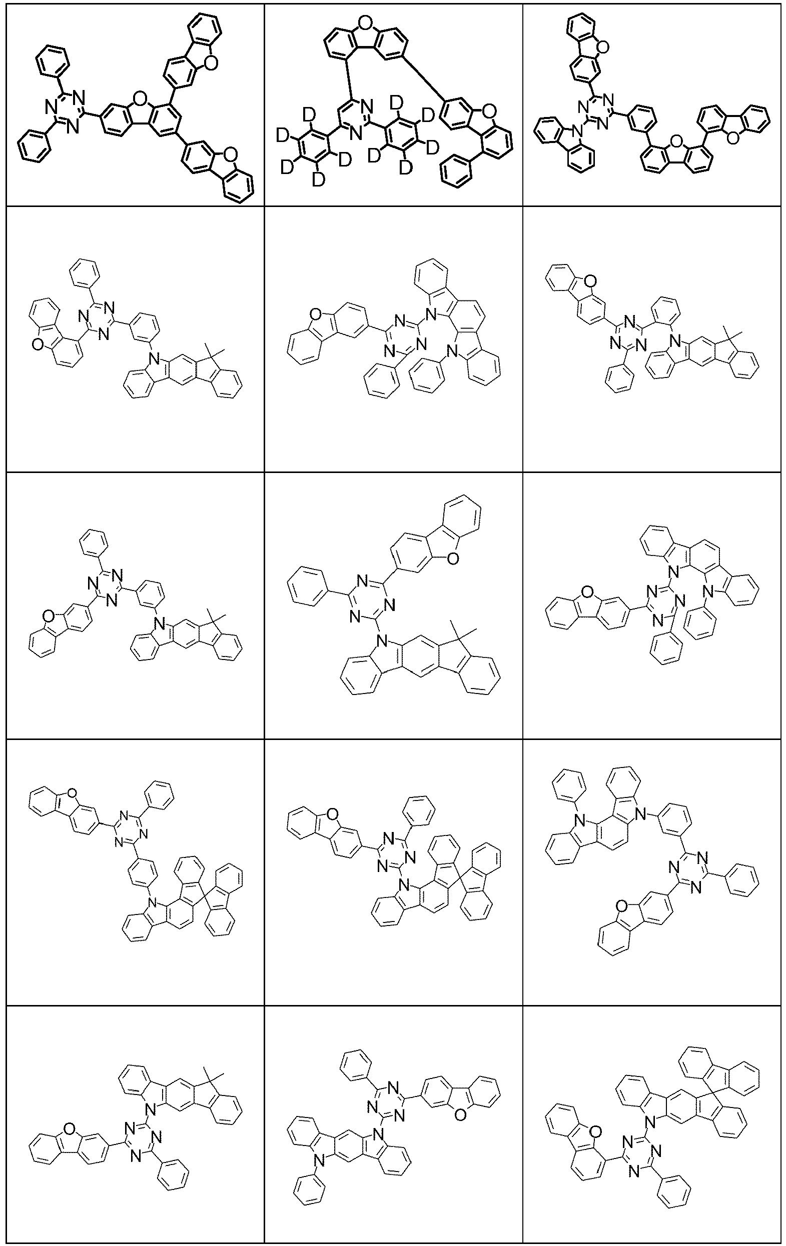

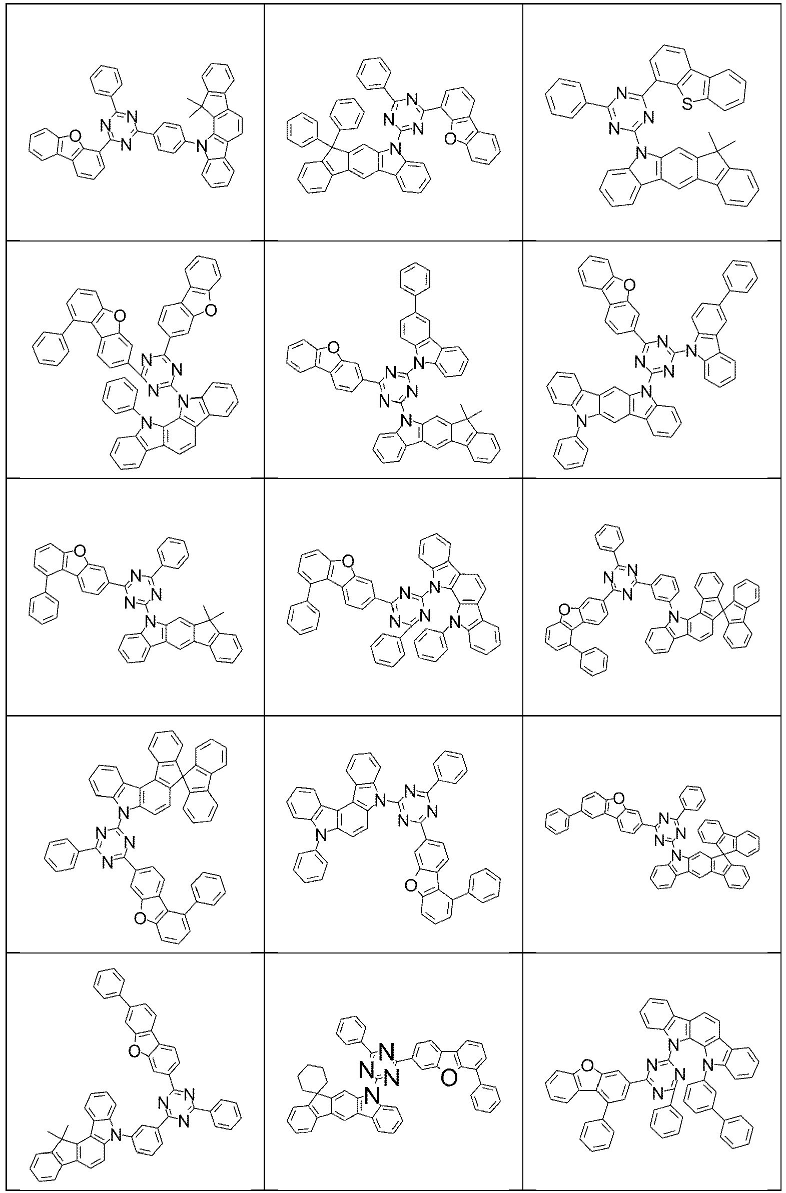

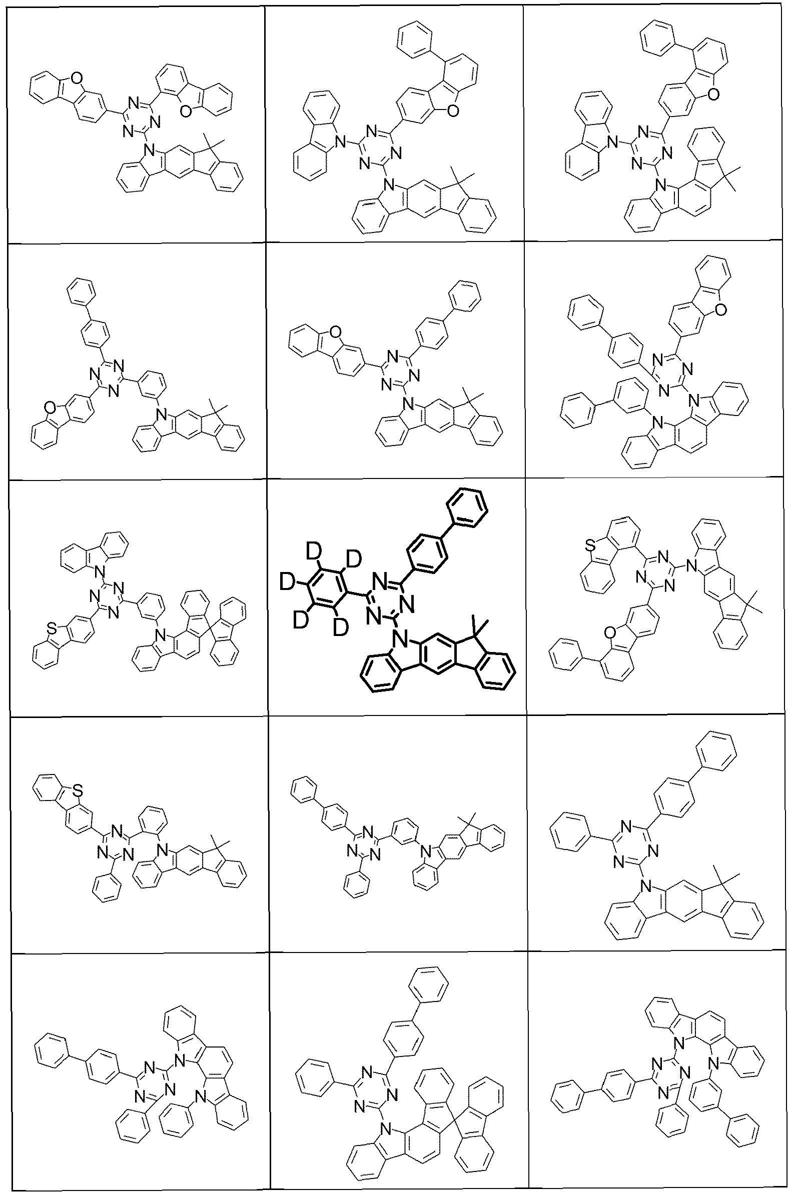

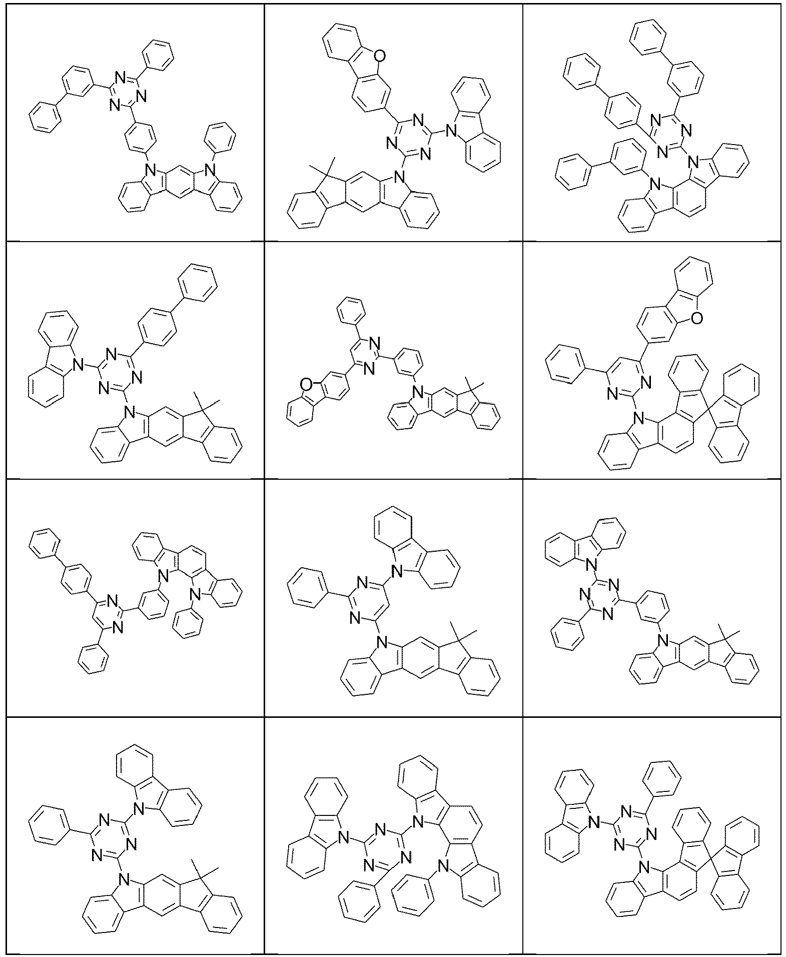

Lochleitende Verbindungen der Tabelle 2:

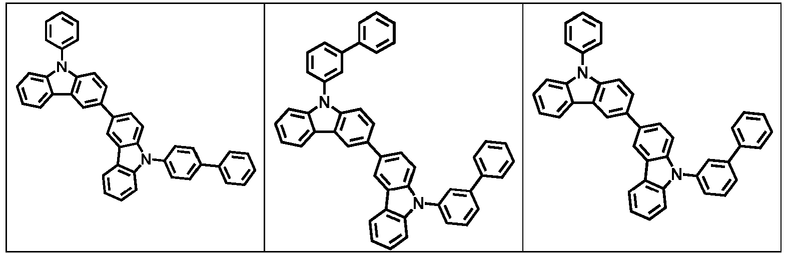

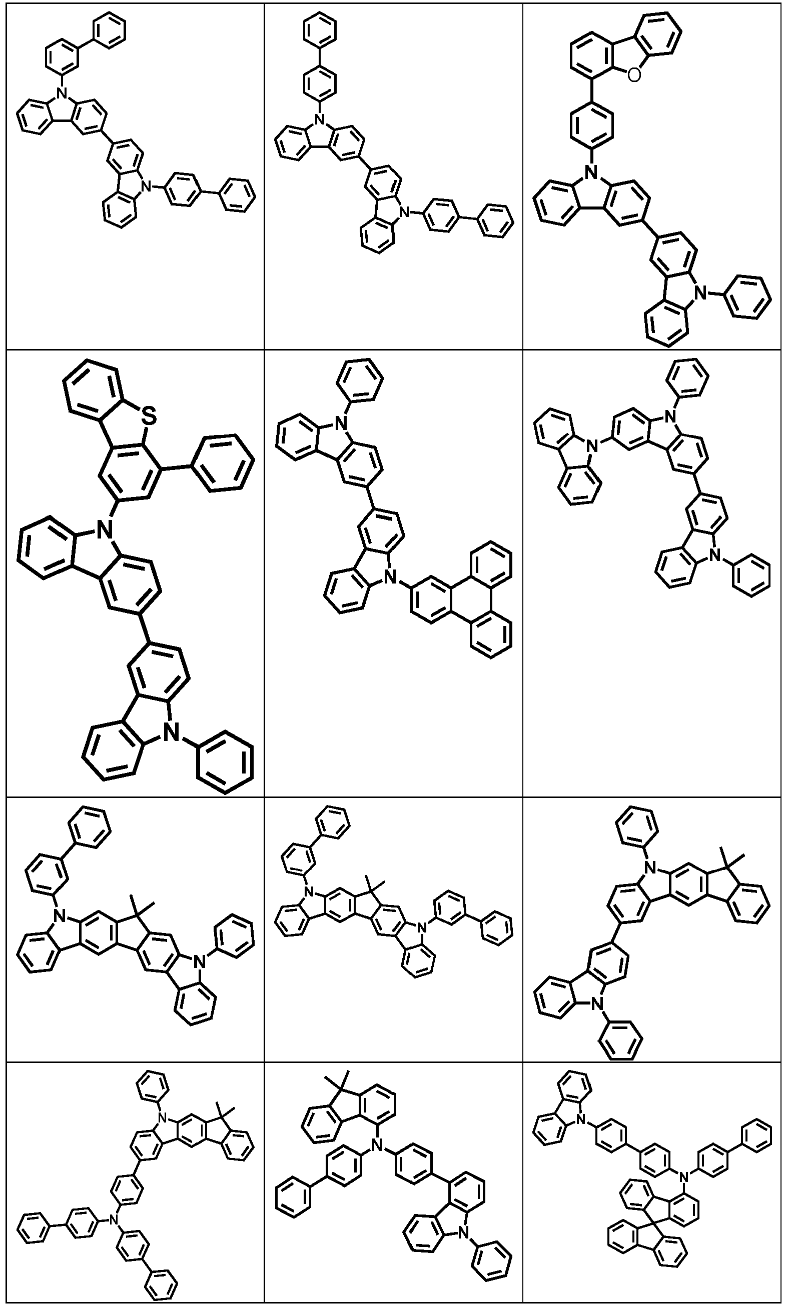

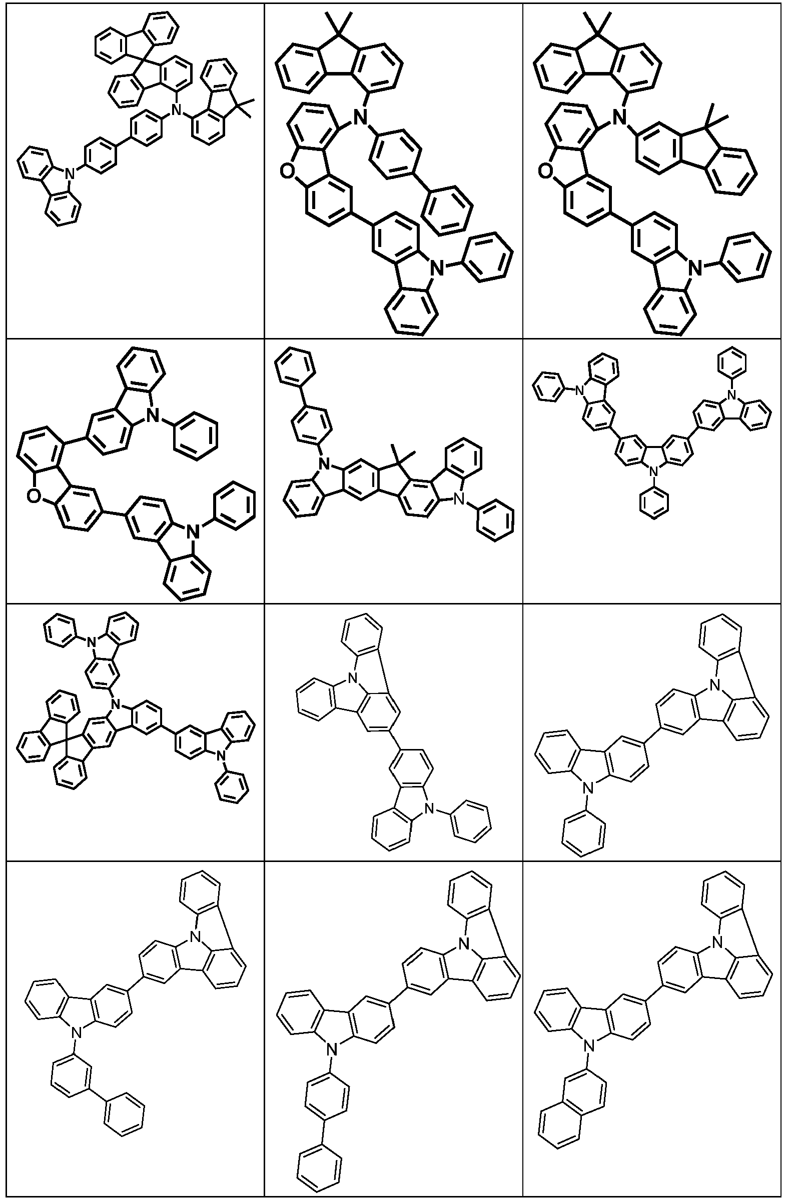

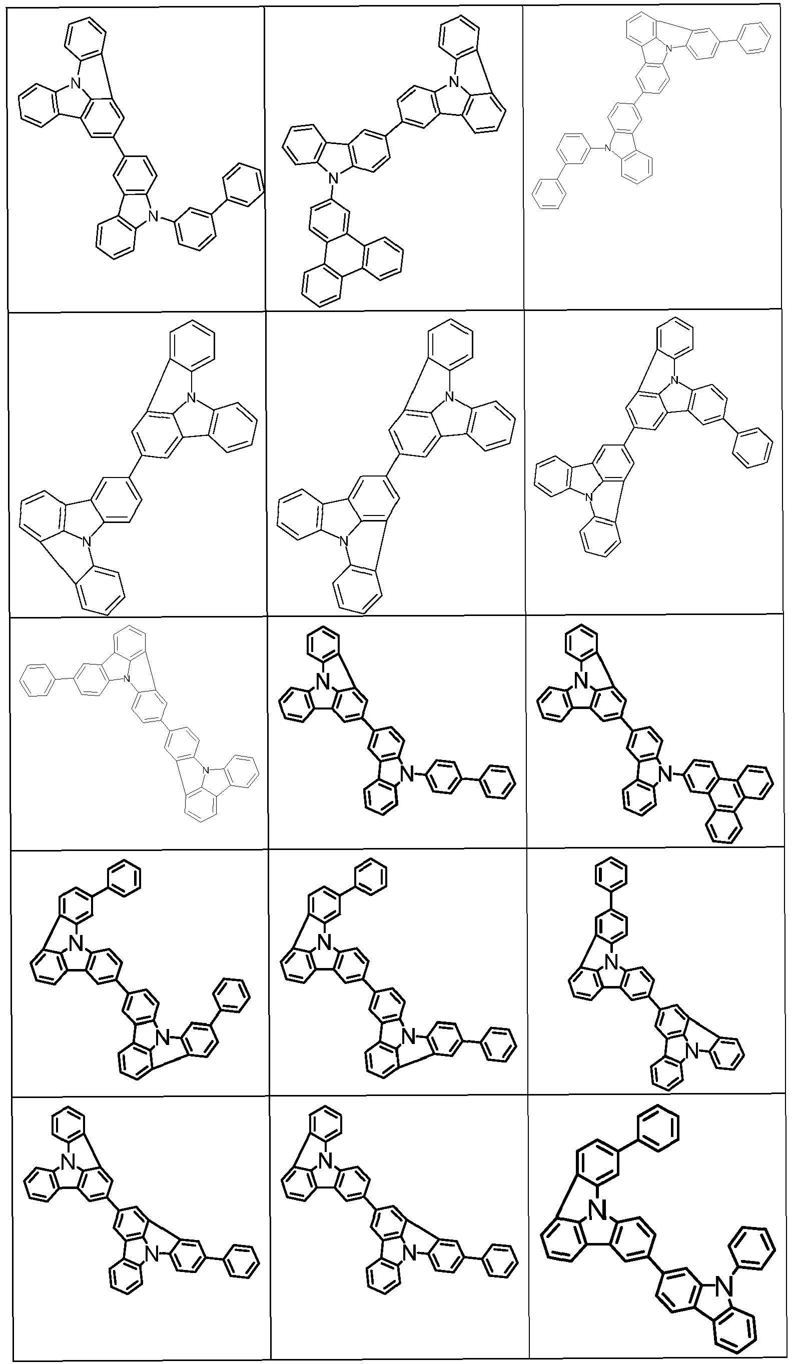

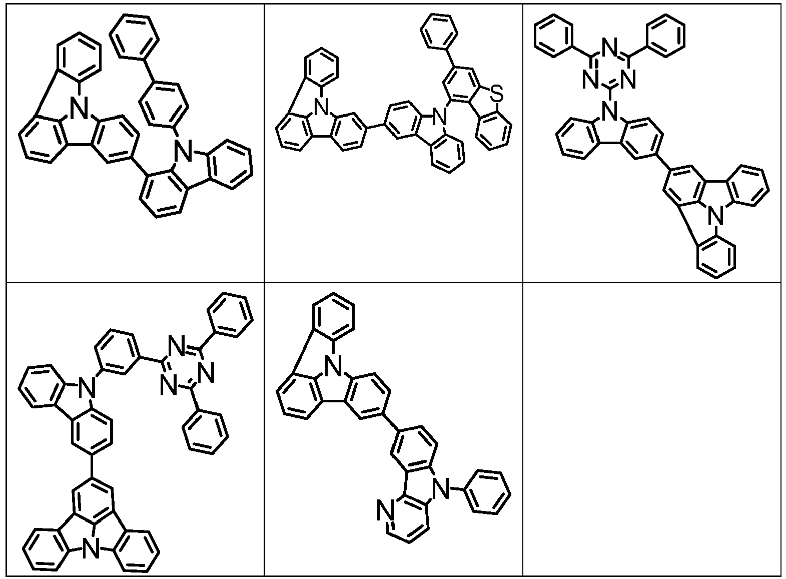

Weiterhin können Verbindungen als organische funktionale Materialien (FM1, FM2) eingesetzt werden, welche den Übergang vom Singulett- zum Triplettzustand verbessern und welche, unterstützend zu den funktionalen Verbindungen mit Emittereigenschaften eingesetzt, die Phosphoreszenzeigenschaften dieser Verbindungen verbessern. Hierfür kommen insbesondere Carbazol- und überbrückte Carbazoldimereinheiten in Frage, wie sie z.B. in der WO 04/070772 A2 und der WO 04/113468 A1 beschrieben werden. Weiterhin kommen hierfür Ketone, Phosphinoxide, Sulfoxide, Sulfone, Silan-Derivate und ähnliche Verbindungen in Frage, wie sie z.B. in der WO 05/040302 A1 beschrieben werden.

Unter n-Dotanden werden hierin Reduktionsmittel, d.h. Elektronendonatoren verstanden. Bevorzugte Beispiele für n-Dotanden als organische funktionale Materialien (FM1, FM2) sind W(hpp)4 und weitere elektronenreiche Metallkomplexe gemäß WO 2005/086251 A2, P=N-Verbindungen (z.B. WO 2012/175535 A1, WO 2012/175219 A1), Naphthylencarbodiimide (z.B. WO 2012/168358 A1), Fluorene (z.B. WO 2012/031735 A1), Radikale und Diradikale (z.B. EP 1837926 A1, WO 2007/107306 A1), Pyridine (z.B. EP 2452946 A1, EP 2463927 A1), N-heterocyclische Verbindungen (z.B. WO 2009/000237 A1) und Acridine sowie Phenazine (z.B. US 2007/145355 A1).

Weiterhin können die zur Herstellung der Mischungen einsetzbaren Verbindungen als Wide-Band-Gap-Material ausgestaltet sein. Unter Wide-Band-Gap-Material wird ein Material im Sinne der Offenbarung von US 7,294,849 verstanden. Diese Systeme zeigen besondere vorteilhafte Leistungsdaten in elektrolumineszierenden Vorrichtungen.

Vorzugsweise kann die als Wide-Band-Gap-Material eingesetzte Verbindung eine Bandlücke (band gap) von 2.5 eV oder mehr, bevorzugt 3.0 eV oder mehr, ganz bevorzugt von 3.5 eV oder mehr aufweisen. Die Bandlücke kann unter anderem durch die Energieniveaus des highest occupied molecular orbital (HOMO) und des lowest unoccupied molecular orbital (LUMO) berechnet werden.

Weiterhin können die zur Herstellung der Mischungen einsetzbaren Verbindungen als Lochblockiermaterial (hole blocking material; HBM) ausgestaltet sein. Ein Lochblockiermaterial bezeichnet ein Material welches in einem Mehrschichtverbund die Durchleitung von Löchern (positive Ladungen) verhindert oder minimiert, insbesondere falls dieses Material in Form einer Schicht benachbart zu einer Emissionsschicht oder eine lochleitenden Schicht angeordnet ist. Im Allgemeinen hat ein Lochblockiermaterial ein niedrigeres HOMO Niveau als das Lochtransportmaterial in der benachbarten Schicht. Lochblockierschichten werden häufig zwischen der lichtemittierenden Schicht und der Elektronentransportschicht in OLEDs angeordnet.

Grundsätzlich kann jedes bekannte Lochblockiermaterial verwendet werden. Zusätzlich zu weiteren Lochblockiermaterialien, die an anderen Stellen in der vorliegenden Anmeldung dargelegt werden, sind zweckmäßige Lochblockiermaterialien Metallkomplexe (US 2003/0068528), wie beispielsweise Bis(2-methyl-8-quinolinolato)(4-phenylphenolato)-aluminium(III) (BAIQ). Fac-tris(1-phenylpyrazolato-N,C2)iridium(III) (Ir(ppz)3) wird ebenfalls für diese Zwecke eingesetzt (US 2003/0175553 A1). Phenanthrolin-Derivate, wie beispielsweise BCP, oder Phthalimide, wie beispielsweise TMPP können ebenfalls eingesetzt werden.

Weiterhin werden zweckmäßige Lochblockiermaterialien in WO 00/70655 A2, WO 01/41512 und WO 01/93642 A1 beschrieben.

Grundsätzlich kann jedes bekannte Elektronenblockiermaterial (electron blocking material; EBM) verwendet werden. Ein Elektronenblockiermaterial bezeichnet ein Material welches in einem Mehrschichtverbund die Durchleitung von Elektronen verhindert oder minimiert, insbesondere falls dieses Material in Form einer Schicht benachbart zu einer Emissionsschicht oder eine elektronenleitenden Schicht angeordnet ist. Im Allgemeinen hat ein Elektronenblockiermaterial ein höheres LUMO Niveau als das Elektronentransportmaterial in der benachbarten Schicht.

Zusätzlich zu weiteren Elektronenblockiermaterialien, die an anderen Stellen in der vorliegenden Anmeldung dargelegt werden, sind zweckmäßige Elektronenblockiermaterialien Übergangsmetall-Komplexe wie beispielsweise Ir(ppz)3 (US 2003/0175553).

Vorzugsweise kann das Elektronenblockiermaterial ausgewählt sein aus Aminen, Triarylaminen und deren Derivativen.

Weiterhin weisen die funktionalen Materialien (FM1, FM2), welche zur Herstellung von Funktionsschichten elektronischer Vorrichtungen einsetzbar sind, sofern es sich um niedermolekulare Verbindungen handelt, und welche in Molekulargewicht von ≤ 2000 g/mol haben, besonders bevorzugt von ≤ 1500 g/mol, insbesondere bevorzugt ≤ 1200 g/mol und ganz besonders bevorzugt von ≤ 1000 g/mol auf. Niedermolekulare Verbindungen können sublimiert oder verdampft werden.

Von besonderem Interesse sind des Weiteren funktionale Materialien (FM1, FM2), welche zur Herstellung von Funktionsschichten elektronischer Vorrichtungen einsetzbar sind, die sich durch eine hohe Glasübergangstemperatur auszeichnen. In diesem Zusammenhang sind Verbindungen, welche zur Herstellung von Funktionsschichten elektronischer Vorrichtungen einsetzbar sind, bevorzugt, die eine Glasübergangstemperatur von ≥ 70°C, bevorzugt von ≥ 100°C, besonders bevorzugt von ≥ 125°C und insbesondere bevorzugt von ≥ 150°C aufweisen, bestimmt nach DIN 51005:2005-08.

Unter der Voraussetzung, dass die in Anspruch 1 genannten Bedingungen eingehalten werden, sind die oben genannten bevorzugten Ausführungsformen beliebig miteinander kombinierbar. In einer besonders bevorzugten Ausführungsform der Erfindung gelten die oben genannten bevorzugten Ausführungsformen gleichzeitig.

Die erfindungsgemäß einsetzbaren Verbindungen, welche zur Herstellung von Funktionsschichten elektronischer Vorrichtungen einsetzbar sind, sind prinzipiell durch verschiedene Verfahren darstellbar, wobei diese in den zuvor Druckschriften dargelegt sind.

Die mit der Erfindung erhaltenen Granulate können alle organisch funktionellen Materialien enthalten, die für die Herstellung der jeweiligen funktionellen Schicht der elektronischen Vorrichtung notwendig sind. Ist z.B. eine Lochtransport-, Lochinjektions-, Elektronentransport-, Elektroneninjektionsschicht genau aus zwei funktionellen Verbindungen aufgebaut, so umfasst das Granulat als organisch funktionale Materialien genau diese zwei Verbindungen. Weist eine Emissionsschicht beispielsweise einen Emitter im Kombination mit einem Matrix- oder Hostmaterial auf, so umfasst die Formulierung als organisch funktionales Material genau die Mischung von Emitter und Matrix- oder Hostmaterial, wie dies in der vorliegenden Anmeldung an anderer Stelle ausführlicher dargelegt ist.

Funktionale Materialien sind generell die organischen oder anorganischen Materialien, welche zwischen Anode und Kathode eingebracht sind. Vorzugsweise ist das organisch funktionale Material ausgewählt aus der Gruppe bestehend aus fluoreszierenden Emittern, phosphoreszierenden Emittern, Emittern, die TADF (thermally activated delayed fluorescence) zeigen, Emittern, die Hyperfluoreszenz oder Hyperphosphoreszenz zeigen, Hostmaterialien, Excitonenblockiermaterialien Elektroneninjektionsmaterialien, Elektronentransportmaterialien, Elektronenblockiermaterialien, Lochinjektionsmaterialien, Lochleitermaterialien, Lochblockiermaterialien, n-Dotanden, p-Dotanden, Wide-Band-Gap-Materialien, Ladungserzeugungsmaterialien.

Die gemäß dem Verfahren der vorliegenden Erfindung hergestellten Granulate können zur Herstellung einer elektronischen Vorrichtung verwendet werden.

Unter einer elektronischen Vorrichtung wird eine Vorrichtung verstanden, welche Anode, Kathode und mindestens eine dazwischenliegenden Funktionsschicht enthält, wobei diese Funktionsschicht mindestens eine organische bzw. metallorganische Verbindung enthält.

Die organische, elektronische Vorrichtung ist vorzugsweise eine organische elektrolumineszierende Vorrichtung (OLED), eine polymere elektro-lumineszierende Vorrichtung (PLED), eine organische integrierte Schaltung (O-IC), ein organischer Feld-Effekt-Transistor (O-FET), ein organischer Dünnfilmtransistor (O-TFT), ein organischer, lichtemittierender Transistor (O-LET), eine organische Solarzelle (O-SC), ein organischer, optischer Detektor, ein organischer Fotorezeptor, ein organisches Feld-Quench-Device (O-FQD), ein organisch elektrischer Sensor, eine lichtemittierende elektrochemische Zelle (LEC) oder eine organische Laserdiode (O-Laser).

Aktive Komponenten sind generell die organischen oder anorganischen Materialien, welche zwischen Anode und Kathode eingebracht sind, wobei diese aktiven Komponenten die Eigenschaften der elektronischen Vorrichtung, beispielsweise deren Leistungsfähigkeit und/oder deren Lebensdauer bewirken, aufrechterhalten und/oder verbessern, beispielsweise Ladungsinjektions-, Ladungstransport- oder Ladungsblockiermaterialien, insbesondere aber Emissionsmaterialien und Matrixmaterialien. Das organisch funktionelle Material, welches zur Herstellung von Funktionsschichten elektronischer Vorrichtungen einsetzbar ist, umfasst demgemäß vorzugsweise eine aktive Komponente der elektronischen Vorrichtung.

Eine bevorzugte Ausführungsform der vorliegenden Erfindung sind organische Elektrolumineszenzvorrichtungen. Die organische Elektrolumineszenzvorrichtung enthält Kathode, Anode und mindestens eine emittierende Schicht.

Weiterhin bevorzugt ist es, eine Mischung aus zwei oder mehr Triplett-Emittern zusammen mit einer Matrix als organische funktionale Materialien (FM1, FM2) im erfindungsgemäßen Verfahren einzusetzen. Dabei dient der Triplett-Emitter mit dem kürzerwelligen Emissionsspektrum als Co-Matrix für den Triplett-Emitter mit dem längerwelligen Emissionsspektrum.

Der Anteil des Matrixmaterials in der emittierenden Schicht liegt in diesem Fall vorzugsweise zwischen 50 und 99,9 Vol.-%, besonders bevorzugt zwischen 80 und 99,5 Vol.-% und insbesondere bevorzugt für fluoreszierende emittierende Schichten zwischen 92 und 99,5 Vol.-% sowie für phosphoreszierende emittierende Schichten zwischen 85 und 97 Vol.-%.

Entsprechend liegt der Anteil des Dotanden vorzugsweise zwischen 0,1 und 50 Vol.-%, besonders bevorzugt zwischen 0,5 und 20 Vol.-% und insbesondere bevorzugt für fluoreszierende emittierende Schichten zwischen 0,5 und 8 Vol.-% sowie für phosphoreszierende emittierende Schichten zwischen 3 und 15 Vol.-%.

Die angegebenen Volumenprozent gelten entsprechend auch für die herzustellende Mischung der funktionalen Materialien (FM1, FM2), wie zuvor beschrieben.

Eine emittierende Schicht einer organischen Elektrolumineszenzvorrichtung kann auch Systeme umfassen, die mehrere Matrixmaterialien (Mixed-Matrix-Systeme) und/oder mehrere Dotanden enthalten. Auch in diesem Fall sind die Dotanden im Allgemeinen diejenigen Materialien, deren Anteil im System der kleinere ist und die Matrixmaterialien sind diejenigen Materialien, deren Anteil im System der größere ist. In Einzelfällen kann jedoch der Anteil eines einzelnen Matrixmaterials im System kleiner sein als der Anteil eines einzelnen Dotanden.

Die Mixed-Matrix-Systeme umfassen bevorzugt zwei oder drei verschiedene Matrixmaterialen gemäß den Ansprüchen. Bevorzugt stellt dabei eines der beiden Materialien ein Material mit lochtransportierenden Eigenschaften und das andere Material ein Material mit elektronentransportierenden Eigenschaften dar. Die gewünschten elektronentransportierenden und lochtransportierenden Eigenschaften der Mixed-Matrix-Komponenten können jedoch auch hauptsächlich oder vollständig in einer einzigen Mixed-Matrix-Komponente vereinigt sein, wobei die weitere bzw. die weiteren Mixed-Matrix-Komponenten andere Funktionen erfüllen. Die beiden unterschiedlichen Matrixmaterialien können dabei in einem Verhältnis von 1:50 bis 1:1, bevorzugt von 1:20 bis 1:1, besonders bevorzugt von 1:10 bis 1:1 und insbesondere bevorzugt von 1:4 bis 1:1 vorliegen. Bevorzugt werden Mixed-Matrix-Systeme in phosphoreszierenden organischen Elektrolumineszenzvorrichtungen eingesetzt. Detailliertere Angaben zu Mixed-Matrix-Systemen finden sich z.B. in der WO 2010/108579.

Die genannten Mixed-Matrix-Komponenten sind bevorzugte Komponenten der Mischung der organische funktionale Materialien (FM1, FM2), die nach dem erfindungsgemäßen Verfahren hergestellt wird.

Außer diesen Schichten kann eine organische Elektrolumineszenzvorrichtung noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten (Charge-Generation Layers, IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer*)* und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayer eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss. Diese Schichten können ebenfalls unter Verwendung der erfindungsgemäß hergestellten Mischungen und/oder Granulate, wie oben definiert, enthalten werden.

Bevorzugt kann vorgesehen sind, dass eine oder mehrere Schichten einer erfindungsgemäßen elektronischen Vorrichtung aus einer Gasphase, vorzugsweise durch Sublimation hergestellt werden. Demgemäß kann das vorliegende Granulat vorzugsweise so ausgestaltet werden, dass die entsprechende Beschichtungsvorrichtung mit dem Granulat beschickt werden kann.

Insbesondere kann vorgesehen sein, dass das Granulat in eine Sublimationsvorrichtung überführt wird.

Ferner kann vorgesehen sind, dass eine oder mehrere Schichten einer erfindungsgemäßen elektronischen Vorrichtung aus Lösung, wie z.B. durch Spincoating, oder mit einem beliebigen Druckverfahren, wie z.B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden.

Die Vorrichtung wird in an sich bekannter Weise je nach Anwendung entsprechend strukturiert, kontaktiert und schließlich hermetisch versiegelt, da sich die Lebensdauer derartiger Vorrichtungen bei Anwesenheit von Wasser und/oder Luft drastisch verkürzt.

Die erfindungsgemäß hergestellten Granulaten, die hieraus erhältlichen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1. Die erfindungsgemäßen oder erfindungsgemäß hergestellten Granulate zeichnen sich durch eine hohe Umweltfreundlichkeit aus, wobei insbesondere die Arbeitsplatzsicherheit hoch ist.
2. Die Granulate können kostengünstig hergestellt werden.
3. Die erfindungsgemäß hergestellten Granulate ermöglichen einen sicheren und zuverlässigen Transport von Zusammensetzungen, die auch zur Herstellung von sehr feinstrukturierten elektronischen Vorrichtungen verwendet werden können.
4. Die erfindungsgemäß hergestellten Granulate können mit konventionellen Apparaten verarbeitet werden, so dass auch hierdurch Kostenvorteile erzielt werden können.
5. Die mit den erfindungsgemäß hergestellten Granulaten erhältlichen elektronischen Vorrichtungen zeigen eine sehr hohe Stabilität und eine sehr hohe Lebensdauer und eine ausgezeichnete Qualität im Vergleich zu elektronischen Vorrichtungen, die mit konventionellen Feststoffen erhalten werden, wobei die Eigenschaften auch nach einer längeren Lagerungs- oder Transportzeit der Materialien erzielt werden können.
6. Überraschend führen die erfindungsgemäß hergestellten Mischungen, vorzugsweise die erfindungsgemäß hergestellten Granulate zu einer geringeren Ausschussrate von den erhaltenen elektronischen Vorrichtungen, beispielsweise Displays. Durch die Verbesserung der Ausbeute an funktionsfähigen oder den Anforderungen und Qualitätsrichtlinien entsprechenden Produkten gelingt es die Produktionskosten der erhaltenen elektronischen Vorrichtungen, beispielsweise Displays zu steigern.
7. Überraschend führen die erfindungsgemäß hergestellten Mischungen, vorzugsweise die erfindungsgemäß hergestellten Granulate zu einer konstanteren und besser vorhersehbaren Qualität der erhaltenen elektronischen Vorrichtungen, beispielsweise Displays. Diese unerwartbare Verbesserung führt insbesondere zu höherwertigen elektronischen Vorrichtungen.

Diese oben genannten Vorteile gehen nicht mit einer Verschlechterung der weiteren elektronischen Eigenschaften einher.

Nachfolgend wird anhand einer schematischen Zeichnung die Durchführung eines erfindungsgemäßen Verfahrens mit einer Anlage veranschaulicht.

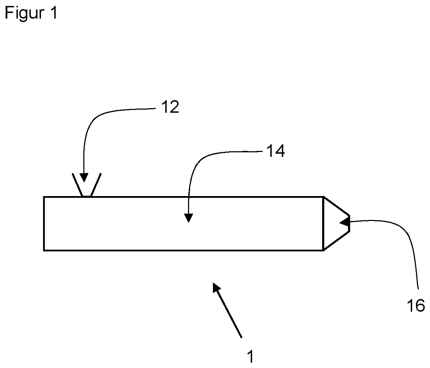

So zeigt Figur 1 in schematischer Darstellung einen Extruder zur Durchführung (1) eines erfindungsgemäßen Verfahrens. In den Extruder (1) wird als Mischung zwei oder mehr Pulver mindestens zweier funktionaler Materialien (FM1, FM2) durch einen Einzug oder eine Zuführung (12) in einen Extruder (1) eingeleitet. Der Extruder (1) weist einen Förderbereich (14) auf, der vorzugsweise ein oder zwei Schnecken umfasst, in welchem die Pulvermischung zu einer hochviskosen Masse erweicht wird. Die hochviskose, in eine relativ homogene Mischung überführte Masse wird über eine Düse (16) aus dem Extruder (1) ausgeleitet und zu einem Granulat abgekühlt.

Detailliertere Beschreibungen von bevorzugten Extrudern finden sich im Stand der Technik, so unter anderem in Dokument EP 2 381 503 B1.

Nachfolgend wird die Bestimmung der Glasübergangstemperatur anhand einer Verbindung, deren Übergangstemperatur schwer zu bestimmen ist, näher erläutert.

### Bestimmung der Glasübergangstemperatur (Tq) von Bis-4,4'-(N,N'-carbazolyl)-biphenyl (CBP; CAS-No. 58328-31-7):

CBP wird seit längerem als Hostmaterial in phosphoreszierenden OLEDs eingesetzt (s. z. B. M. A. Baldo et al., Applied Physics Letters 1999, 75(1), 4-6).

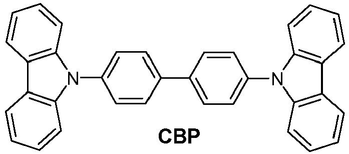

Die Glasübergangstemperatur des Materials ist schwer zu bestimmen, so dass dieses Beispiel insbesondere dazu dient, den Nachweis über die Bestimmbarkeit der Glasübergangstemperatur zu erbringen. Durch die besonders bevorzugte Ausgestaltung der Messung wird gezeigt, dass CBP eine Glasübergangstemperatur von etwa 115 °C aufweist.

Die genaue Durchführung dieser Messung ist im Folgenden beschrieben:
1. Das o. g. Material wird mehrfach hergestellt und gereinigt; die Herstellung erfolgt gemäß einer abgewandelten Vorschrift nach BUCHWALD (vgl. z. B. Buchwald et al., J. Am. Chem. Soc. 1998, 120(37), 9722-9723). Die abgewandelte Vorschrift lehnt sich an die Patentanmeldung WO 03/037844 an.
2. Das Material wird durch mehrfache Umkristallisation aus Dioxan gereinigt und schließlich durch zweifache "Sublimation" (325 °C; 10-4 mbar; Verdampfung aus flüssiger Phase; Kondensation als Feststoff) endgereinigt.
3. Die Materialien werden jeweils via HPLC (Gerät: Fa. Agilent 1100; Säule: Fa. Agilent, Sorbax SB-C18, 75 x 4.6 mm, 3.5 µm Korngröße; Laufmittelgemisch: 90 % MeOH : THF (90:10, vv) + 10 % Wasser, Retentionszeit: 6.95 min.) auf Reinheit untersucht; diese war jeweils im Bereich von 99.9 %, wenn man alle bei der Reaktion anfallenden Regioisomere mit einbezieht.
4. Die Materialien werden durch 1H- und 13C-NMR-Spektroskopie auf Identität und Lösemittelfreiheit geprüft.
5. Für die Bestimmung der Glasübergangstemperatur Tg werden zwei Batches verwendet: Batch A und Batch B. Die Bestimmung der Glasübergangs-temperatur Tg erfolgte mit einem DSC-Gerät der Fa. Netsch, DSC 204/1/G Phönix. Es wurden dabei jeweils Proben in der Größe von 10-15 mg vermessen.

Zur Bestimmung der Glasübergangstemperatur Tg wird wie in Tabelle 3 beschrieben vorgegangen (Batch A). Zur Bestätigung wird dann mit dem zweiten Batch (Batch B) noch eine Referenzmessung durchgeführt.

**Tabelle 3: Bestimmung des Tg von CBP**

| No. | Batch | 1. Heizen | 1. Kühlen | 2. Heizen | 2. Kühlen | 3. Heizen |
|---|---|---|---|---|---|---|
| 1 | A | 0-350°C / 20 K/min | 350-0°C / 20 K/min | 0-350°C / 20 K/min | n. a. | n. a. |
| 2 | A | 0-350°C / 20 K/min | **Probe in flüssigen N₂** | 0-350°C / **3 K/min** | 350-0°C / 20 K/min | 0-350°C / 20 K/min |
| 3 | A | 0-350°C / 20 K/min | **Probe in flüssigen N₂** | 0-350°C / **20 K/min** | 350-0°C / 20 K/min | 0-350°C / 20 K/min |
| 4 | A | 0-350°C / 20 K/min | **Probe in flüssigen N₂** | 0-350°C / **20 K/min** | 350-0°C / 100 K/min | 0-350°C / 20 K/min |
| 5 | A | 0-350°C / 20 K/min | **Probe in flüssigen N₂** | 0-350°C / **35 K/min** | 350-0°C / 20 K/min | 0-350°C / 20 K/min |
| 6 | A | 0-350°C / 20 K/min | **Probe in flüssigen N₂** | 0-350°C / **50 K/min** | 350-0°C / 20 K/min | 0-350°C / 20 K/min |
| 7 | A | 0-350°C / 20 K/min | **Probe in flüssigen N₂** | 0-350°C / **50 K/min** | 350-0°C / 20 K/min | 0-350°C / 20 K/min |
| 8 | B | 0-350°C / 20 K/min | **Probe in flüssigen N₂** | 0-350°C / **50 K/min** | 350-0°C / 20 K/min | 0-350°C / 20 K/min |

**Tabelle 3: Bestimmung des Tg von CBP (Fortsetzung)**

| No. | Batch | Tₘ [°C] | T_{g} [°C] | T_{Rekrist.} [°C] |
|---|---|---|---|---|
| 1 | A | 282 (1. Heizen) | n. a. | ~195 (1. Kühlen) |
| 2 | A | 282 (2. Heizen) | n. a. | ~110 (2. Heizen) |
| 3 | A | 285 (2. Heizen) | n. a. | 120-150 (2. Heizen) |
| 4 | A | 284 (2. Heizen) | n. a. | 120-150 (2.+3. Heizen) |
| 5 | A | 287 (2. Heizen) | **112 (2. Heizen)** | ~150 (2. Heizen) |
| | | | | ~190 (2. Abkühlen) |
| 6 | A | 288 (2. Heizen) | **116 (2. Heizen)** | -160 (2. Heizen) |
| | | | | ~195 (2. Abkühlen) |
| 7 | A | 288 (2. Heizen) | **115 (2. Heizen)** | ~162 (2. Heizen) |
| | | | | ~195 (2. Abkühlen) |
| 8 | B | 288 (2. Heizen) | **114 (2. Heizen)** | ~164 (2. Heizen) |
| | | | | ~195 (2. Abkühlen) |

Die in Tabelle 3 dargelegten Daten zeigen, dass auch bei Verbindungen, deren Glasübergangstemperatur schwer zu bestimmen ist, diese zuverlässig erhalten werden kann. Vorzugsweise kann daher ein Quenchen nach dem ersten Aufheizen erfolgen, um eine eindeutige Glasübergangstemperatur zu erhalten. Weiterhin kann unter anderem eine Rekristallisation Schwierigkeiten bereiten, die im Temperaturbereich zwischen Glasübergangstemperatur und Schmelztemperatur auftreten kann. Diese kann zuverlässig durch ein Quenchen und ein schnelles zweites Aufheizen so abgemildert werden, dass eine Glasübergangstemperatur eindeutig und zuverlässig bestimmbar ist.

Beispiele:

**Tabelle 4: Verwendete funktionale Materialien FM**

| | |
|---|---|
| 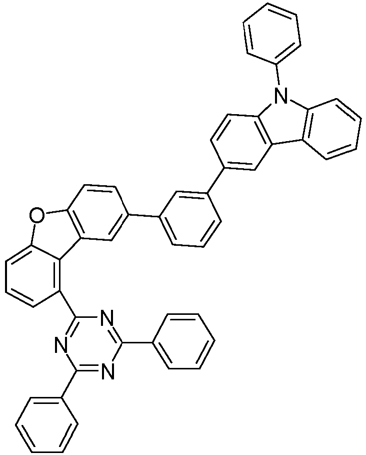 | 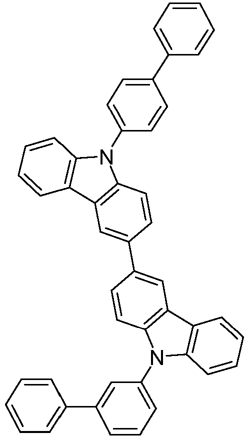 |
| FM1-1 | FM2-1 |
| Tg: 127°C | Tg: 122°C |
| Tm: nicht beobachtet | Tm: nicht beobachtet |
| Tsub.: 340°C | Tsub.: 340°C |
| Tzers.: > 360°C | Tzers.: > 360°C |
| 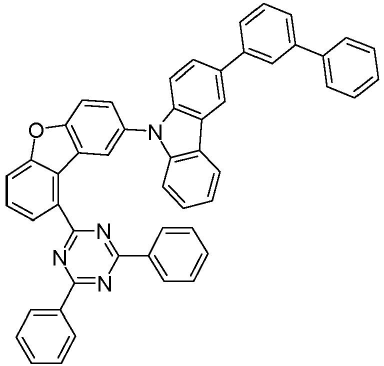 | 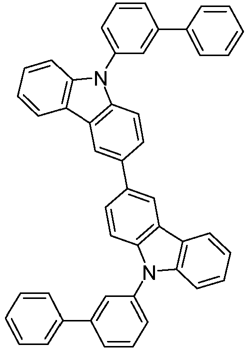 |
| FM3-1 | FM4-1 |
| Tg: 119°C | Tg:111°C |
| Tm: 239°C | Tm: 217°C |
| Tsub.: 340°C | Tsub.: 320°C |
| Tzers.: > 360°C | Tzers.: > 360°C |

Messbedingungen:
Tg: Glasübergangspunkt aus DSC, 1tes Aufheizen, Heizrate 20 K/min, Kühlrate 20 K/min., Messbereich 0-350°C. Tm: Schmelzpunkt aus DSC, Bedingungen siehe Beschreibung für Tg.
Tsubl.: die Sublimationstemperatur ergibt sich aus der Vakuum-TGA Messung, wie zuvor beschrieben.
Tzers.: Zersetzungstemperatur, aus thermischen Auslagerungstest unter Hochvakuum in einer abgeschmolzenen Duranglas-Ampulle unter Lichtsauschluss bei der angegebenen Temperatur für 100 h

Herstellung der Mischungen:

### A: Herstellung von Pulvermischungen gemäß Stand der Technik

Pulver-Mischung1 = PM1:
Je 500 g der Materialien FM1-1 und FM2-1 (jeweils als pulverförmiges Sublimat, mittlere Korngröße ∼ 100 µm, Reinheit nach HPLC > 99.9 %) werden mit einem Standard Laborpulvermischer (z.B. Mini Pulvermischer der Fa. Biomation Wissenschaftliche Geräte GmbH, 40 U/min., 30 min.) gemischt.

Pulver-Mischung2 = PM2:
600 g des Funktionsmaterials FM3-1 und 400 g des Funktionsmaterials FM4-1 (jeweils als pulverförmiges Sublimat, mittlere Korngröße ∼ 100 µm, Reinheit nach HPLC > 99.9 %) werden mit einem Standard Laborpulvermischer (z.B. Mini Pulvermischer der Fa. Biomation Wissenschaftliche Geräte GmbH, 40 Umdrehungen/min., 30 min.) gemischt.

### B: Herstellung erfindungsgemäßer Mischungen

Die in Punkt A beschriebenen Pulver-Mischungen PM1 bzw. PM2 werden in einem Doppelschnecken-Extruder Pharma 11 (Fa. Thermo Fischer Scientific Inc., max. Zonentemperatur 150° - 175 °C, 200 - 350 U/min.) unter Inertgas (Stickstoff) extrudiert und anschließend granuliert (Mittlere Granulatgröße ca. 3 mm).

Es werden so erhalten aus:
PM1 die Extruder-Mischung 1 = EM1: 960 g
PM2 die Extruder-Mischung 2 = EM2: 965 g

### Charakterisierung der Mischungen:

Aus jeder der Pulver- bzw. Extruder-Mischungen, wie zuvor unter A. und B. beschrieben, werden 10 Proben der Masse 10 mg entnommen. Mittels kalibrierter HPLC (high-performance liquid chromatography) wird das relative Masseverhältnis bestimmt.

Die Standardabweichung (STD) wird wie folgt ermittelt: $σ = \sqrt{\frac{{\left({x}_{1}-m\right)}^{2} + {\left({x}_{2}-m\right)}^{2} + ⋯ + {\left({x}_{n}-m\right)}^{2}}{n - 1}} ;$ mit: $m = \frac{{x}_{1} + {x}_{2} + ⋯ + {x}_{n}}{n} , Massenmittel$
x: Masse Datenwert
n: Anzahl der Proben

Tabelle 5 fasst die Ergebnisse für PM1 und EM1 zusammen:

**Tabelle 5: Analysedaten der Mischungen PM1 und EM1**

| Mischung PM1 | | | Mischung EM1 | | |
|---|---|---|---|---|---|
| Proben-Nr. | Masseverhältnisse nach HPLC | | Proben-Nr. | Masseverhältnisse nach HPLC | |
| | FM1-1 | FM2-1 | | FM1-1 | FM2-1 |
| 1 | 52.3 | 47.7 | 1 | 50.0 | 50.0 |
| 2 | 52.0 | 48.0 | 2 | 49.8 | 50.2 |
| 3 | 48.2 | 51.8 | 3 | 50.2 | 49.8 |
| 4 | 51.0 | 49.0 | 4 | 50.0 | 50.0 |
| 5 | 47.5 | 52.5 | 5 | 50.2 | 49.8 |
| 6 | 52.7 | 47.3 | 6 | 50.0 | 50.0 |
| 7 | 47.1 | 52.9 | 7 | 49.9 | 50.1 |
| 8 | 50.4 | 49.6 | 8 | 50.1 | 49.9 |
| 9 | 48.1 | 51.9 | 9 | 50.0 | 50.0 |
| 10 | 52.7 | 47.3 | 10 | 50.0 | 50.0 |
| STD | 2.26 | | STD | 0.12 | |

Mischung EM1 ist, gemäß der geringeren SDT, deutlich homogener als Mischung PM1. Durch das homogene Mischen, verglasen und granulieren wird eine Entmischung der Funktionsmaterialien FM1-1 und FM2-1 dauerhaft unterbunden.

Tabelle 6 fasst die Ergebnisse für PM2 und EM2 zusammen:

**Tabelle 6: Analysedaten der Mischungen PM2 und EM2**

| Mischung PM2 | | | | Mischung EM2 | | |
|---|---|---|---|---|---|---|
| Proben-Nr. | Masseverhältnisse nach HPLC | | | Proben-Nr. | Masseverhältnisse nach HPLC | |
| | FM3-1 | | FM4-1 | | FM3-1 | FM4-1 |
| 1 | 63.0 | | 37.0 | 1 | 60.1 | 39.9 |
| 2 | 58.2 | | 41.8 | 2 | 59.9 | 40.1 |
| 3 | 59.3 | | 40.7 | 3 | 59.8 | 40.2 |
| 4 | 58.4 | | 41.6 | 4 | 60.2 | 39.8 |
| 5 | 62.1 | | 37.9 | 5 | 60.0 | 40.0 |
| 6 | 60.5 | | 39.5 | 6 | 60.0 | 40.0 |
| 7 | 61.6 | | 38.4 | 7 | 60.2 | 39.8 |
| 8 | 58.7 | | 41.3 | 8 | 60.1 | 39.9 |
| 9 | 60.9 | | 39.1 | 9 | 59.9 | 40.1 |
| 10 | 58.6 | | 41.4 | 10 | 59.8 | 40.2 |
| STD | 1.73 | | | STD | 0.15 | |

Mischung EM2 ist, gemäß der geringeren SDT, deutlich homogener als Mischung PM2. Durch das homogene Mischen, Verglasen und Granulieren wird eine Entmischung der Funktionsmaterialien FM3-1 und FM4-1 dauerhaft unterbunden.

### Verwendung der erfindungsgemäßen Mischung EM in OLED-Bauteilen

Die erfindungsgemäßen Mischung EM1 und EM2 - und zum Vergleich die Pulvermischungen PM1 und PM2 - werden als Mixed-Host-Materialien in der Emissionsschicht von phosphoreszenten OLED-Bauteilen verbaut, die ansonsten einen identischen Aufbau besitzen.

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird. Die Verwendeten Materialien sind in Tabelle 8 aufgeführt.

### Die OLEDs haben folgenden Schichtaufbau:

### Substrat

Lochinjektionsschicht 1 (HIL1) aus HTM1 dotiert mit 5 % NDP-9 (kommerziell erhältlich von der Fa. Novaled), 20 nm
Lochtransportschicht 1 (HTL1) aus HTM1, 40 nm
Lochtransportschicht 2 (HTL2), HTM2 20 nm
Emissionsschicht (EML), Mixed-Host (s. Tabelle 4), dotiert mit 15 % Dotand D
Elektronentransportschicht (ETL2), aus ETL1, 5 nm
Elektronentransportschicht (ETL1), aus ETL1(50%):ETL2(50%), 30 nm
Elektroneninjektionsschicht (EIL) aus ETM2, 1 nm
Kathode aus Aluminium, 100 nm

**Tabelle 7: Ergebnisse Phosphoreszenz-OLED-Bauteile**

| **Bsp.** | **EML Mixed-Host** | **EQE (%) 1000 cd/m²** | **Spannung (V) 1000 cd/m²** | **LD90 10000 cd/m²** |
|---|---|---|---|---|
| Vgl. D1 | PM1 | 100 % | 100 % | 100 % |
| D2 | EM1 | 104 % | 98 % | 105 % |
| Vgl. D3 | PM2 | 100 % | 100 % | 100 % |
| D4 | EM2 | 102 % | 99 % | 103 % |

Die OLED-Bauteile D2 bzw. D4, enthaltend die erfindungsgemäßen Mischung EM1 und EM2, weisen gegenüber den Vergleichen D1 bzw. D3, enthaltend die Mischungen PM1 bzw. PM2, sowohl eine verbesserte Effizienz, also auch eine geringere Betriebsspannung sowie eine verbesserte Lebensdauer auf.

**Tabelle 8: Strukturformeln der verwendeten Materialien**

| | |
|---|---|
| 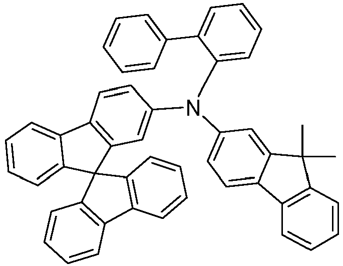 HTM1 [136463-07-5] | 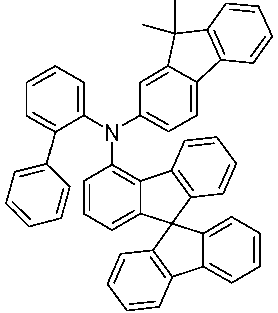 HTM2 [1450933-44-4] |
| 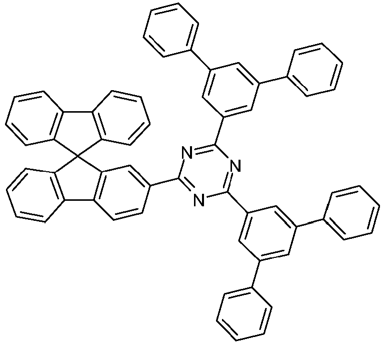 ETM1 [1233200-52-6] | 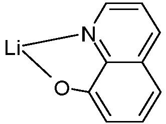 ETM2 [25387-93-3] |
| 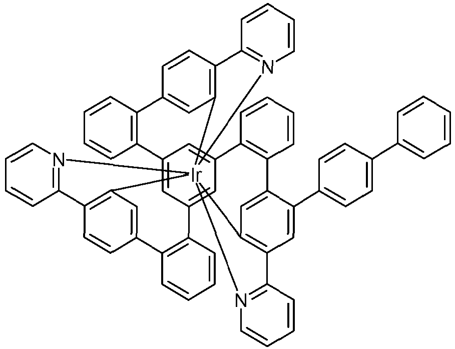 D [2245866-06-0] | |

## Patentansprüche

1. Verfahren zur Herstellung einer Mischung aus verschiedenen Matrixmaterialien, enthaltend mindestens ein elektronenleitendes Matrixmaterial und mindestens ein lochleitendes Matrixmaterial als funktionale Materialien (FM1, FM2), welche zur Herstellung von Funktionsschichten elektronischer Vorrichtungen einsetzbar sind und welche ein Molekulargewicht von ≤ 2000 g/mol haben, umfassend die Schritte:
A) Bereitstellung von mindestens zwei funktionalen Materialien, welche zur Herstellung von Funktionsschichten elektronischer Vorrichtungen einsetzbar sind;
B) Überführen der unter A) bereitgestellten Materialien in einen Schneckenextruder, der mindestens eine Homogenisierungszone umfasst;
C) Extrudieren der in Schritt B) überführten Materialien unter Erhalt einer Mischung und nach Schritt C);
D) Verfestigen der gemäß Schritt C) erhaltenen Mischung,
wobei
die in Schritt A) bereitgestellten und in Schritt B) überführten Materialien sublimierbar sind und
die in Schritt C) durchgeführte Extrusion unterhalb der Schmelztemperatur und/oder der Sublimationstemperatur und unterhalb der Zersetzungstemperatur der in Schritt B) überführten Materialien und oberhalb der niedrigsten Glasübergangstemperatur durchgeführt wird, die die in Schritt A) bereitgestellten und in Schritt B) überführten Materialien oder die Mischung der in Schritt A) bereitgestellten und in Schritt B) überführten Materialien aufweisen, wobei die in Schritt D) erhaltene, verfestigte Mischung ein Granulat darstellt oder in ein Granulat überführt wird.

2. Verfahren nach Anspruch 1, **dadurch gekennzeichnet, dass** mindestens eines der funktionalen Materialien (FM1, FM2), welche zur Herstellung von Funktionsschichten elektronischer Vorrichtungen einsetzbar sind, zersetzungsfrei oberhalb einer Temperatur von 50°C schmelzbar sind.

3. Verfahren nach Anspruch 1, **dadurch gekennzeichnet, dass** mindestens eines der funktionalen Materialien (FM1, FM2), welche zur Herstellung von Funktionsschichten elektronischer Vorrichtungen einsetzbar sind, zersetzungsfrei oberhalb einer Temperatur von 100°C schmelzbar sind.

4. Verfahren nach einem der vorhergehenden Ansprüche, **dadurch gekennzeichnet, dass** ein Einschnecken- oder Doppelschneckenextruder eingesetzt wird.

5. Verfahren nach einem der vorhergehenden Ansprüche, **dadurch gekennzeichnet, dass** die in Schritt D) erhaltene Mischung im Wesentlichen aus den funktionalen Materialien, welche zur Herstellung von Funktionsschichten elektronischer Vorrichtungen einsetzbar sind, besteht.

6. Verfahren nach einem der vorhergehenden Ansprüche, **dadurch gekennzeichnet, dass** die in Schritt D) erhaltene Mischung mindestens 90 Gew.-%, vorzugsweise mindestens 95 Gew.-% und speziell bevorzugt mindestens 99 Gew.-% an funktionalen Materialien, welche zur Herstellung von Funktionsschichten elektronischer Vorrichtungen einsetzbar sind, aufweist.

7. Verfahren nach einem der vorhergehenden Ansprüche, **dadurch gekennzeichnet, dass** das Extrudieren gemäß Schritt C) mindestens 5°C, vorzugsweise mindestens 10°C oberhalb der Glasübergangstemperatur des funktionalen Materials mit der geringsten Glasübergangstemperatur durchgeführt wird.

8. Verfahren nach einem der vorhergehenden Ansprüche, **dadurch gekennzeichnet, dass** das Extrudieren gemäß Schritt C) mit einer Mischung durchgeführt wird, die eine Viskosität im Bereich von 1 bis 50000[mPa s], vorzugsweise 10 bis 10000 [mPa s] und besonders bevorzugt 20 bis 1000 [mPa s] aufweist, gemessen nach mittels Platte-Platte unter Rotation bei einer Schergeschwindigkeit von 100 1/s und einer Temperatur im Bereich von 150° bis 450°C.

9. Verfahren nach einem der vorhergehenden Ansprüche, **dadurch gekennzeichnet, dass** mindestens eines der funktionalen Materialien (FM1, FM2), welches zur Herstellung von Funktionsschichten elektronischer Vorrichtungen einsetzbar ist, ausgewählt ist aus der Gruppe bestehend aus der Gruppe der Benzene, Fluorene, Indenofluorene, Spirobifluorene, Carbazole, Indenocarbazole, Indolocarbazole, Spirocarbazole, Pyrimidine, Triazine, Chinazoline, Chinoxaline, Pyridine, Chinoline, iso-Chinoline, Lactame, Triarylamine, Dibenzofurane, Dibenzothiophene,, Imidazole, Benzimidazole, Benzoxazole, Benzthiazole, 5-Aryl-phenanthridin-6-one, 9,10-Dihydrophenanthrene, Fluoranthene, Naphthaline, Phenanthrene, Anthracene, Benzanthracene, Fluoradene, Pyrene, Perylene, Chrysene, Borazine, Boroxine, Borole, Borazole, Azaborole, Ketone, Phosphinoxide, Arylsilane, Siloxane, Biphenyle, Triphenyle, Terphenyle, Triphenylene, Arylgermane, Arylbismutodide, Metallkomplexe, Chelatkomplexe, Übergangsmetallkomplexe, Metallcluster und deren Kombinationen.

10. Verfahren nach Anspruch 1, **dadurch gekennzeichnet, dass** das erhaltene Granulat einen Durchmesser im Bereich von 0,1 mm bis 10 cm, vorzugsweise 1 mm bis 8 cm und besonders bevorzugt 1 cm bis 5 cm aufweist, gemessen mit optischen Methoden als numerischer Mittelwert.

## Claims

1. Process for the preparation of a mixture of various matrix materials, comprising at least one electron-conducting matrix material and at least one hole-conducting matrix material as functional materials (FM1, FM2) which can be employed for the production of functional layers of electronic devices and which have a molecular weight of ≤ 2000 g/mol, comprising the steps:
A) provision of at least two functional materials which can be employed for the production of functional layers of electronic devices;
B) transfer of the materials provided under A) into a screw extruder which includes at least one homogenisation zone;
C) extrusion of the material transferred in step B) to give a mixture and, after step C);
D) solidification of the mixture obtained in step C),
where
the materials provided in step A) and transferred in step B) are sublimable and
the extrusion carried out in step C) is carried out below the melting temperature and/or sublimation temperature and below the decomposition temperature of the materials transferred in step B) and above the lowest glass-transition temperature of the materials provided in step A) and transferred in step B) or of the mixture of materials provided in step A) and transferred in step B),
where the solidified mixture obtained in step D) is in the form of granules or is converted into granules.

2. Process according to Claim 1, **characterised in that** at least one of the functional materials (FM1, FM2) which can be employed for the production of functional layers of electronic devices can be melted without decomposition above a temperature of 50°C.

3. Process according to Claim 1, **characterised in that** at least one of the functional materials (FM1, FM2) which can be employed for the production of functional layers of electronic devices can be melted without decomposition above a temperature of 100°C.

4. Process according to one of the preceding claims, **characterised in that** a single-screw or twin-screw extruder is employed.

5. Process according to one of the preceding claims, **characterised in that** the mixture obtained in step D) essentially consists of the functional materials which can be employed for the production of functional layers of electronic devices.

6. Process according to one of the preceding claims, **characterised in that** the mixture obtained in step D) has at least 90% by weight, preferably at least 95% by weight and especially preferably at least 99% by weight of functional materials which can be employed for the production of functional layers of electronic devices.

7. Process according to one of the preceding claims, **characterised in that** the extrusion in step C) is carried out at least 5°C, preferably at least 10°C, above the glass-transition temperature of the functional material having the lowest glass-transition temperature.

8. Process according to one of the preceding claims, **characterised in that** the extrusion in step C) is carried out with a mixture which has a viscosity in the range from 1 to 50000 [mPa s], preferably 10 to 10000 [mPa s] and particularly preferably 20 to 1000 [mPa s], measured by means of plate-plate with rotation at a shear rate of 100 1/s and a temperature in the range from 150° to 450°C.

9. Process according to one of the preceding claims, **characterised in that** at least one of the functional materials (FM1, FM2) which can be employed for the production of functional layers of electronic devices is selected from the group consisting of the group of the benzenes, fluorenes, indenofluorenes, spirobifluorenes, carbazoles, indenocarb-azoles, indolocarbazoles, spirocarbazoles, pyrimidines, triazines, quinazolines, quinoxalines, pyridines, quinolines, isoquinolines, lactams, triarylamines, dibenzofurans, dibenzothiophenes, imidazoles, benzimidazoles, benzoxazoles, benzothiazoles, 5-arylphenanthridin-6-ones, 9,10-dihydrophenanthrenes, fluoranthenes, naphthalenes, phen-anthrenes, anthracenes, benzanthracenes, fluoradenes, pyrenes, perylenes, chrysenes, borazines, boroxines, boroles, borazoles, azaboroles, ketones, phosphine oxides, arylsilanes, siloxanes, biphenyls, triphenyls, terphenyls, triphenylenes, arylgermanes, arylbismuth iodides, metal complexes, chelate complexes, transition-metal complexes, metal clusters and combinations thereof.

10. Process according to Claim 1, **characterised in that** the granules obtained have a diameter in the range from 0.1 mm to 10 cm, preferably 1 mm to 8 cm and particularly preferably 1 cm to 5 cm, measured as the arithmetic mean using optical methods.

## Revendications

1. Procédé de préparation d'un mélange de divers matériaux de matrice, comprenant au moins un matériau de matrice conducteur d'électrons et au moins un matériau de matrice conducteur de trous en tant que matériaux fonctionnels (MF1, MF2) qui peuvent être employés pour la production de couches fonctionnelles de dispositifs électroniques et qui présentent un poids moléculaire ≤ 2000 g/mol, comprenant les étapes :
A) de mise à disposition d'au moins deux matériaux fonctionnels qui peuvent être employés pour la production de couches fonctionnelles de dispositifs électroniques ;
B) de transfert des matériaux mis à disposition à l'étape A) dans une extrudeuse à vis comportant au moins une zone d'homogénéisation ;
C) d'extrusion du matériau transféré à l'étape B) pour obtenir un mélange et, après l'étape C) ;
D) de solidification du mélange obtenu à l'étape C),
dans lequel
les matériaux fournis à l'étape A) et transférés à l'étape B) sont sublimables et
l'extrusion réalisée à l'étape C) est effectuée en dessous de la température de fusion et/ou de la température de sublimation et en dessous de la température de décomposition des matériaux transférés à l'étape B), et au-dessus de la température de transition vitreuse la plus basse des matériaux mis à disposition à l'étape A) et transférés à l'étape B) ou du mélange de matériaux mis à disposition à l'étape A) et transféré à l'étape B),
le mélange solidifié obtenu à l'étape D) se présentant sous forme de granulat ou étant transformé en granulat.

2. Procédé selon la revendication 1, **caractérisé en ce qu'**au moins l'un parmi les matériaux fonctionnels (MF1, MF2) qui peuvent être employés pour la production de couches fonctionnelles de dispositifs électroniques peut être fondu sans décomposition au-dessus d'une température de 50°C.

3. Procédé selon la revendication 1, **caractérisé en ce qu'**au moins l'un parmi les matériaux fonctionnels (MF1, MF2) qui peuvent être employés pour la production de couches fonctionnelles de dispositifs électroniques peut être fondu sans décomposition au-dessus d'une température de 100°C.

4. Procédé selon l'une des revendications précédentes, **caractérisé en ce qu'**une extrudeuse mono-vis ou bi-vis est employée.

5. Procédé selon l'une des revendications précédentes, **caractérisé en ce que** le mélange obtenu à l'étape D) est constitué essentiellement des matériaux fonctionnels qui peuvent être employés pour la production de couches fonctionnelles de dispositifs électroniques.

6. Procédé selon l'une des revendications précédentes, **caractérisé en ce que** le mélange obtenu à l'étape D) contient au moins 90% en poids, préférablement au moins 95% en poids et particulièrement préférablement au moins 99% en poids de matériaux fonctionnels qui peuvent être employés pour la production de couches fonctionnelles de dispositifs électroniques.

7. Procédé selon l'une des revendications précédentes, **caractérisé en ce que** l'extrusion à l'étape C) est réalisée à une température supérieure d'au moins 5°C, préférablement d'au moins 10°C, à la température de transition vitreuse du matériau fonctionnel présentant la température de transition vitreuse la plus basse.

8. Procédé selon l'une des revendications précédentes, **caractérisé en ce que** l'extrusion à l'étape C) est réalisée avec un mélange présentant une viscosité dans la plage allant de 1 à 50 000 [mPa.s], préférablement de 10 à 10 000 [mPa.s] et particulièrement préférablement de 20 à 1000 [mPa.s], mesurée au moyen d'un essai plaque-plaque avec rotation à un taux de cisaillement de 100 1/s et à une température dans la plage allant de 150°C à 450°C.

9. Procédé selon l'une des revendications précédentes, **caractérisé en ce qu'**au moins l'un parmi les matériaux fonctionnels (MF1, MF2) qui peuvent être employés pour la production de couches fonctionnelles de dispositifs électroniques est choisi dans le groupe constitué par les benzènes, les fluorènes, les indénofluorènes, les spirobifluorènes, les carbazoles, les indénocarbazoles, les indolocarbazoles, les spirocarbazoles, les pyrimidines, les triazines, les quinazolines, les quinoxalines, les pyridines, les quinoléines, les isoquinoléines, les lactames, les triarylamines, les dibenzofuranes, les dibenzothiophènes, les imidazoles, les benzimidazoles, les benzoxazoles, les benzothiazoles, les 5-arylphénanthridin-6-ones, les 9,10-dihydrophénanthrènes, les fluoranthènes, les naphtalènes, les phénanthrènes, les anthracènes, les benzanthracènes, les fluoradènes, les pyrènes, les pérylènes, les chrysènes, les borazines, les boroxines, les boroles, les borazoles, les azaboroles, les cétones, les oxydes de phosphine, les arylsilanes, les siloxanes, les biphényles, les triphényles, les terphényles, les triphénylènes, les arylgermanes, les iodures d'arylbismuth, les complexes métalliques, les complexes chélatés, les complexes de métaux de transition, les agrégats métalliques et des combinaisons de ceux-ci.

10. Procédé selon la revendication 1, **caractérisé en ce que** le granulat obtenu présente un diamètre dans la plage allant de 0,1 mm à 10 cm, préférablement de 1 mm à 8 cm et particulièrement préférablement de 1 cm à 5 cm, mesuré en tant que moyenne arithmétique en utilisant des méthodes optiques.
